# EUROPEAN PATENT APPLICATION

(11) **EP 2 161 319 A2**
(43) Date of publication of application: **10.03.2010**
(21) Application number: 09156565.5
(22) Date of filing: 30.03.2009
(51) Int. Cl.: C09K 11/06

(54) **Benzo(c)phenanthrene derivatives and organic electroluminescent device using the same**

(30) Priority: 04.09.2008 KR 20080087050
(71) Applicant: Gracel Display Inc., Seoul 133-833 (KR)
(72) Inventor: Eum, Sung Jin, Seoul (KR); Lee, Hyo Jung, 153-784, Seoul (KR); Cho, Young Jun, 136-060, Seoul (KR); Kwon, Hyuck Joo, 130-100, Seoul (KR); Kim, Bong Ok, 135-090, Seoul (KR); Kim, Sung Min, 157-886, Seoul (KR); Yoon, Seung Soo, 135-884, Seoul (KR)
(74) Representative: Kent, Venetia Katherine

(57) **Abstract**

Provided are novel organic electroluminescent compounds and organic electroluminescent devices and organic solar cells comprising the same. Specifically, the organic electroluminescent compounds according to the invention are **characterized in that** they are represented by Chemical Formula (1): 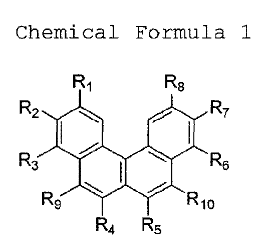 wherein, R₁ through R₁₀ cannot be hydrogen all at the same time.
The organic electroluminescent compounds according to the invention exhibit high luminous efficiency and excellent color purity and life property of material, so that an OLED having very good operation life can be manufactured therefrom.

## Description

### FIELD OF THE INVENTION

The present invention relates to novel organic electroluminescent compounds and organic electroluminescent devices employing the same.

### BACKGROUND OF THE INVENTION

Among display devices, electroluminescence devices (EL devices) are self-luminescent display devices showing the advantage of wide angle of view, excellent contrast and rapid response rate. Eastman Kodak developed in 1987 an organic EL device which employs a low molecular weight aromatic diamine and an aluminum complex as material for forming an EL layer, for the first time [Appl. Phys. Lett. 51, 913, 1987].

An organic EL device is a device wherein, when charge is applied to an organic film formed between an electron injection electrode (cathode) and a hole injection electrode (anode), an electron and a hole form a pair and then become extinct with emitting light. A device can be formed on a transparent flexible substrate such as plastics. The device can be operated at a lower voltage (not more than 10 V) with relatively lower power consumption but excellent color purity, as compared to a plasma display panel or an inorganic EL display.

Since the organic electroluminescent (EL) devices can develop three colors (green, blue and red), they have been focused as full colored display devices for next generation.

The procedure for manufacturing an organic EL device comprises the following steps:
(1) First, anode material is coated on a transparent substrate. As the anode material, ITO (indium tin oxide) is usually employed.
(2) A hole injecting layer (HIL) is coated thereon. As the hole injecting layer, it is common to coat copper phthalocyanine (CuPc) with a thickness of 10 nm to 30 nm.
(3) Then, a hole transport layer (HTL) is introduced. As the hole transport layer, 4,4'-bis[N-(1-naphthyl)-N-phenylamino]biphenyl (NPB) is vapor-deposited with a thickness of about 30 nm to 60 nm.
(4) An organic emitting layer is formed thereon. If required, dopant is added. In case of green electroluminescence, tris(8-hydroxyquinolate)aluminium (Alq₃) is commonly vapor-deposited with a thickness of 30 to 60 nm as the organic emitting layer, and MQD(N-methylquinacridone) is usually employed as dopant.
(5) An electron transport layer (ETL) and an electron injecting layer (EIL) is then sequentially coated thereon, or an electron injecting/transport layer is formed. In case of green electroluminescence, since Alq₃ of (4) has good capability of electron transport, an electron injecting/transport layer may not be necessarily employed.
(6) Then, a cathode is coated, and finally passivation is carried out.

Depending upon how the emitting layer is formed in such a structure, a blue, green or red electroluminescent device can be realized. In the meanwhile, conventional substances used as green electroluminescent compound for realizing a green electroluminescent device had problems of insufficient life and poor luminous efficiency.

The most important factor to determine luminous efficiency, lifetime or the like in an organic EL device is electroluminescent material. Several properties required for such electroluminescent materials include that the material should have high fluorescent quantum yield in solid state and high mobility of electrons and holes, is not easily decomposed during vapor-deposition in vacuo, and forms uniform and stable thin film.

Organic electroluminescent materials can be generally classified into high-molecular materials and low-molecular materials. The low-molecular materials include metal complexes and thoroughly organic electroluminescent materials which do not contain metal, in view of molecular structure. Such electroluminescent materials include chelate complexes such as tris(8-quinolinolato)aluminum complexes, coumarin derivatives, tetraphenylbutadiene derivatives, bis(styrylarylene) derivatives and oxadiazole derivatives. From those materials, it is reported that light emission of visible region from blue to red can be obtained, so that realization of full-colored display devices is anticipated thereby.

### SUMMARY OF THE INVENTION

With intensive efforts to overcome the problems of conventional techniques as described above, the present inventors have invented novel electroluminescent compounds which can realize organic electroluminescent devices having excellent luminous efficiency and noticeably improved life property.

The object of the present invention is to provide organic electroluminescent compounds having the backbone to provide better luminous efficiency and device life with appropriate color coordinate as compared to conventional host or dopant material, while overcoming the problems described above.

Another object of the invention is to provide organic electroluminescent devices having high luminous efficiency and long life, which employs the organic electroluminescent compounds as electroluminescent material.

Still another object of the invention is to provide organic electroluminescent devices which employ the organic electroluminescent compounds in the electroluminescent layer.

Yet still another object of the invention is to provide organic solar cells comprising the organic electroluminescent compounds.

The present invention relates to organic electroluminescent compounds represented by Chemical Formula (1), and organic electroluminescent devices comprising the same. Since the organic electroluminescent compounds according to the invention show high luminous efficiency and excellent color purity and life property of material, OLED's having very good operation life can be manufactured therefrom. 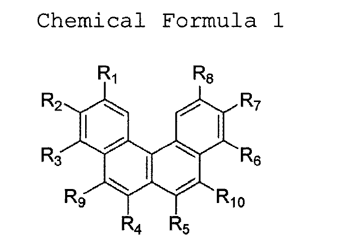 wherein, R₁ through R₁₀ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, NR₁₁R₁₂, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or a substituent selected from the following structures, provided that R₁ through R₁₀ cannot be hydrogen all at the same time:

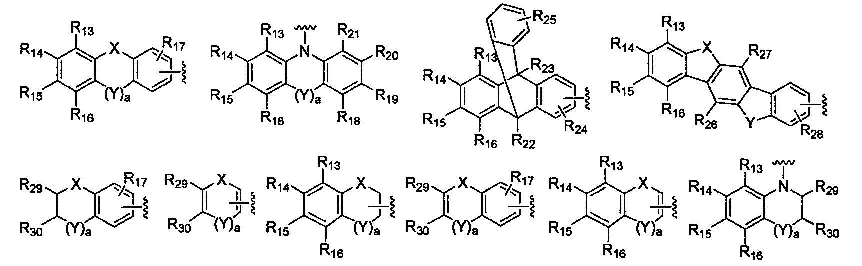

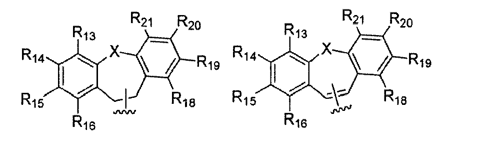

R₁₁ and R₁₂ independently represent hydrogen, deuterium, (C1-C60)alkyl, (C3-C60)cycloalkyl, (C6-C60)aryl or (C3-C60)heteroaryl;

R₁₃ through R₃₀ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₃ through R₂₅ may be linked to an adjacent substituent via (C3-C60)alkylene or (C3-C60)alkenylene with or without a fused ring to form an alicyclic ring, or a monocyclic or polycyclic aromatic ring;

X and Y independently represent a chemical bond, or - C(R₃₁)(R₃₂)-, -N(R₃₃)-, -S-, -O-, -Si(R₃₄)(R₃₅)-, -P(R₃₆)-, - C(=O)-, -B(R₃₇)-, -In(R₃₈)-, -Se-, -Ge(R₃₉)(R₄₀)-, -Sn(R₄₁)(R₄₂)-, -Ga(R₄₃)- or -(R₄₄)C=C(R₄₅)-;

R₃₁ through R₄₅ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₃₁ and R₃₂, R₃₄ and R₃₅, R₃₉ and R₄₀, R₄₁ and R₄₂, or R₄₄ and R₄₅ may be linked via (C3-C60)alkylene or (C3-C60)alkenylene with or without a fused ring to form an alicyclic ring, or a monocyclic or polycyclic aromatic ring;
the alkyl, aryl, heteroaryl, heterocycloalkyl, cycloalkyl, trialkylsilyl, dialkylarylsilyl, triarylsilyl, adamantyl, bicycloalkyl, alkenyl, alkynyl, aralkyl, alkyloxy, alkylthio, aryloxy, arylthio, alkylamino, arylamino, alkoxycarbonyl, alkylcarbonyl or arylcarbonyl of R₁ through R₄₅ may be further substituted by one or more substituent(s) selected from deuterium, halogen, (C1-C60)alkyl with or without halogen substituent(s), (C6-C60)aryl, (C3-C60)heteroaryl with or without (C6-C60)aryl substituent(s), morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; and
a is an integer from 0 to 4.

### BRIEF DESCRIPTION OF THE DRAWINGS

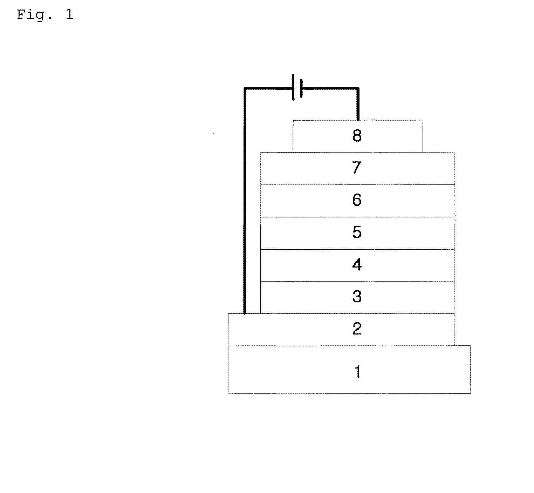

Fig. 1 is a cross-sectional view of an OLED.

### DETAILED DESCRIPTION OF THE INVENTION

Referring now to the Drawings, Fig. 1 illustrates a cross-sectional view of an OLED of the present invention comprising a Glass 1, Transparent electrode 2, Hole injecting layer 3, Hole transport layer 4, Electroluminescent layer 5, Electron transport layer 6, Electron injecting layer 7 and Al cathode 8.

The term "alkyl", "alkoxy" and any other substituents comprising "alkyl" moiety include linear and branched species.

The term "aryl" described herein means an organic radical derived from aromatic hydrocarbon via elimination of one hydrogen atom. Each ring suitably comprises a monocyclic or fused ring system containing from 4 to 7, preferably from 5 to 6 cyclic atoms. Specific examples include phenyl, naphthyl, biphenyl, anthryl, indenyl, fluorenyl, phenanthryl, triphenylenyl, pyrenyl, perylenyl, chrysenyl, naphthacenyl and fluoranthenyl, but they are not restricted thereto.

The term "heteroaryl" described herein means an aryl group containing from 1 to 4 heteroatom(s) selected from N, O, S and Si for the aromatic cyclic backbone atoms, and carbon atom(s) for remaining aromatic cyclic backbone atoms. The heteroaryl may be 5- or 6-membered monocyclic heteroaryl or a polycyclic heteroaryl which is fused with one or more benzene ring(s), and may be partially saturated. The heteroaryl groups include bivalent aryl group of which the heteroatom in the ring is oxidized or quarternized to form an N-oxide or a quaternary salt. Specific examples include monocyclic heteroaryl groups such as furyl, thiophenyl, pyrrolyl, imidazolyl, pyrazolyl, thiazolyl, thiadiazolyl, isothiazolyl, isoxazolyl, oxazolyl, oxadiazolyl, triazinyl, tetrazinyl, triazolyl, tetrazolyl, furazanyl, pyridyl, pyrazinyl, pyrimidinyl, pyridazinyl; polycyclic heteroaryl groups such as benzofuranyl, benzothiophenyl, isobenzofuranyl, benzimidazolyl, benzothiazolyl, benzoisothiazolyl, benzoisoxazolyl, benzoxazolyl, isoindolyl, indolyl, indazolyl, benzothiadiazolyl, quinolyl, isoquinolyl, cinnolinyl, quinazolinyl, quinolizinyl, quinoxalinyl, carbazolyl, phenanthridinyl and benzodioxolyl; and corresponding N-oxides (e.g., pyridyl N-oxides, quinolyl N-oxides) and quaternary salts thereof; but they are not restricted thereto.

The naphthyl mentioned herein may be 1-naphthyl or 2-naphthyl; the anthryl may be 1-anthryl, 2-anthryl or 9-anthryl; and the fluorenyl may be 1-fluorenyl, 2-fluorenyl, 3-fluorenyl, 4-fluorenyl or 9-fluorenyl.

The substituents comprising "(C1-C60)alkyl" moiety described herein may contain 1 to 60 carbon atoms, 1 to 20 carbon atoms, or 1 to 10 carbon atoms. The substituents comprising "(C6-C60)aryl" moiety may contain 6 to 60 carbon atoms, 6 to 20 carbon atoms, or 6 to 12 carbon atoms. The substituents comprising "(C3-C60)heteroaryl" moiety may contain 3 to 60 carbon atoms, 4 to 20 carbon atoms, or 4 to 12 carbon atoms. The substituents comprising "(C3-C60)cycloalkyl" moiety may contain 3 to 60 carbon atoms, 3 to 20 carbon atoms, or 3 to 7 carbon atoms. The substituents comprising "(C2-C60)alkenyl or alkynyl" moiety may contain 2 to 60 carbon atoms, 2 to 20 carbon atoms, or 2 to 10 carbon atoms.

The organic electroluminescent compounds according to the present invention can be represented by Chemical Formula (2): 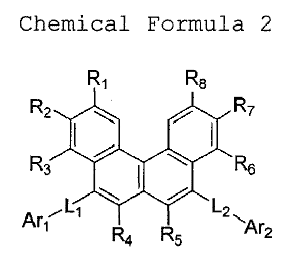 wherein, R₁ through R₈ are defined as in Chemical Formula (1);
L₁ and L₂ independently represent a chemical bond, or (C1-C60)alkylenoxy, (C1-C60)alkylenethio, (C6-C60)arylenoxy, (C6-C60)arylenethio, (C6-C60)arylene or (C3-C60)heteroarylene;

Ar₁ and Ar₂ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, NR₁₁R₁₂, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or a substituent selected from the following structures:

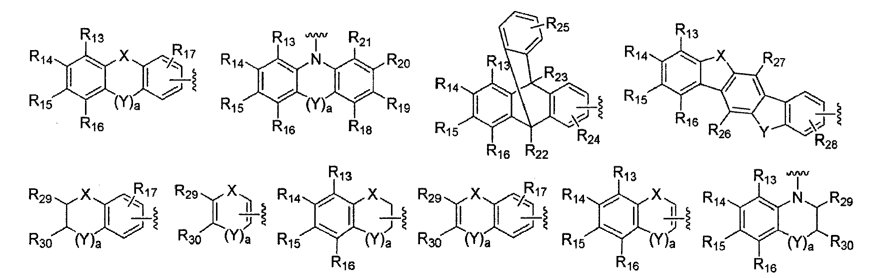

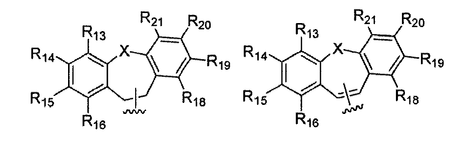

R₁₁ and R₁₂ independently represent hydrogen, deuterium, (C1-C60)alkyl, (C3-C60)cycloalkyl, (C6-C60)aryl or (C3-C60)heteroaryl;
R₁₃ through R₃₀ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₃ through R₂₅ may be linked to an adjacent substituent via (C3-C60)alkylene or (C3-C60)alkenylene with or without a fused ring to form an alicyclic ring, or a monocyclic or polycyclic aromatic ring;
X and Y independently represent a chemical bond, or - C(R₃₁)(R₃₂)-, -N(R₃₃)-, -S-, -O-, -Si(R₃₄)(R₃₅)-, -P(R₃₆)-, - C(=O)-, -B(R₃₇)-, -In(R₃₈)-, -Se-, -Ge(R₃₉)(R₄₀)-, -Sn(R₄₁)(R₄₂)-, -Ga(R₄₃)- or -(R₄₄)C=C(R₄₅)-;
R₃₁ through R₄₅ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₃₁ and R₃₂, R₃₄ and R₃₅, R₃₉ and R₄₀, R₄₁ and R₄₂, or R₄₄ and R₄₅ may be linked via (C3-C60)alkylene or (C3-C60)alkenylene with or without a fused ring to form an alicyclic ring, or a monocyclic or polycyclic aromatic ring;
the arylene or heteroarylene of L₁ and L₂; or the alkyl, aryl, heteroaryl, heterocycloalkyl, cycloalkyl, trialkylsilyl, dialkylarylsilyl, triarylsilyl, adamantyl, bicycloalkyl, alkenyl, alkynyl, aralkyl, alkyloxy, alkylthio, aryloxy, arylthio, alkylamino, arylamino, alkoxycarbonyl, alkylcarbonyl or arylcarbonyl of Ar₁, Ar₂ and R₁₁ through R₄₅ may be further substituted by one or more substituent(s) selected from deuterium, halogen, (C1-C60)alkyl with or without halogen substituent(s), (C6-C60)aryl, (C3-C60)heteroaryl with or without (C6-C60)aryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; and
a is an integer from 0 to 4.

Specifically, Ar₁, Ar₂, and R₁ through R₈ are independently selected from, without restriction, hydrogen, deuterium, fluoro, chloro, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, benzyl, trifluoromethyl, perfluorethyl, trifluoroethyl, perfluoropropyl, perfluorobutyl, methoxy, ethoxy, n-propoxy, i-propoxy, n-butoxy, i-butoxy, t-butoxy, n-pentoxy, i-pentoxy, n-hexyloxy, n-heptoxy, cyclopropyl, cyclobutyl, cyclopentyl, cyclohexyl, cycloheptyl, cyclooctyl, cyclononyl, cyclodecyl, morpholino, thiomorpholino, morpholinyl, thiomorpholinyl, trimethylsilyl, triethylsilyl, tripropylsilyl, tri(t-butyl)silyl, t-butyldimethylsilyl, dimethylphenylsilyl, triphenylsilyl, bicyclo[2.2.1]heptyl, bicyclo[2.2.2]octyl, bicyclo[3.2.1]octyl, bicyclo[5.2.0]nonyl, bicyclo[4.2.2]decyl, bicyclo[2.2.2]octyl, 4-pentylbicyclo[2.2.2]octyl, ethenyl, phenylethenyl, ethynyl, phenylethynyl, cyano, methylthio, phenyloxy, phenylthio, methoxycarbonyl, ethoxycarbonyl, t-butoxycarbonyl, methylcarbonyl, ethylcarbonyl, benzylcarbonyl, phenylcarbonyl, carboxyl, nitro, hydroxyl and the following structures: 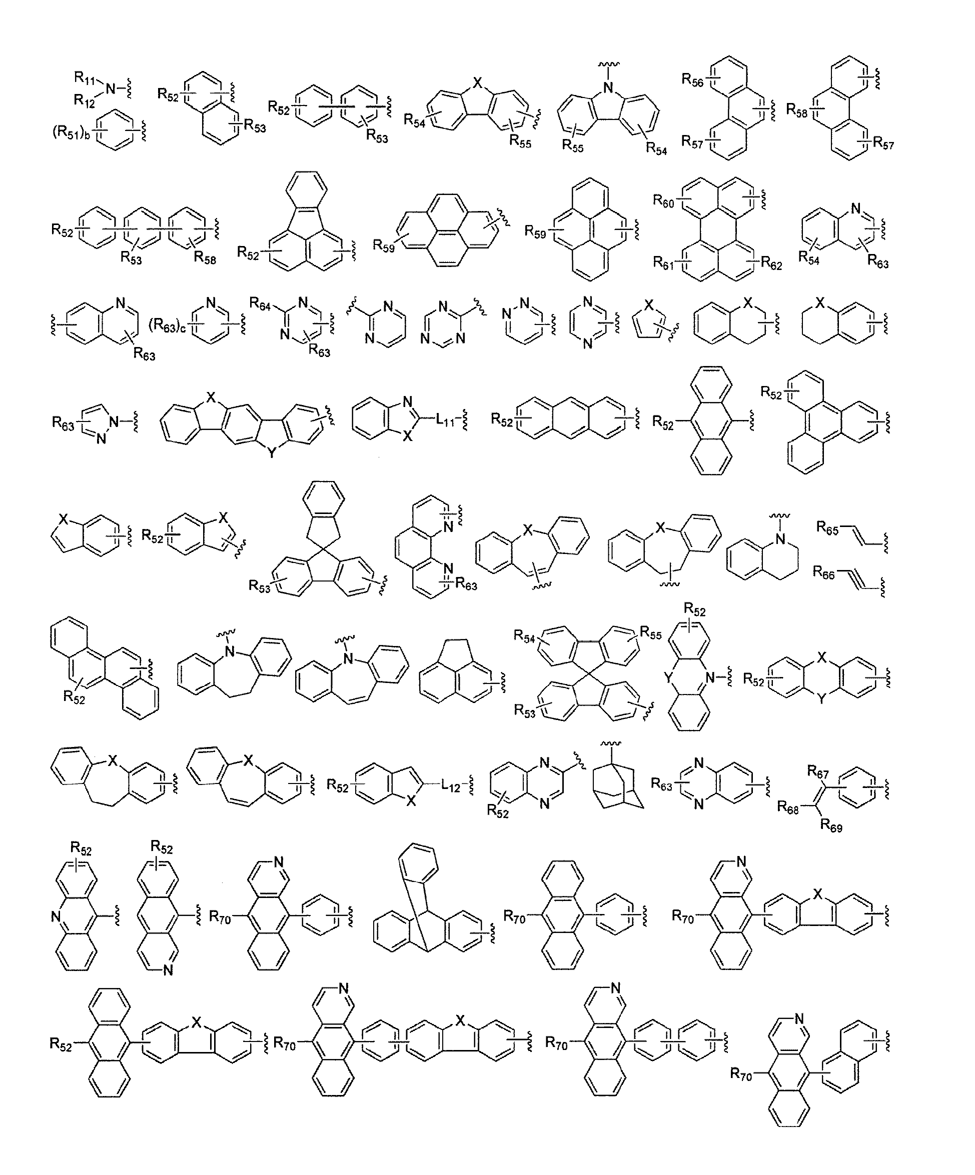 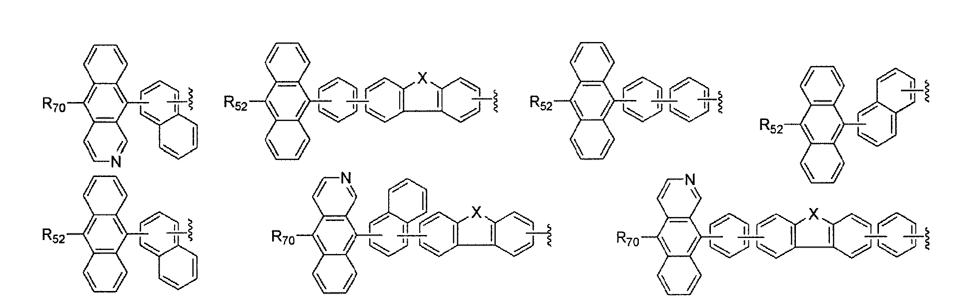 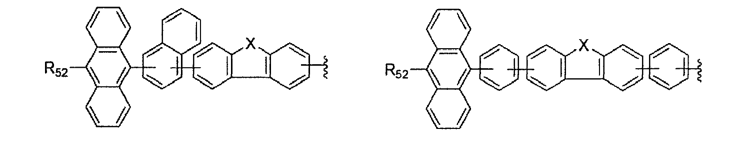 wherein, R₁₁ and R₁₂ independently represent hydrogen, deuterium, (C1-C60)alkyl, (C3-C60)cycloalkyl, (C6-C60)aryl or (C3-C60)heteroaryl;
R₅₁ through R₇₀ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
L₁₁ and L₁₂ independently represent a chemical bond, (C6-C60)arylene or (C3-C60)heteroarylene; the arylene or heteroarylene of L₁₁ and L₁₂ may be further substituted by one or more substituent(s) selected from deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl;
X and Y independently represent -C(R₃₁)(R₃₂)-, -N(R₃₃)-, - S-, -O-, -Si(R₃₄)(R₃₅)-, -P(R₃₆)-, -C(=O)-, -B(R₃₇)-, -In(R₃₈)-, - Se-, -Ge(R₃₉)(R₄₀)-, -Sn(R₄₁)(R₄₂)-, -Ga(R₄₃)- or -(R₄₄)C=C(R₄₅)-;
R₃₁ through R₄₅ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl; or R₃₁ and R₃₂, R₃₄ and R₃₅, R₃₉ and R₄₀, R₄₁ and R₄₂, or R₄₄ and R₄₅ may be linked via (C3-C60)alkylene or (C3-C60)alkenylene with or without a fused ring to form an alicyclic ring, or a monocyclic or polycyclic aromatic ring;
the alkyl, aryl, heteroaryl, heterocycloalkyl, cycloalkyl, trialkylsilyl, dialkylarylsilyl, triarylsilyl, adamantyl, bicycloalkyl, alkenyl, alkynyl, alkylamino, arylamino, alkylthio, alkyloxy, aryloxy or arylthio of R11, R₁₂, R₅₁ through R₇₀, and R₃₁ through R₄₅ may be further substituted by deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl; and
b is an integer from 1 to 5; and
c is an integer from 1 to 4.

More specifically, Ar₁, Ar₂, and R₁ through R₈ are independently selected from the following structures, without restriction:

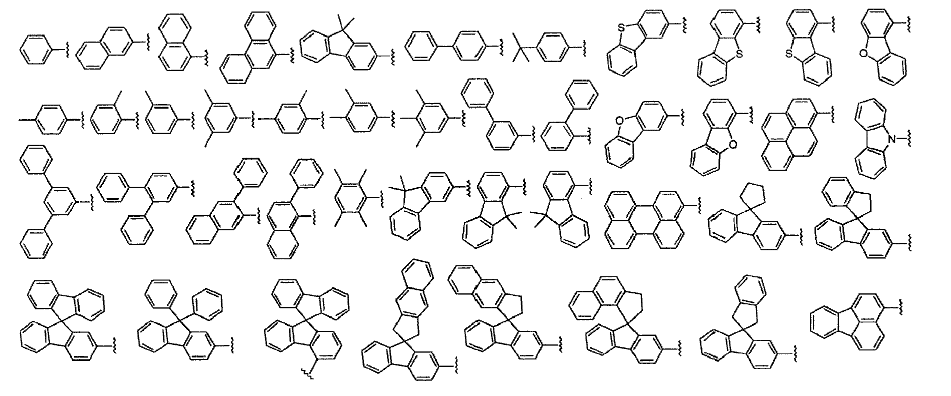

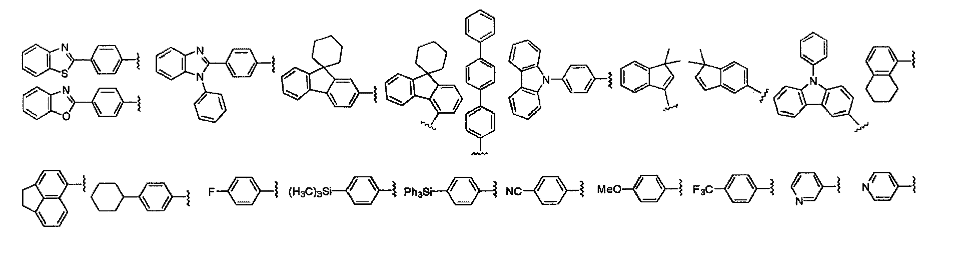

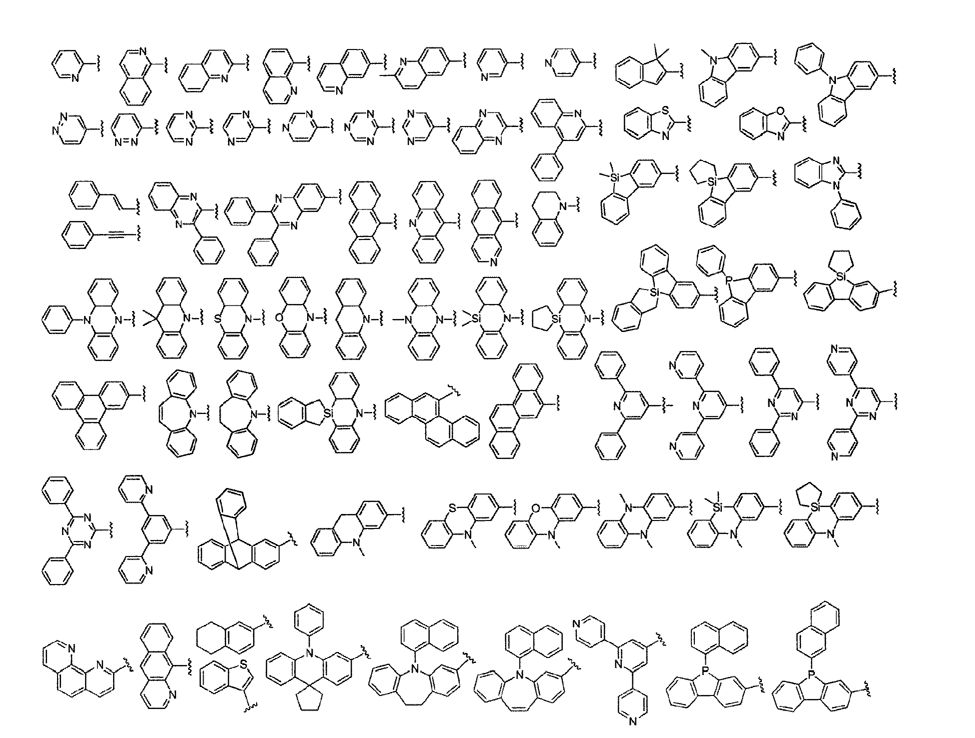

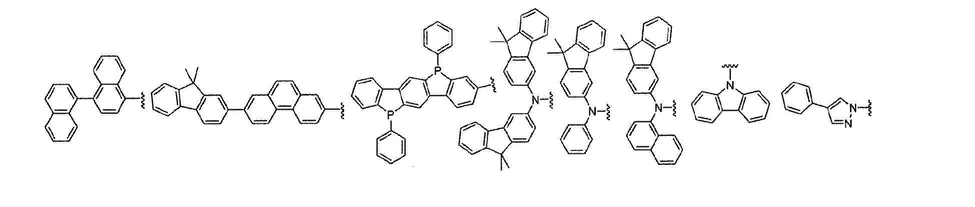

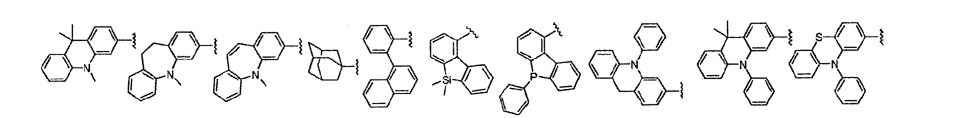

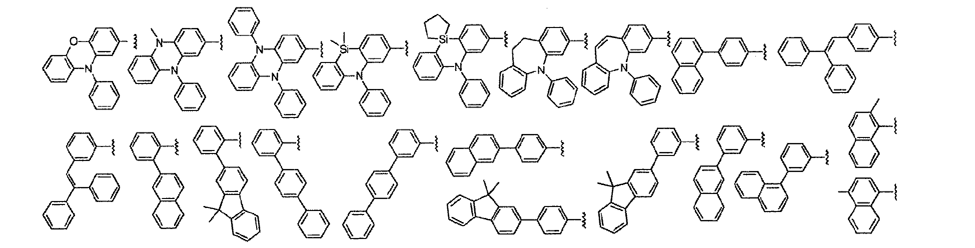

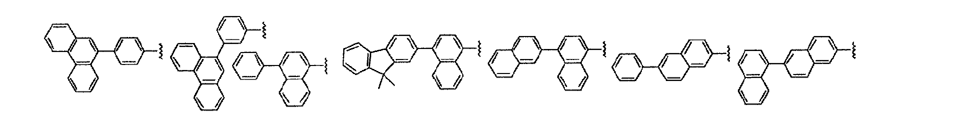

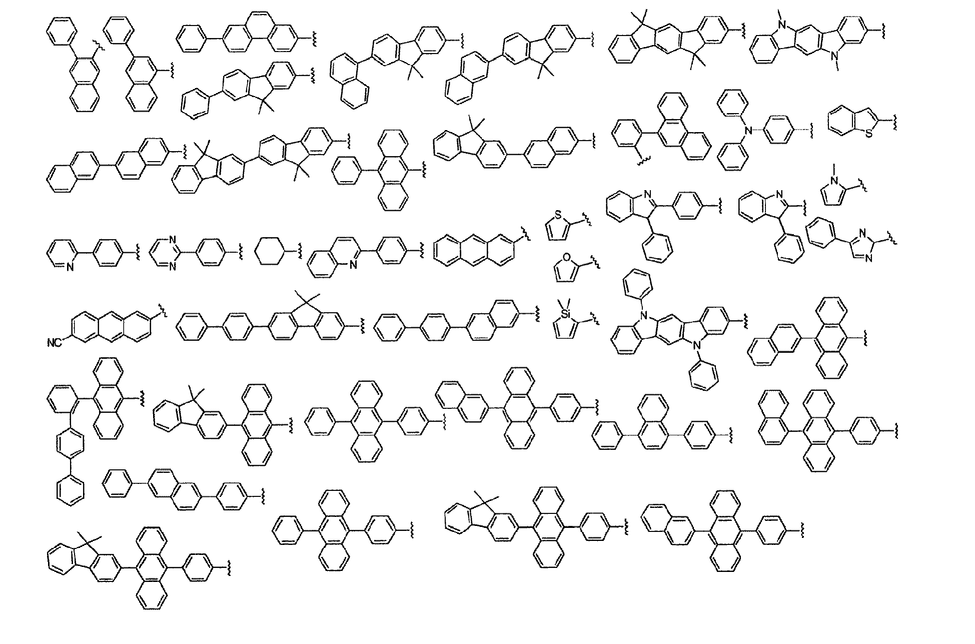

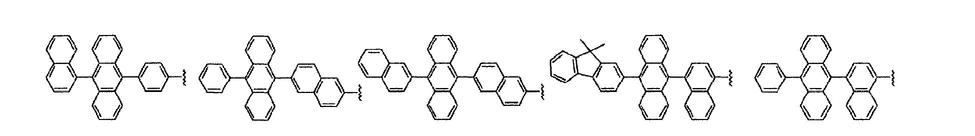

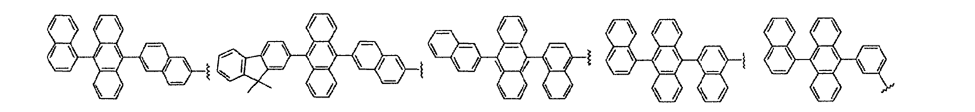

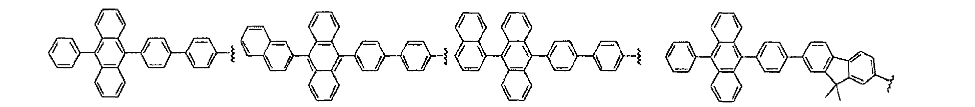

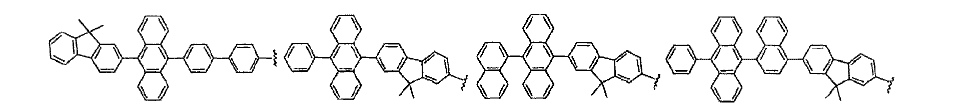

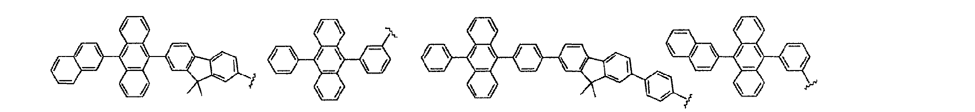

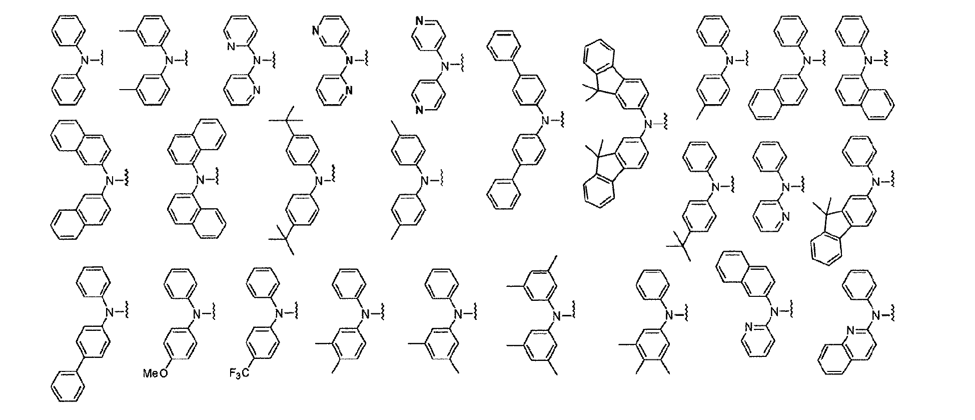

In Chemical Formula (2), L₁ and L₂ independently represent a chemical bond, or arylene selected from the following structures, or heteroarylene, without restriction: 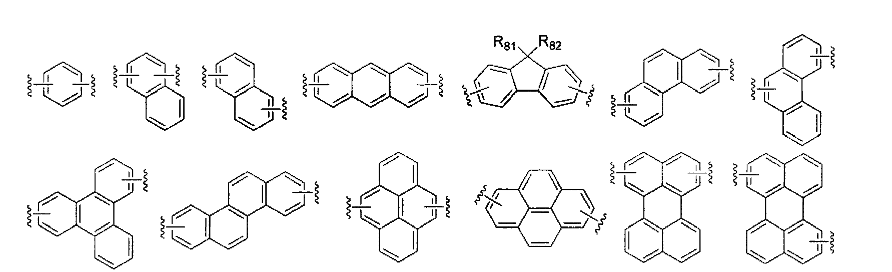 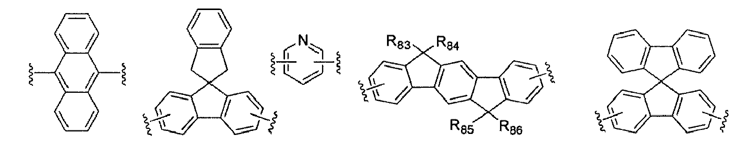 wherein, R₈₁ through R₈₆ independently represent hydrogen, deuterium, halogen, (C1-C60)alkyl with or without halogen substituent(s), (C6-C60)aryl, (C3-C60)heteroaryl with or without (C6-C60)aryl substituent(s), morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl.

The organic electroluminescent compounds according to the present invention can be more specifically exemplified by the following compounds, without restriction:

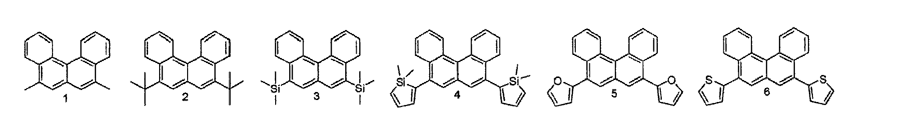

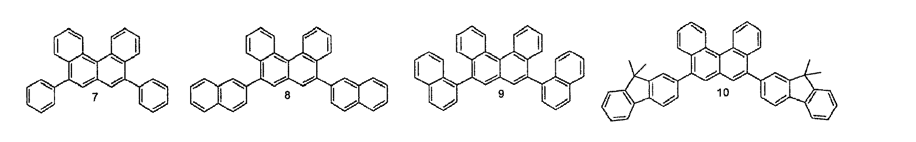

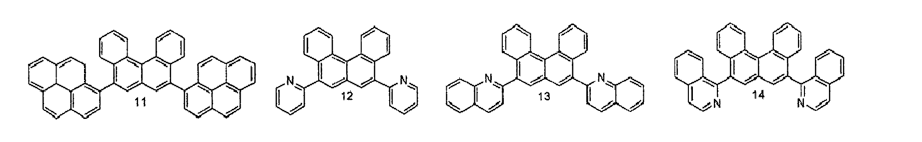

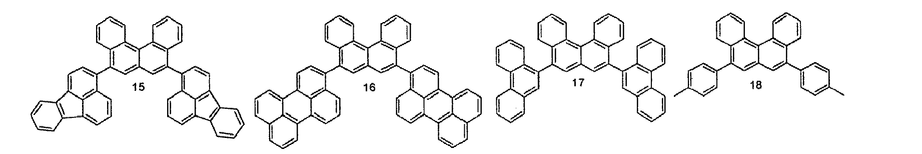

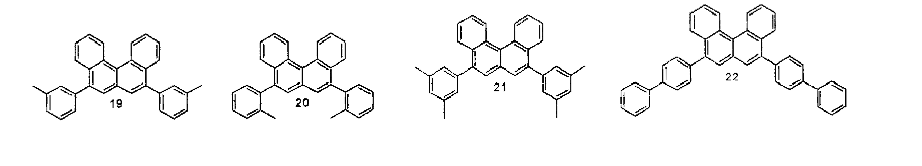

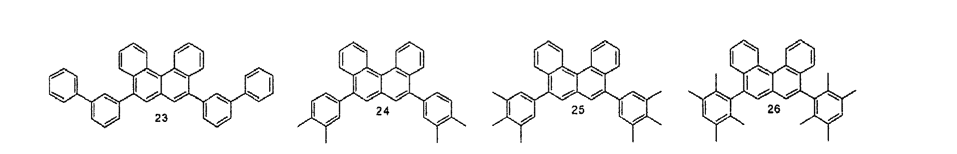

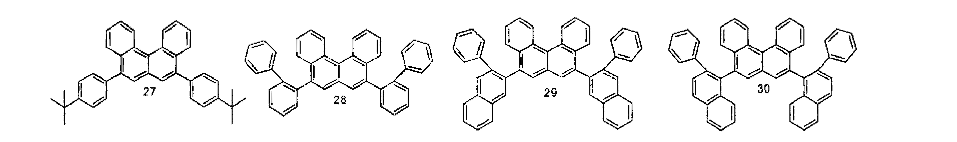

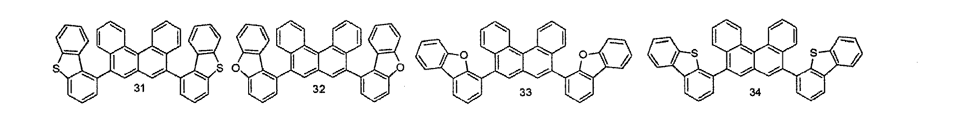

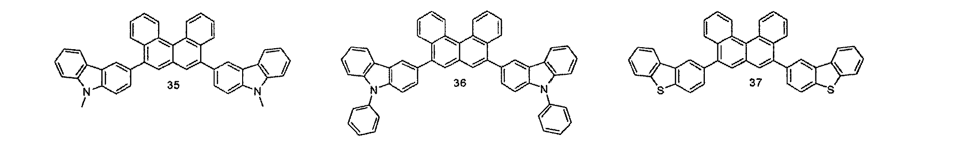

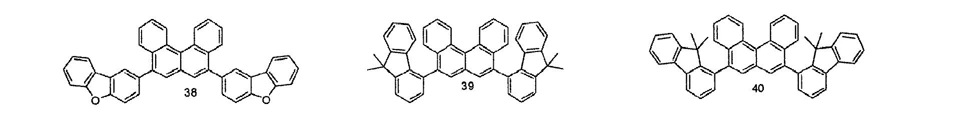

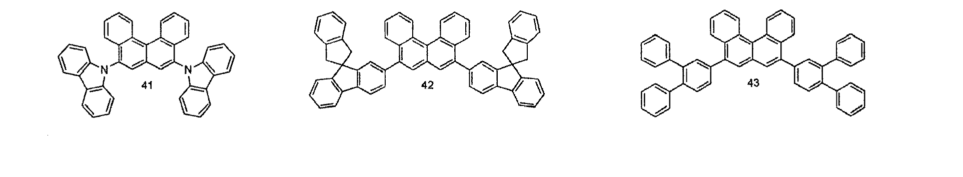

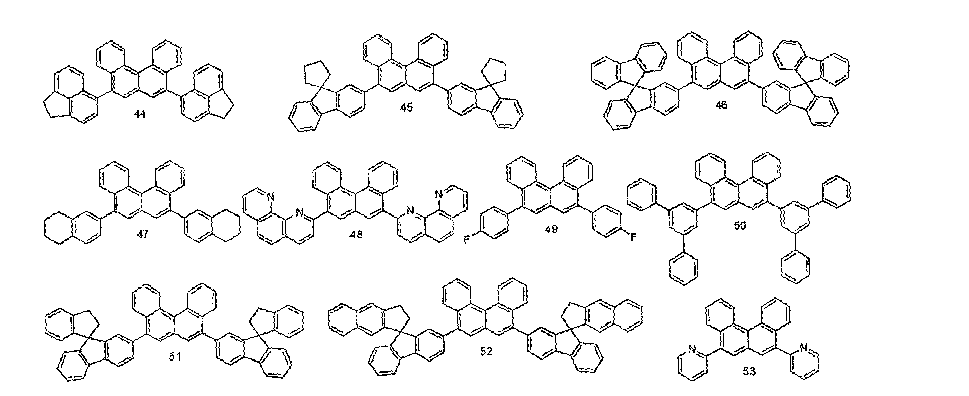

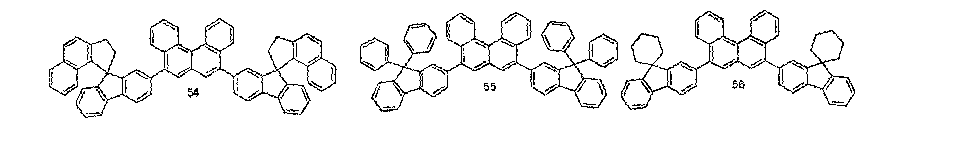

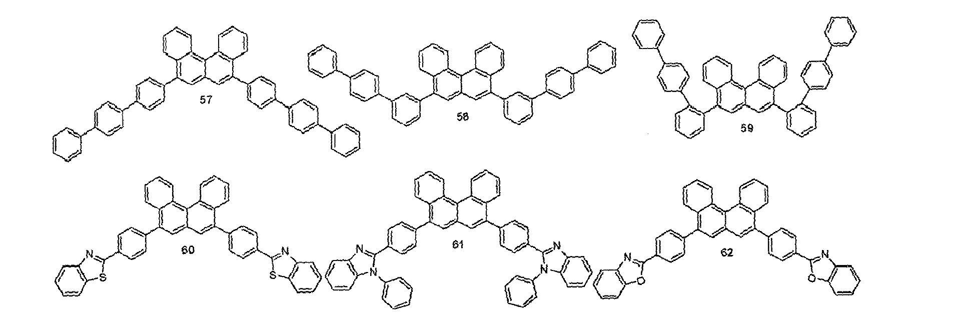

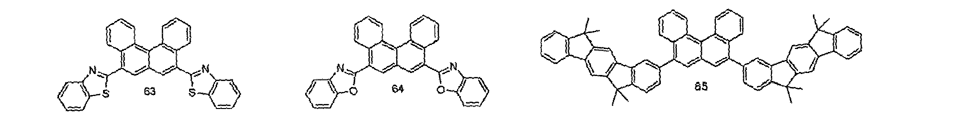

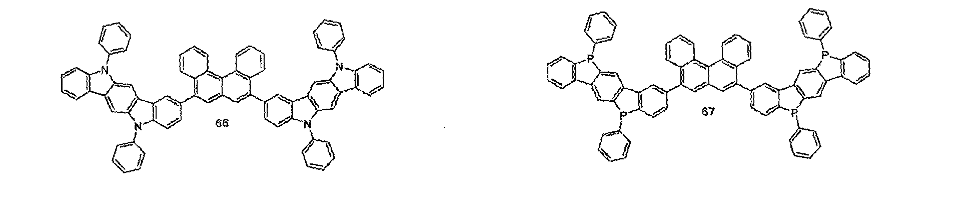

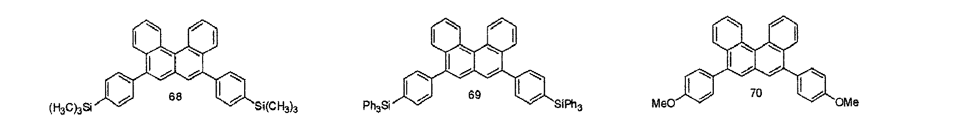

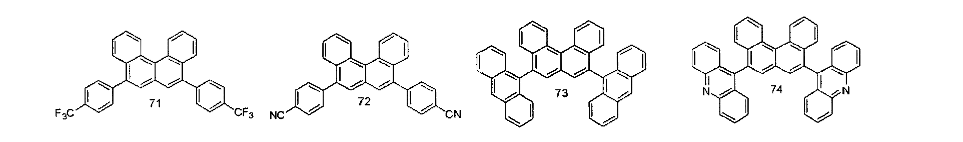

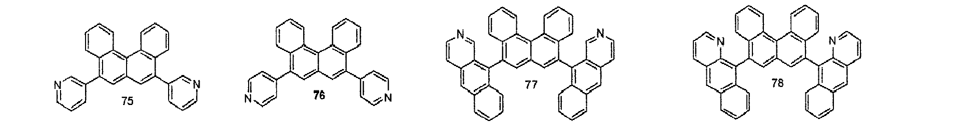

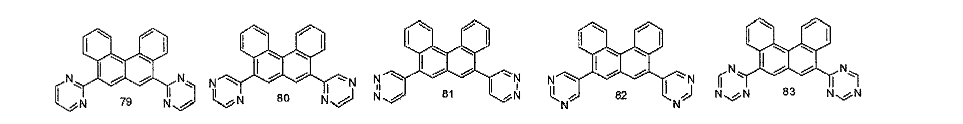

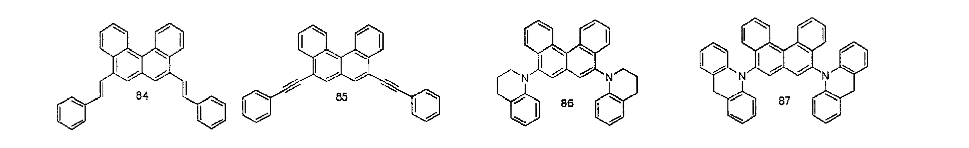

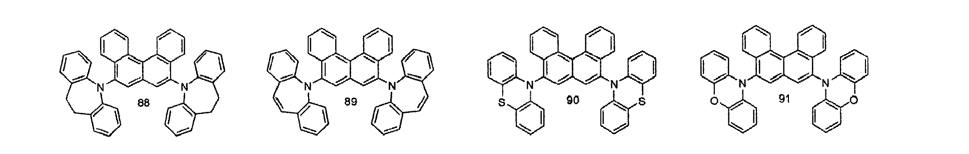

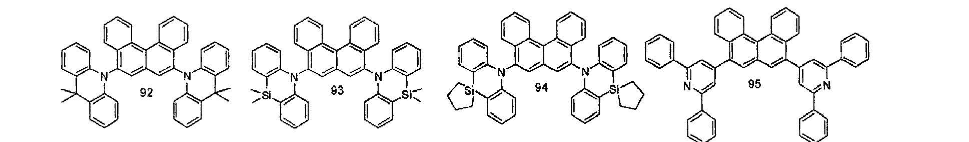

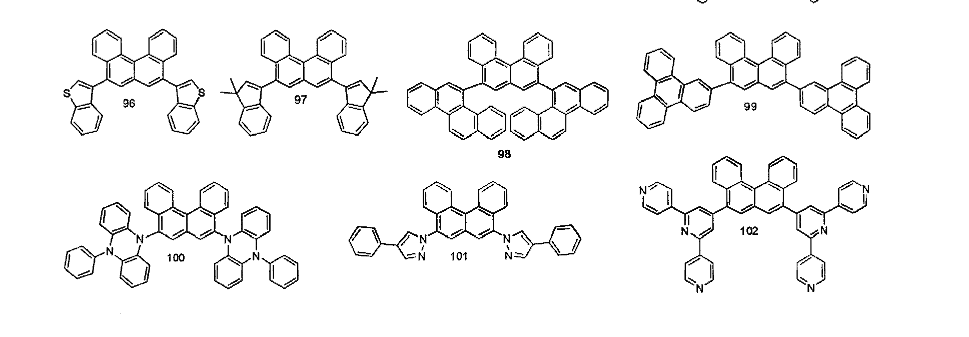

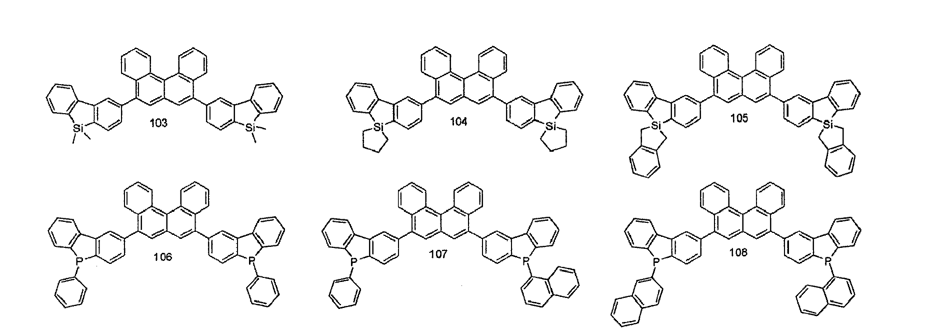

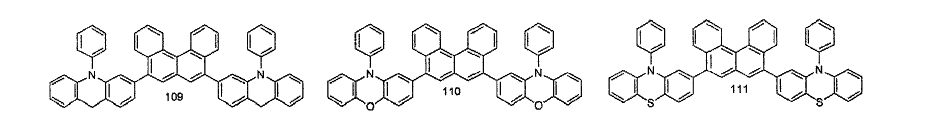

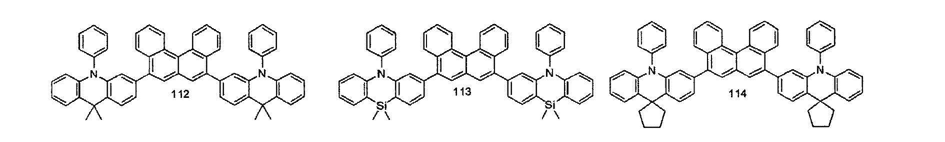

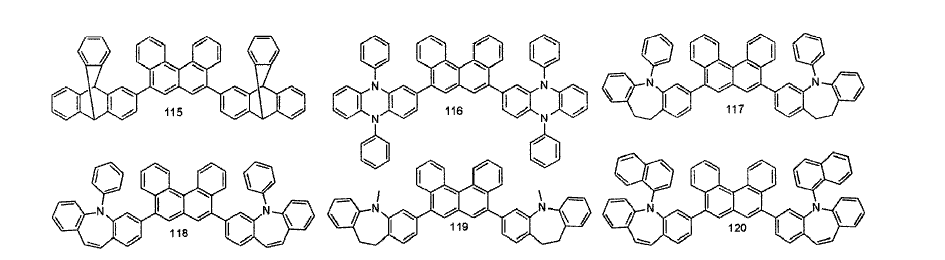

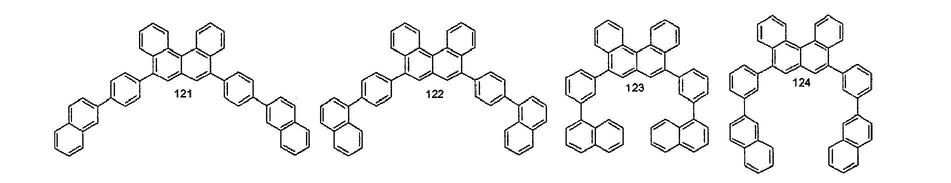

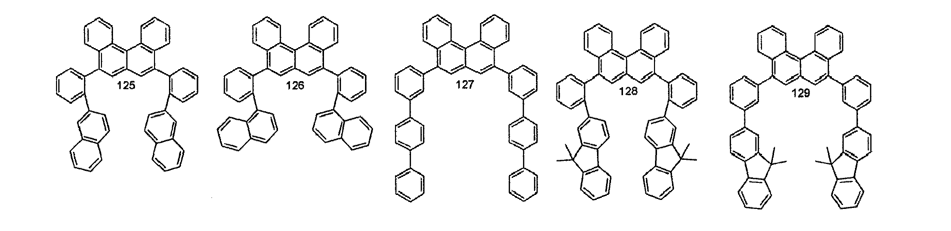

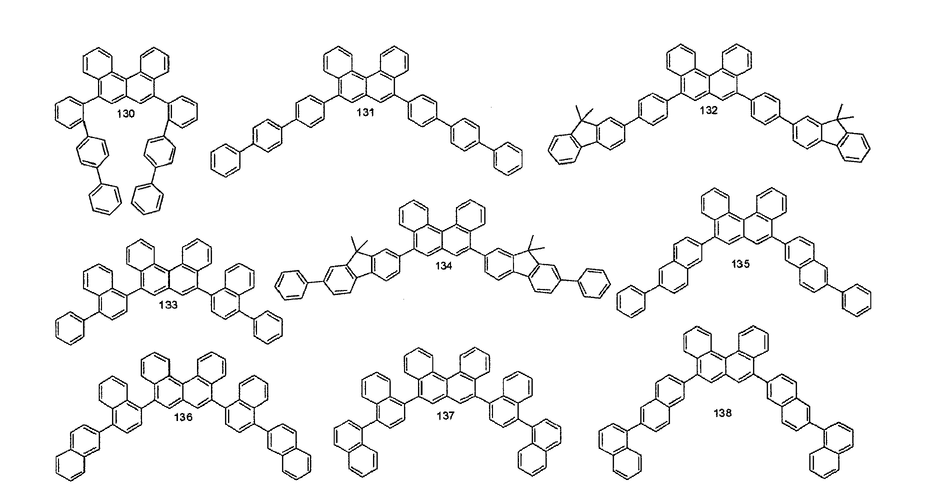

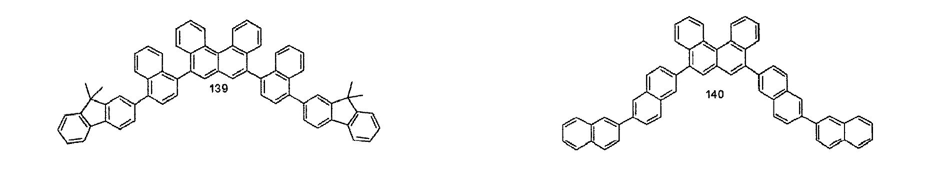

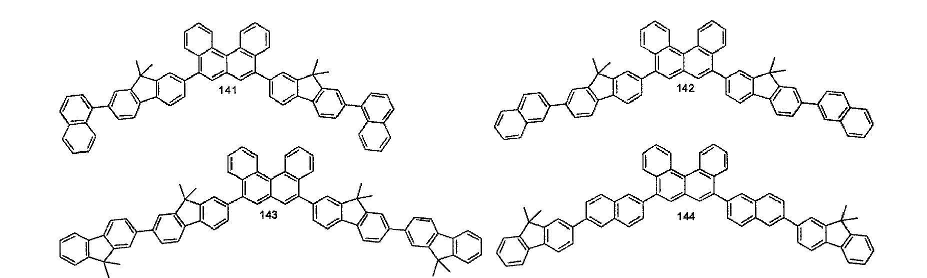

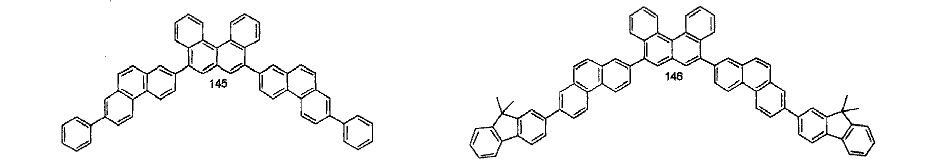

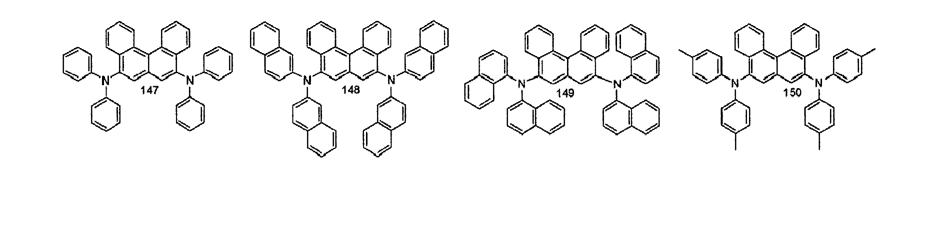

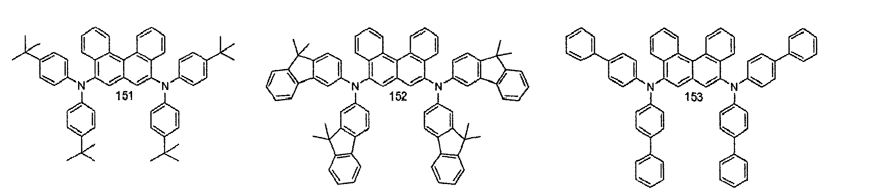

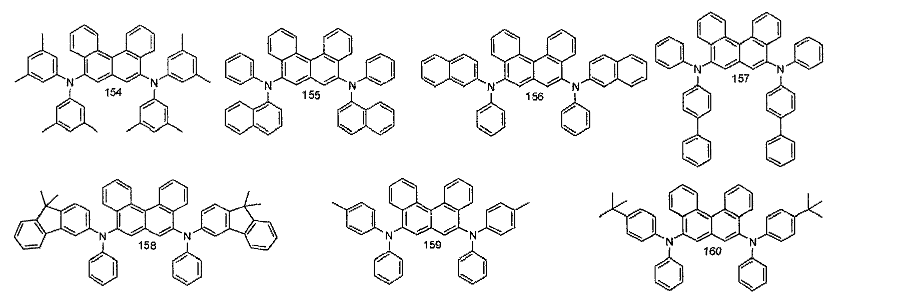

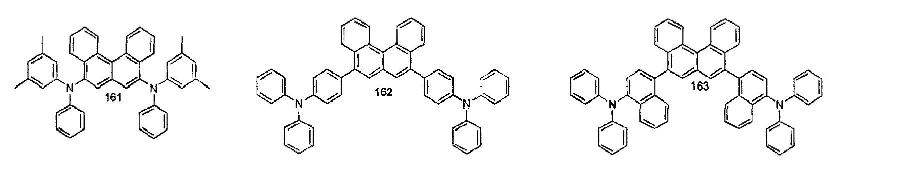

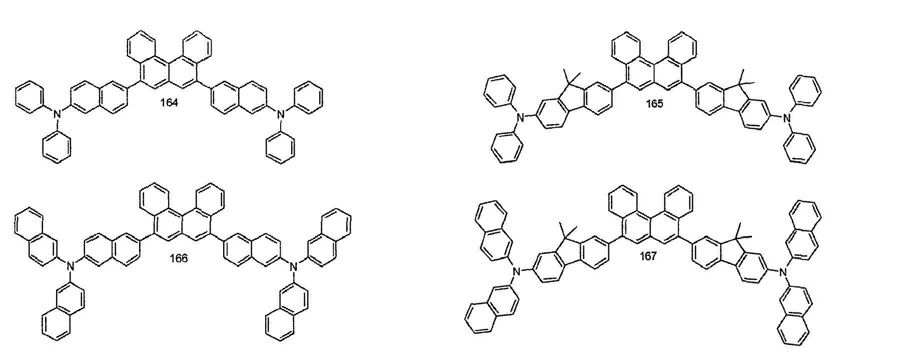

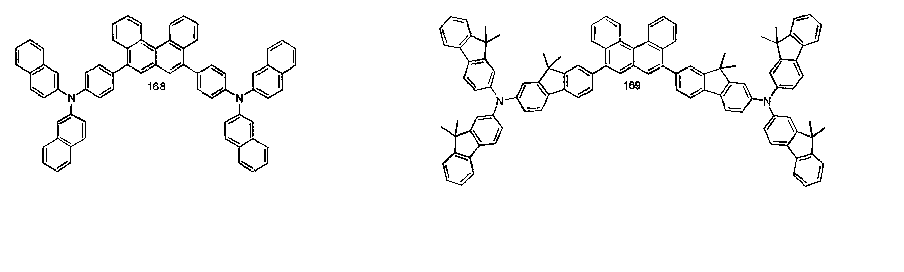

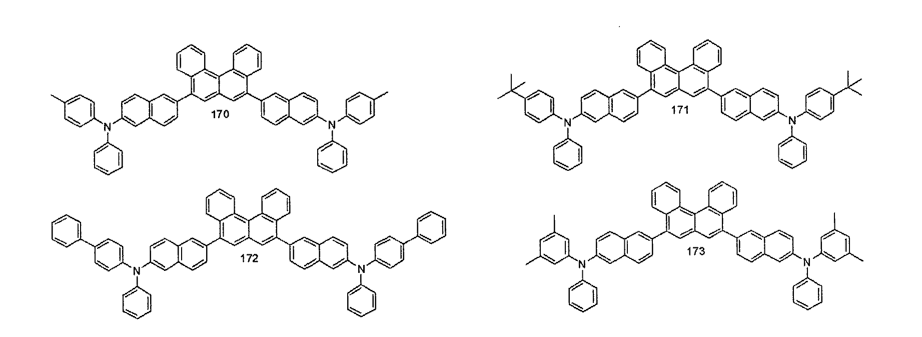

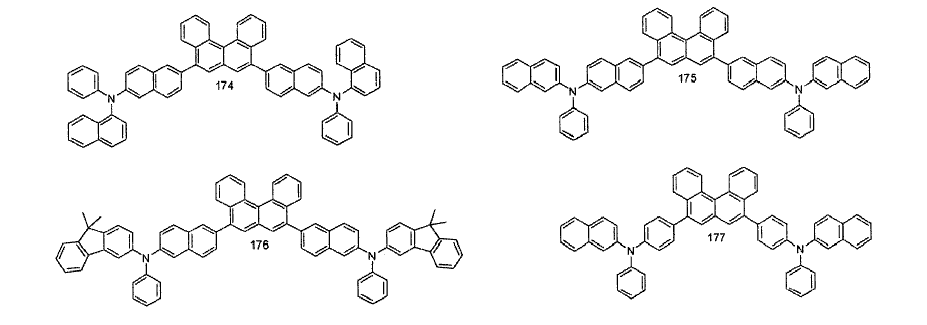

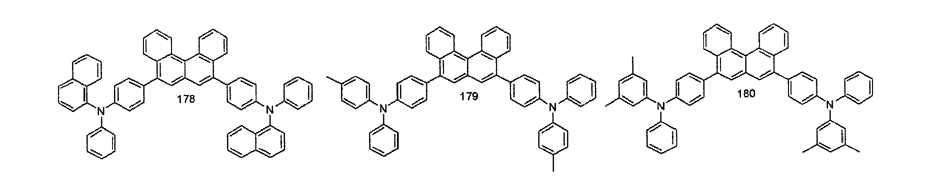

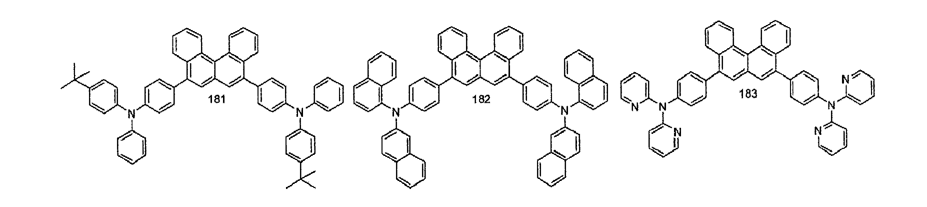

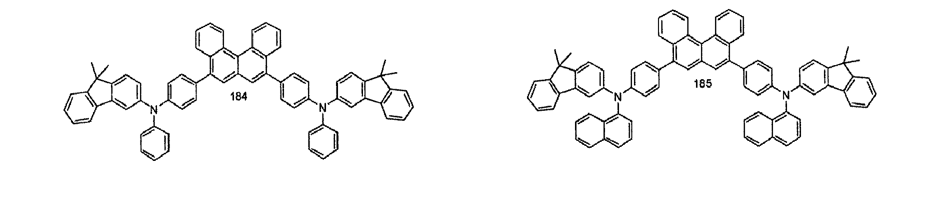

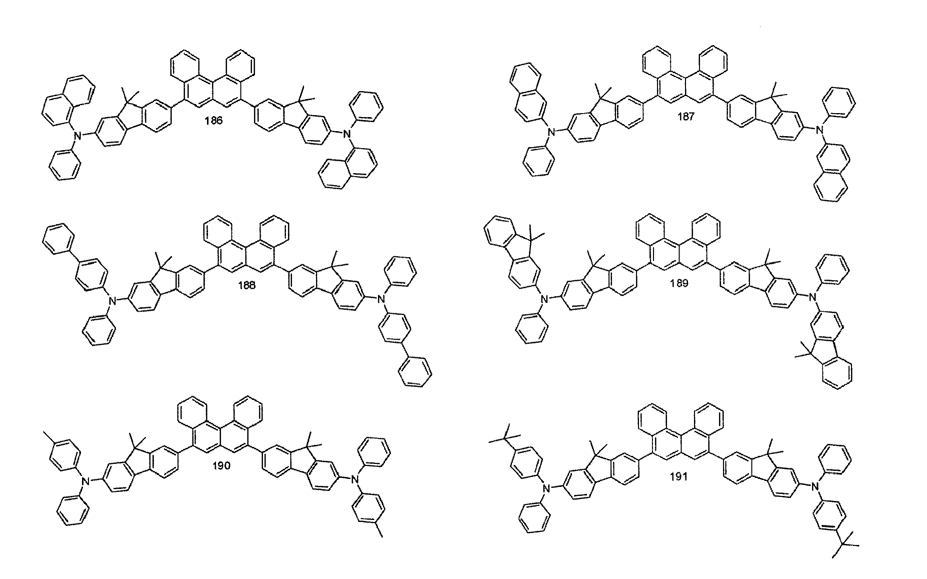

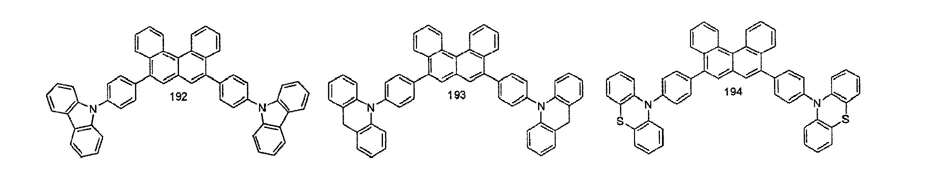

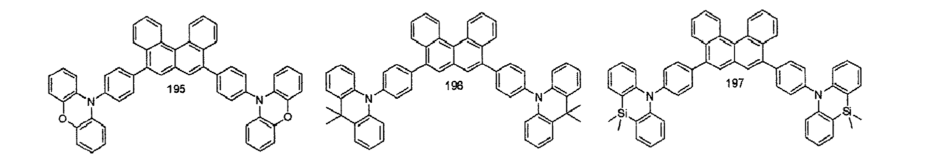

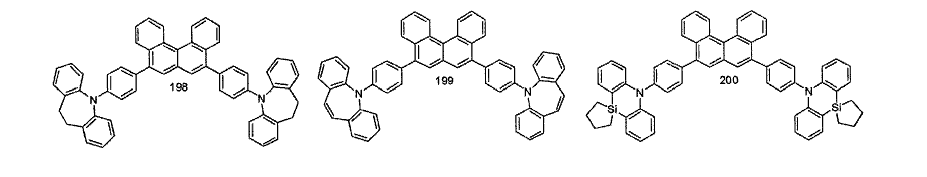

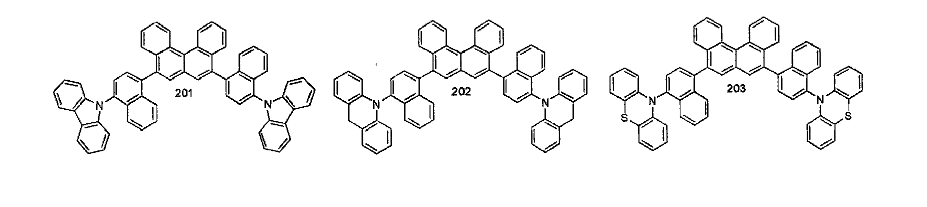

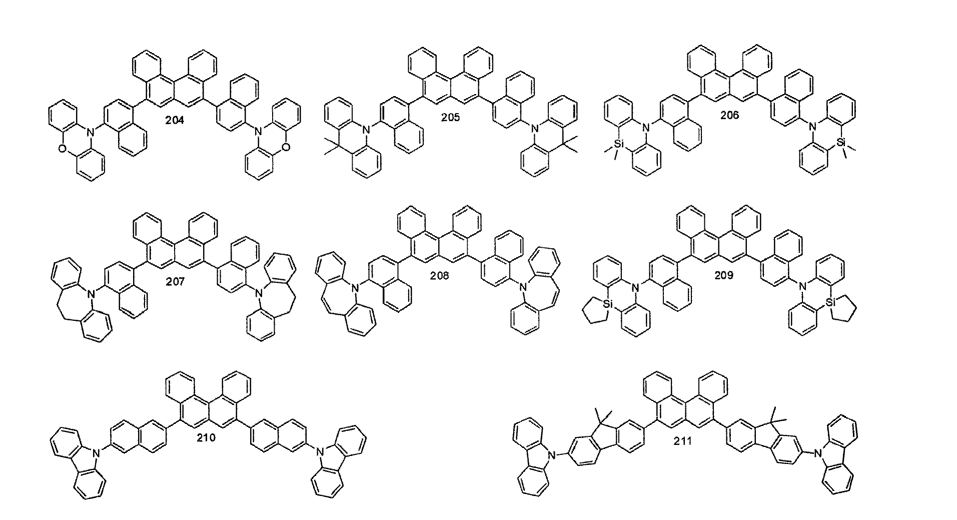

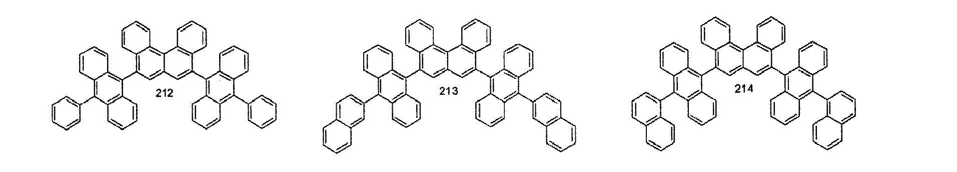

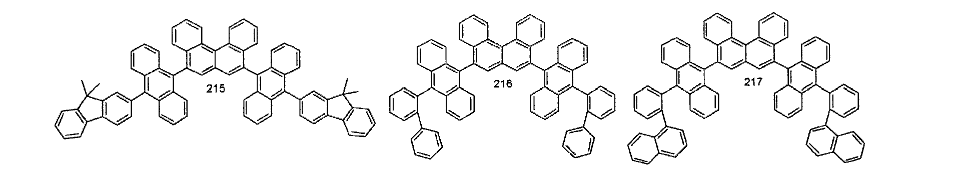

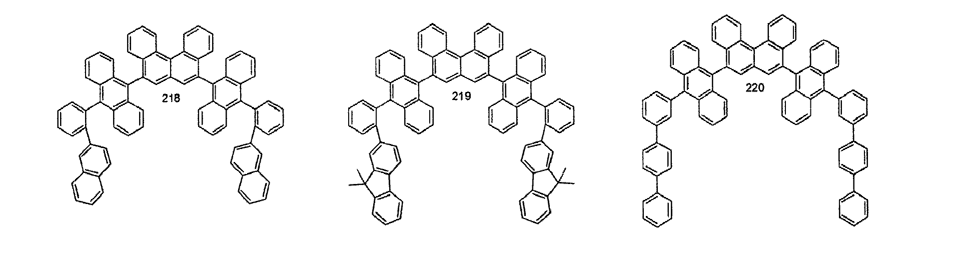

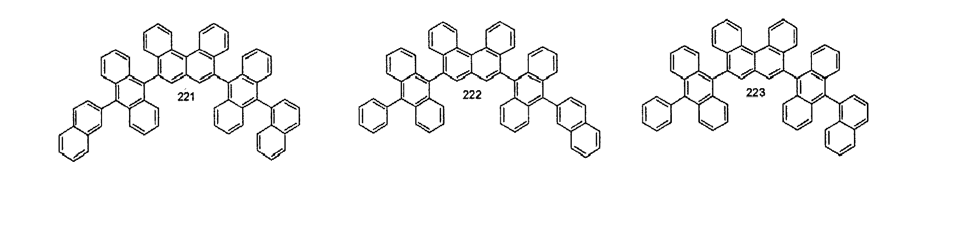

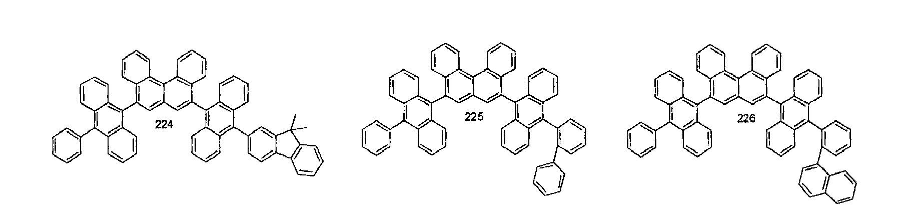

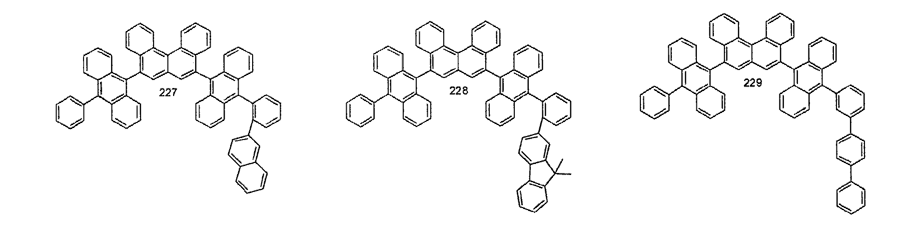

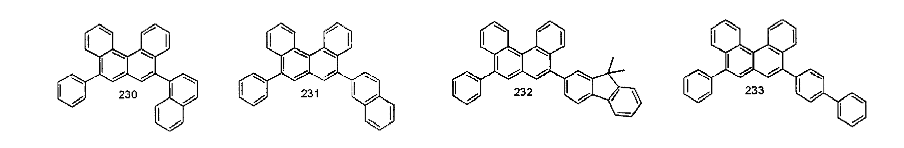

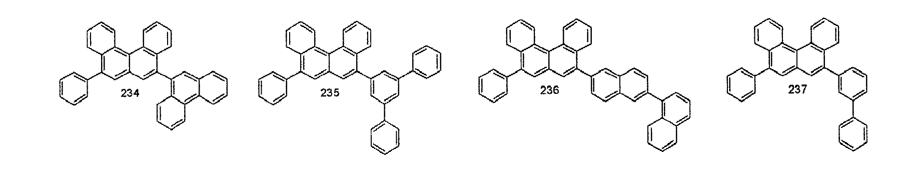

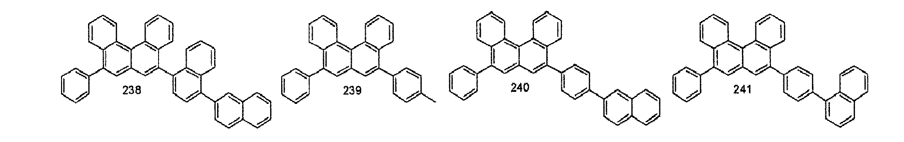

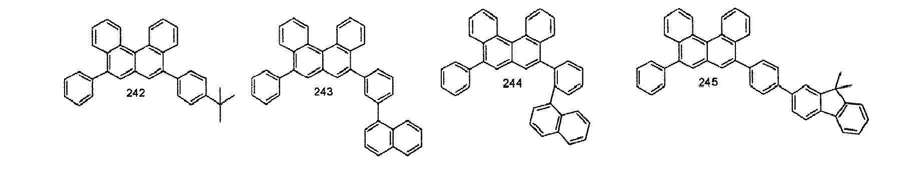

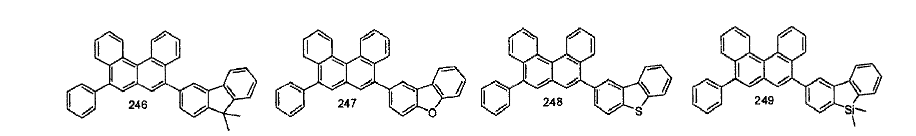

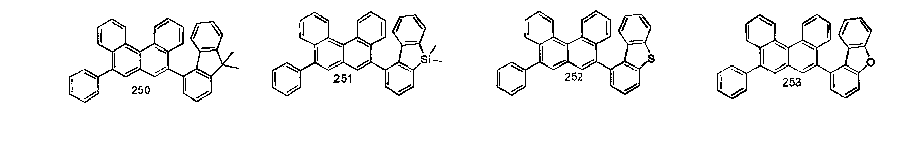

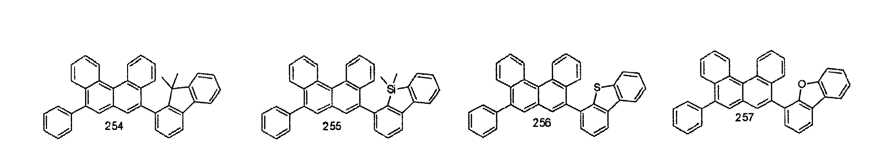

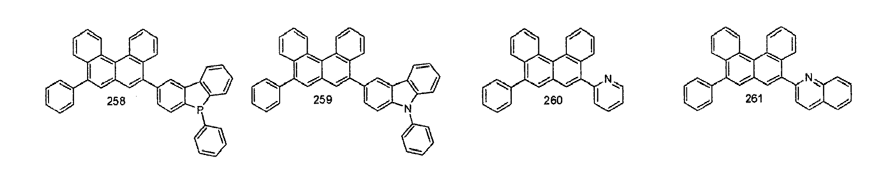

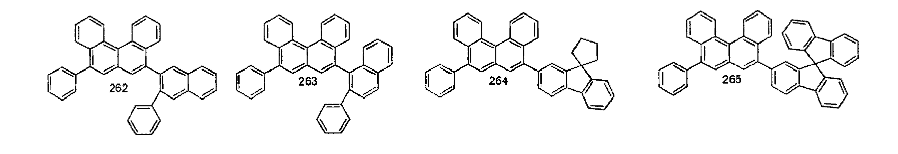

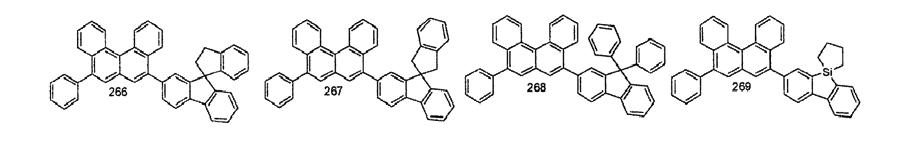

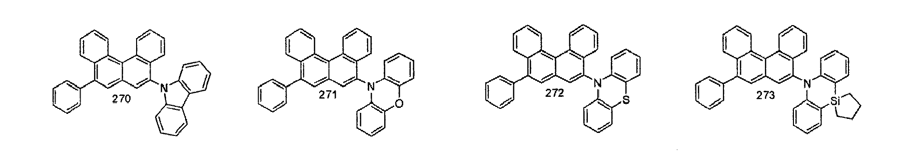

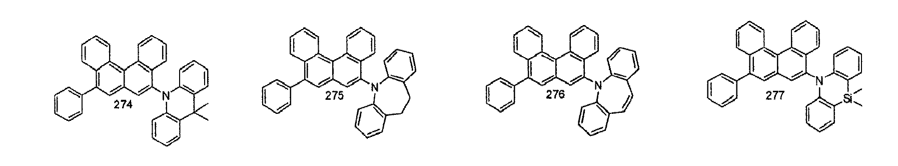

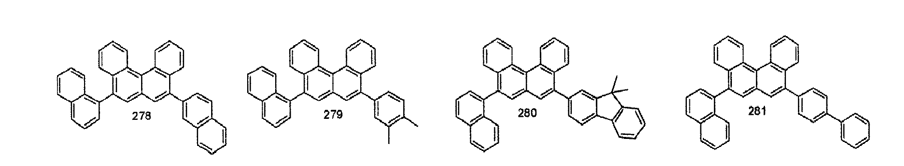

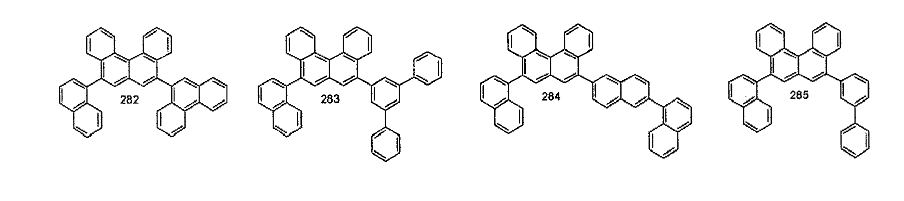

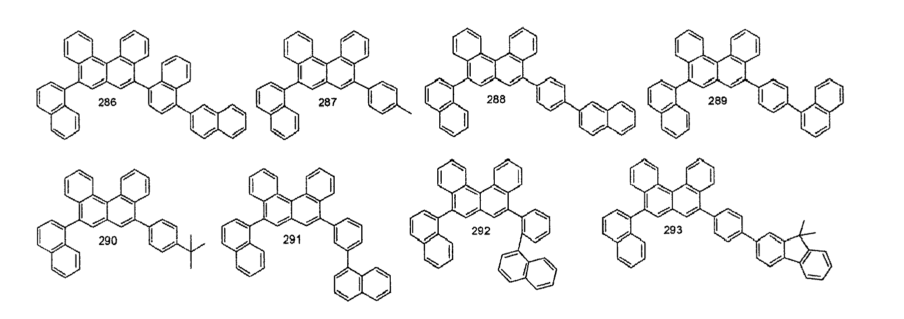

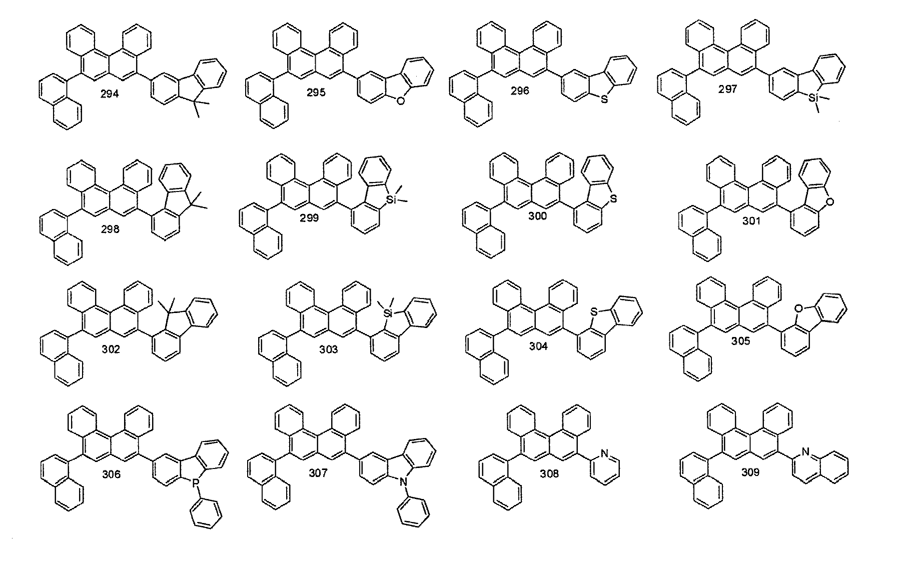

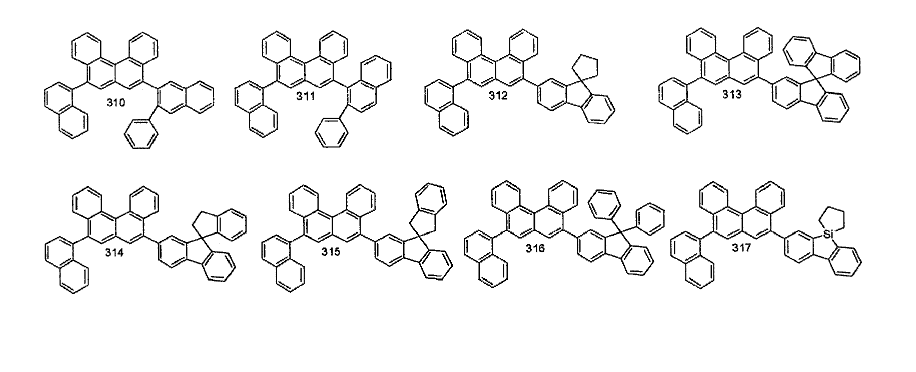

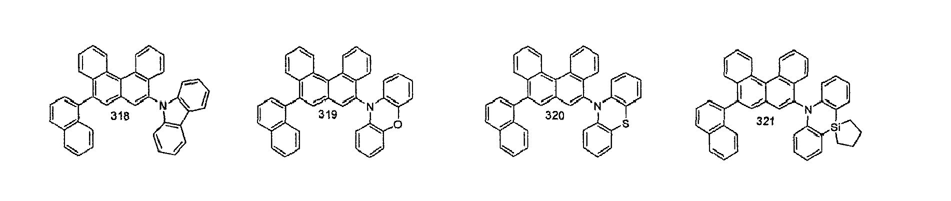

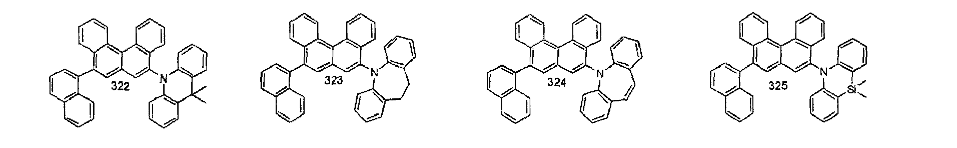

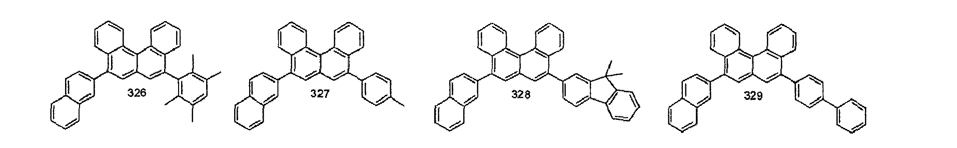

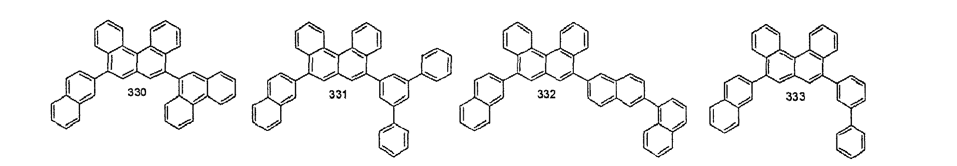

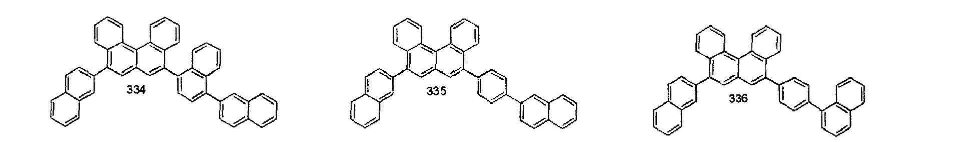

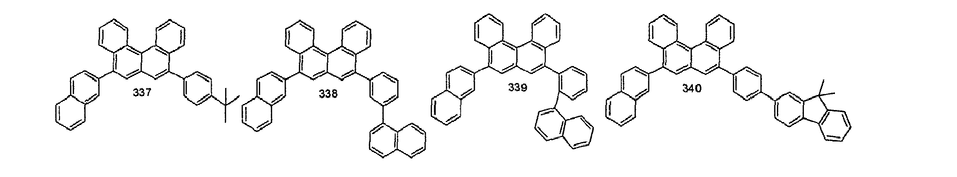

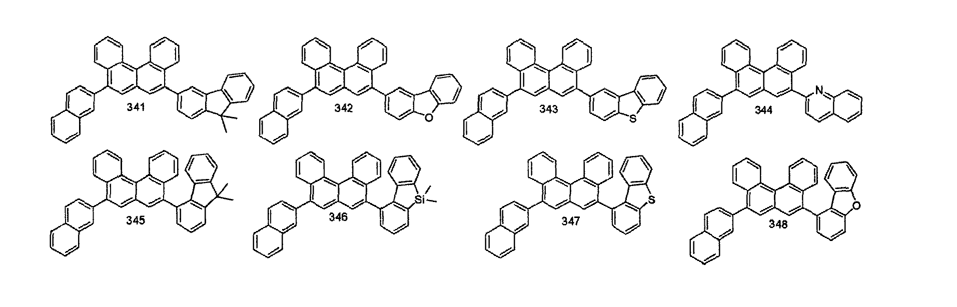

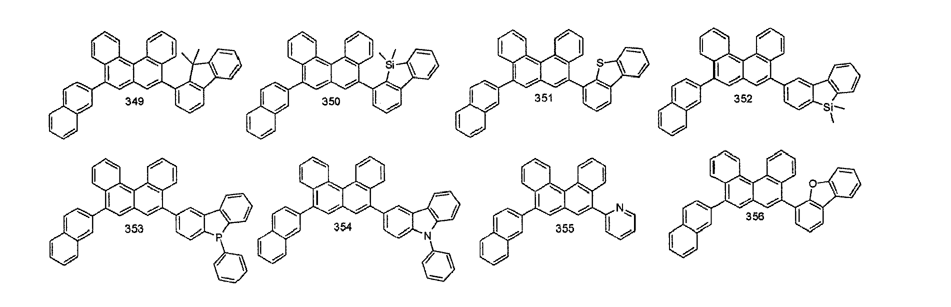

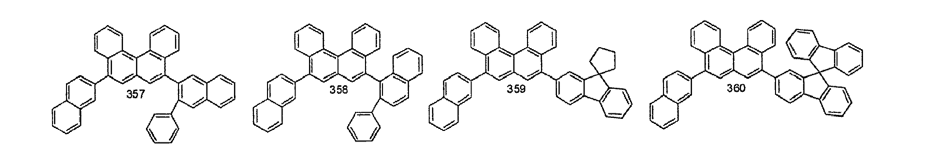

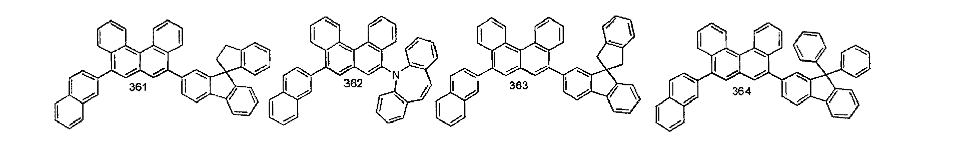

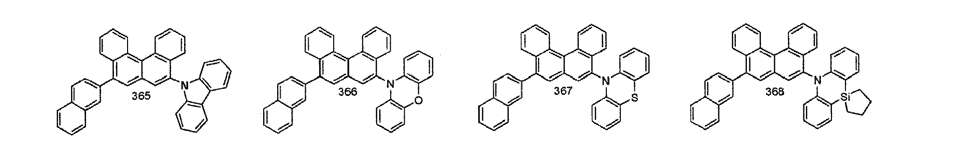

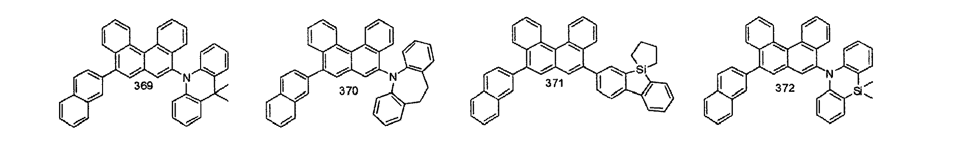

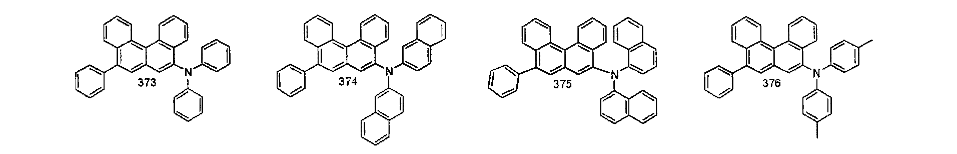

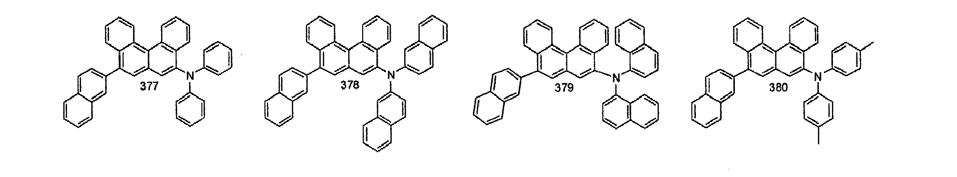

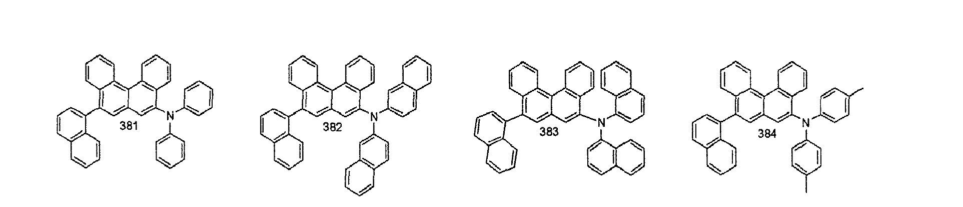

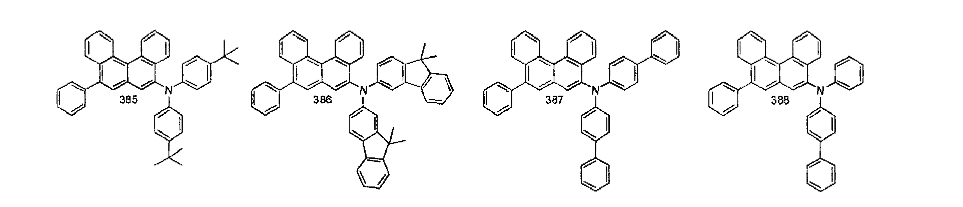

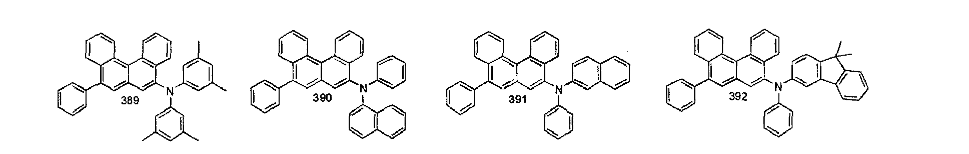

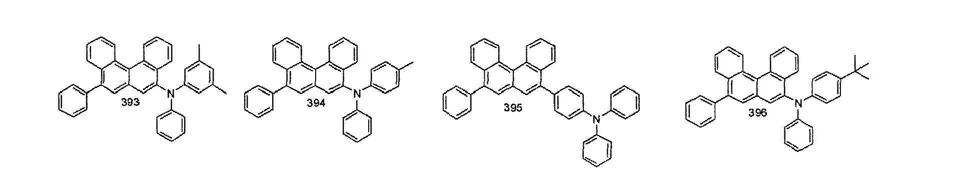

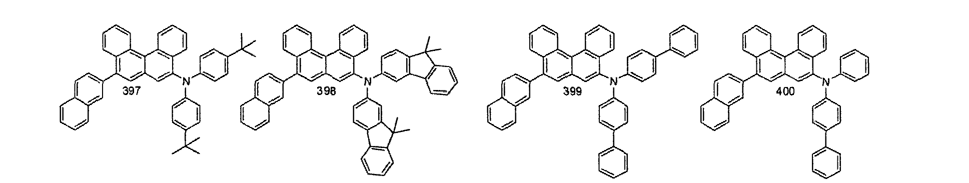

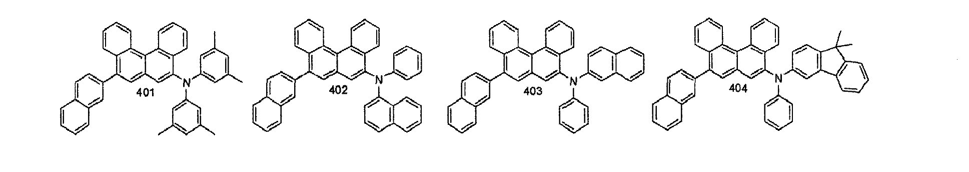

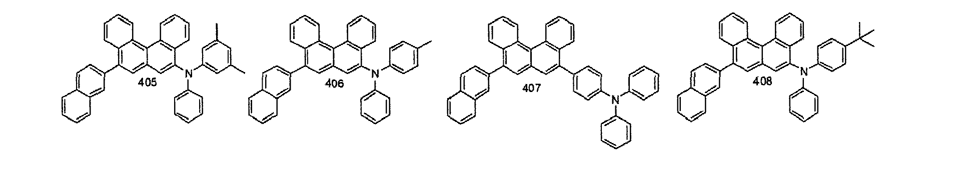

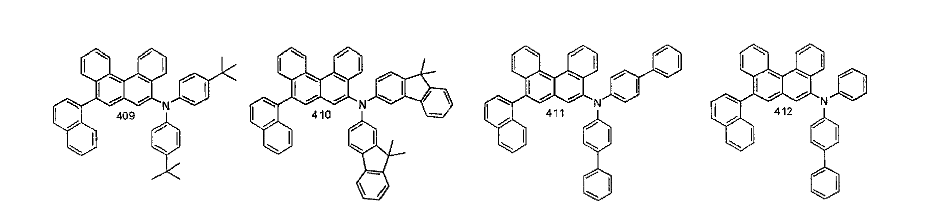

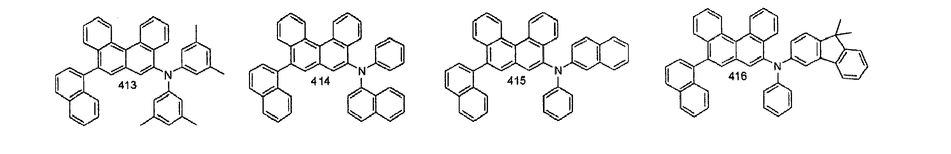

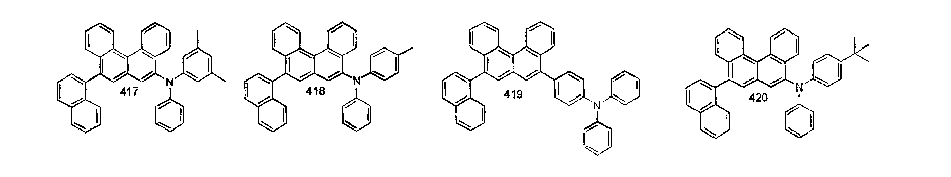

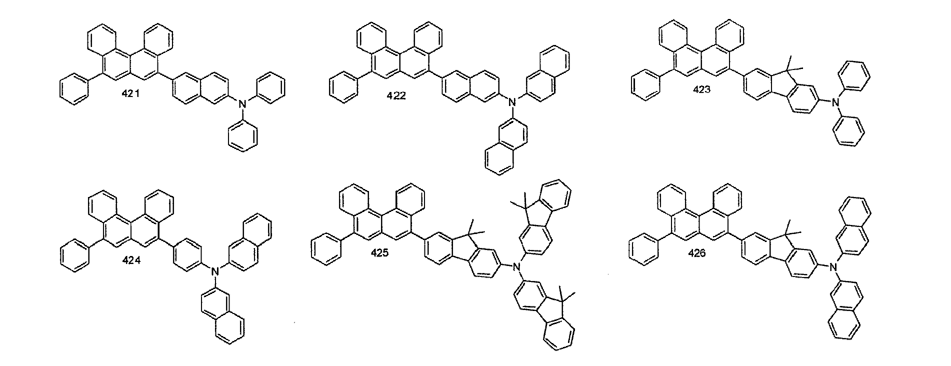

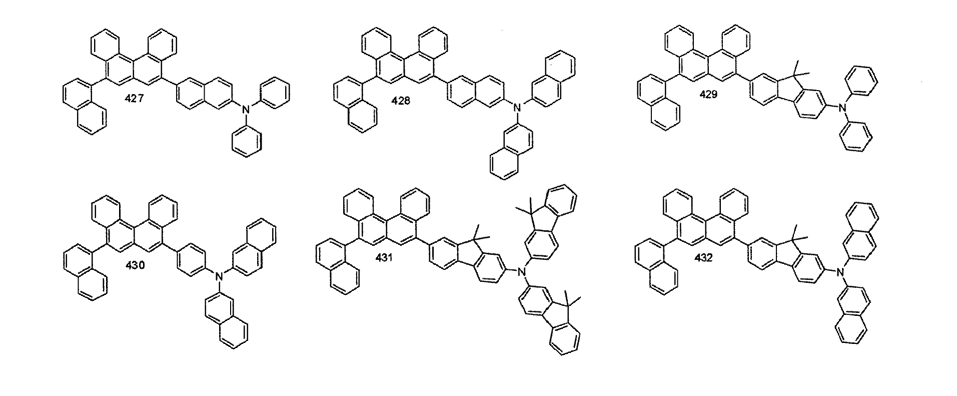

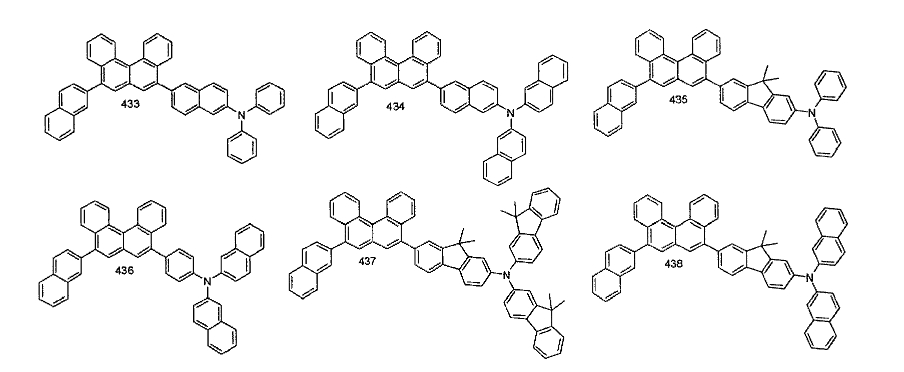

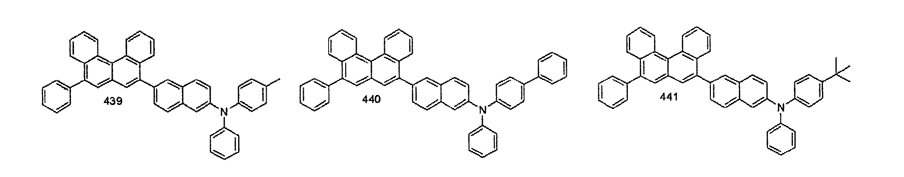

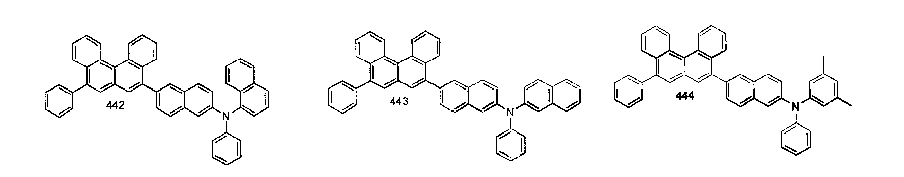

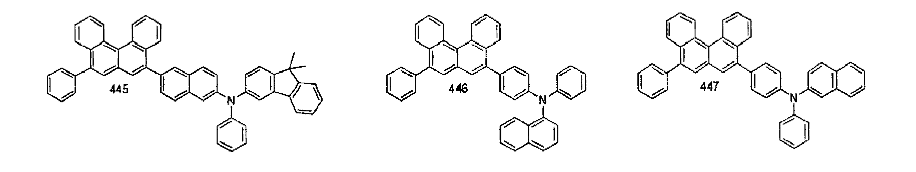

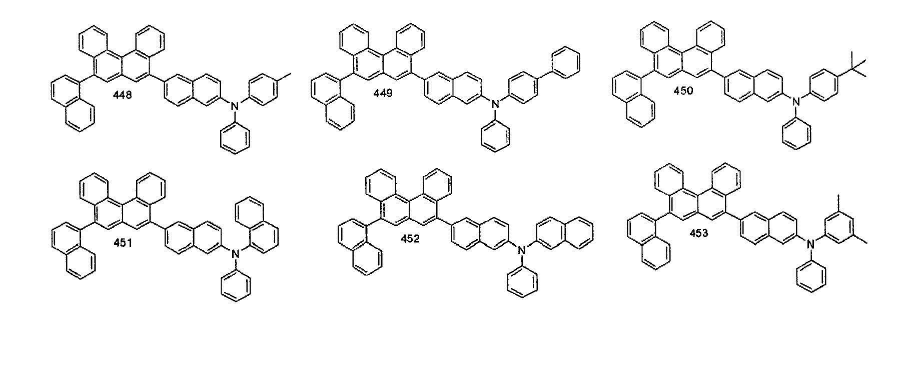

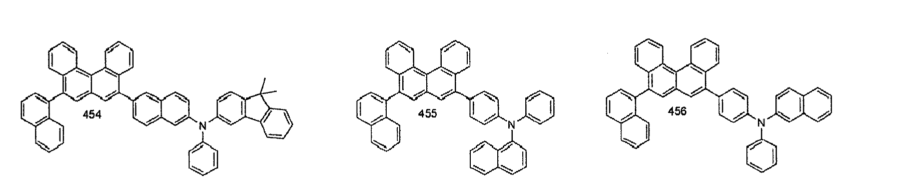

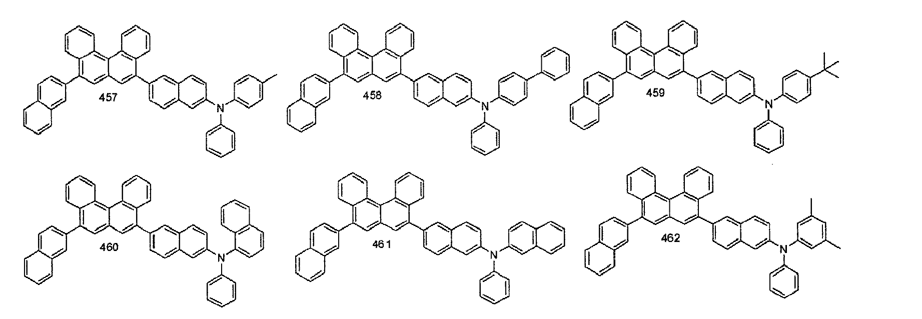

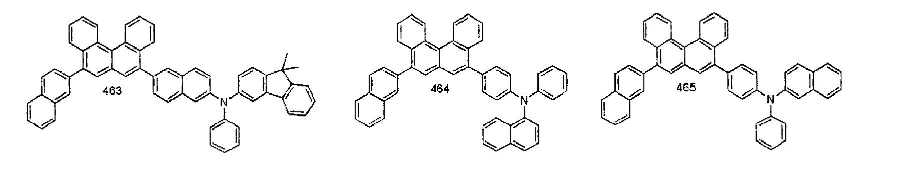

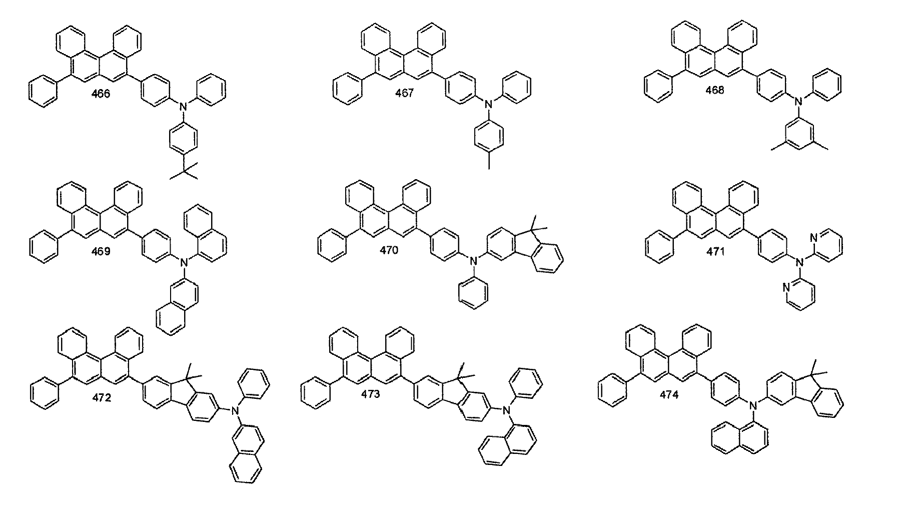

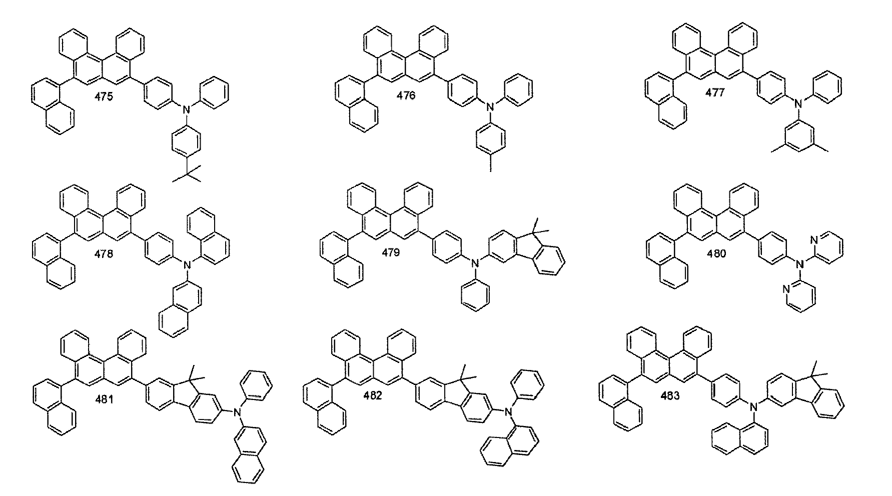

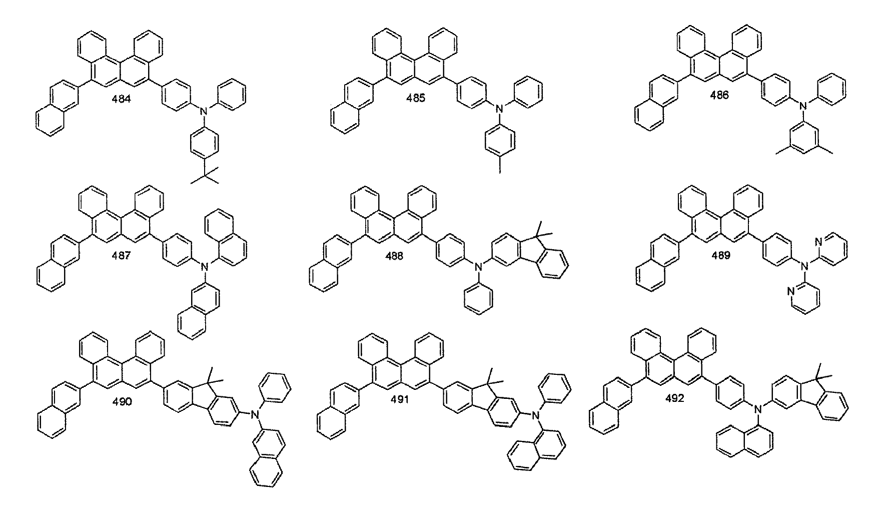

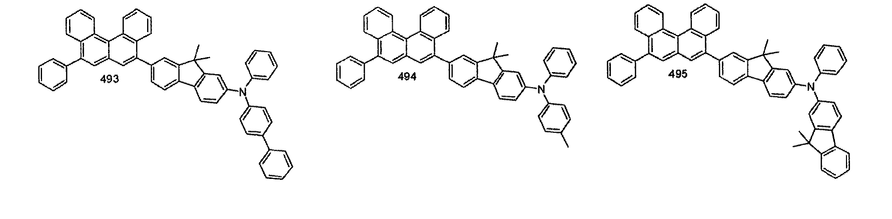

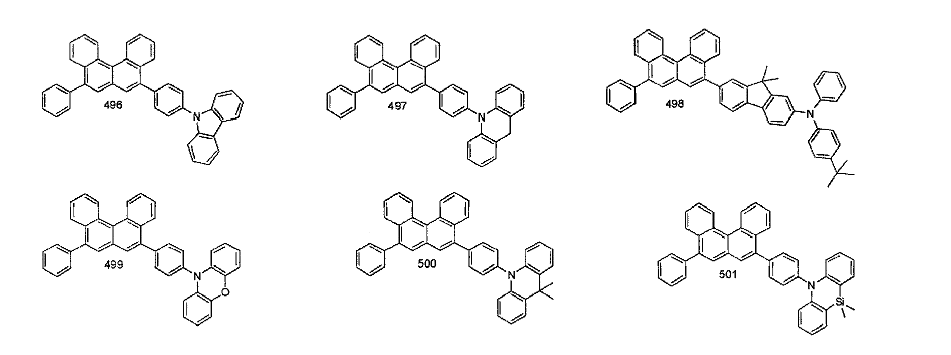

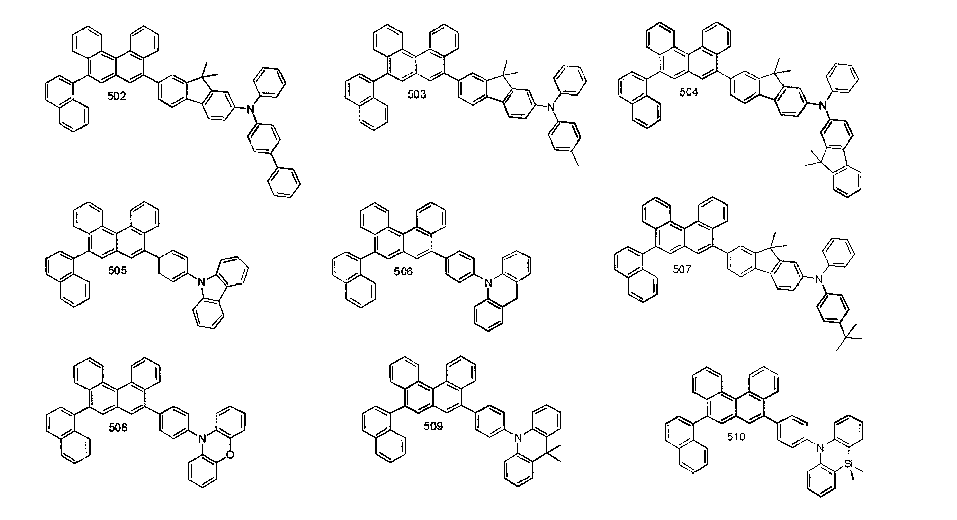

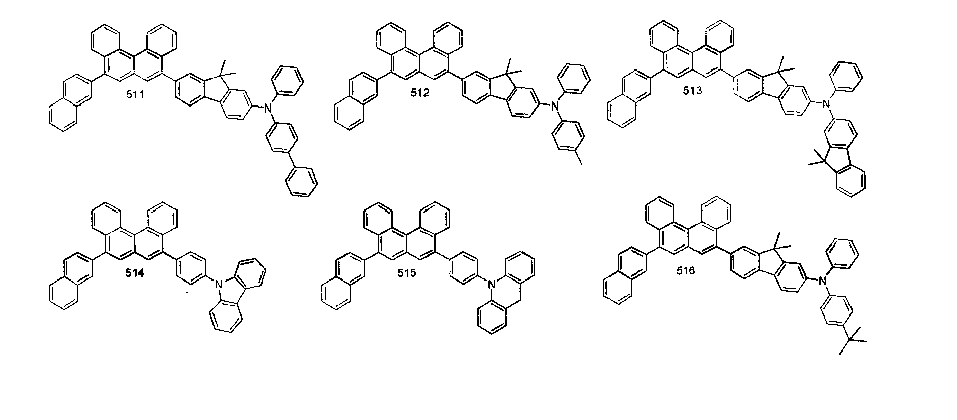

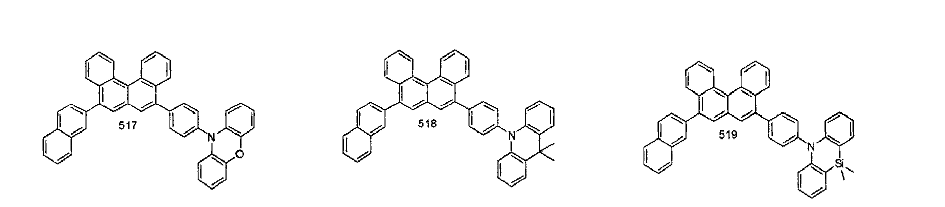

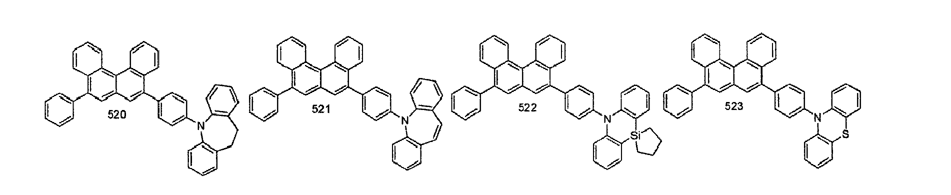

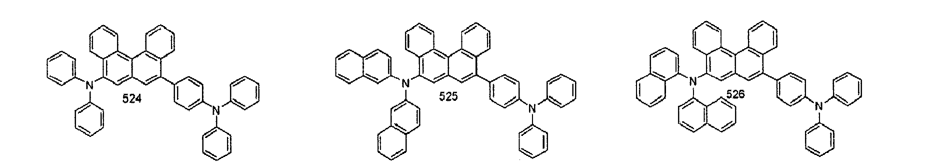

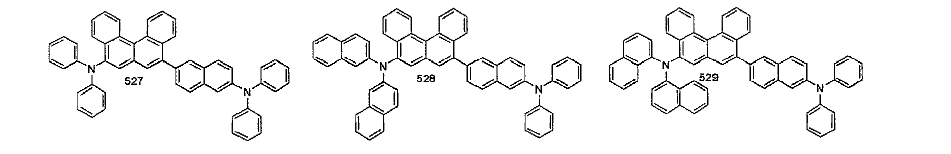

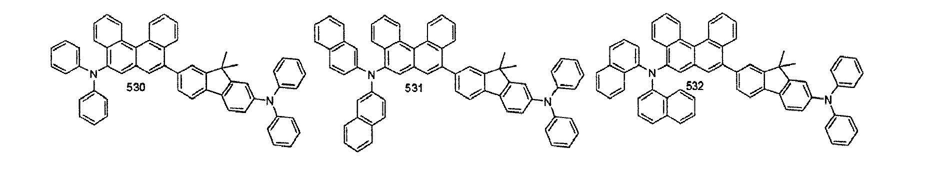

The organic electroluminescent compounds according to the present invention can be prepared according to the process illustrated by Reaction Scheme (1): 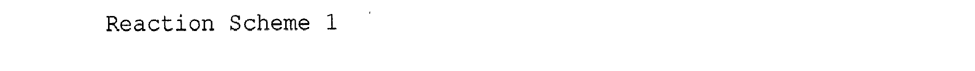 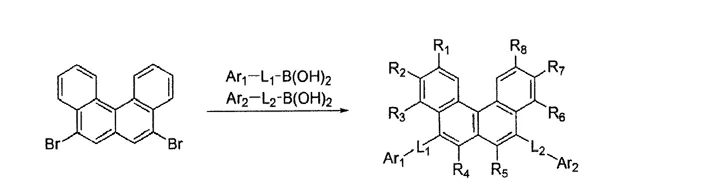 wherein, R₁ through R₈, L₁, L₂, Ar₁ and Ar₂ are defined as in Chemical Formula (2).

Further, the present invention provides organic solar cells, which comprise one or more organic electroluminescent compound(s) represented by Chemical Formula (1).

The present invention also provides an organic electroluminescent device which is comprised of a first electrode; a second electrode; and at least one organic layer(s) interposed between the first electrode and the second electrode; wherein the organic layer comprises one or more organic electroluminescent compound(s) represented by Chemical Formula (1). The organic electroluminescent compounds may be employed as dopant or host material for an electroluminescent layer.

The organic electroluminescent device according to the present invention is **characterized in that** the organic layer comprises an electroluminescent layer, which contains one or more dopant(s) or host(s) in addition to one or more organic electroluminescent compound(s) represented by Chemical Formula (1). The dopant or host to be applied to an organic electroluminescent device according to the present invention is not particularly restrictive.

The dopant to be applied to the organic electroluminescent device according to the invention is preferably selected from the compounds represented by one of Chemical Formulas (3) to (6): 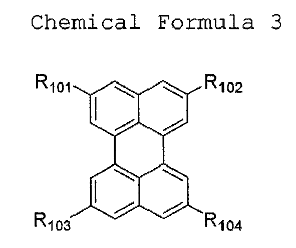 wherein, R₁₀₁ through R₁₀₄ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C1-C60)alkylthio, (C6-C60)arylthio, (C1-C60)alkoxycarbonyl, (C1-C60)alkylcarbonyl, (C6-C60)arylcarbonyl, carboxyl, nitro or hydroxyl, or R₁₀₁ through R₁₀₄ may be linked to an adjacent substituent via (C3-C60)alkylene or (C3-C60)alkenylene with or without a fused ring to form an alicyclic ring, or a monocyclic or polycyclic aromatic ring; and
the alkyl, alkenyl, alkynyl, cycloalkyl, heterocycloalkyl, aryl, heteroaryl, arylsilyl, alkylsilyl, alkyloxy, aryloxy, arylthio, alkylamino or arylamino of R₁₀₁ through R₁₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C1-C60)alkylthio, (C6-C60)arylthio, (C1-C60)alkoxycarbonyl, (C1-C60)alkylcarbonyl, (C6-C60)arylcarbonyl, carboxyl, nitro and hydroxyl; 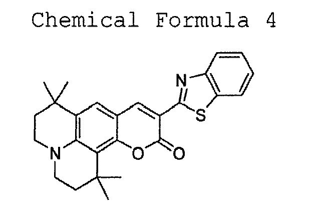 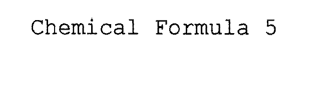 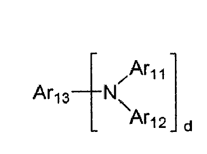 wherein, Ar₁₁ and Ar₁₂ independently represent (C1-C60)alkyl, (C6-C60)aryl, (C4-C60)heteroaryl, (C6-C60)arylamino, (C1-C60)alkylamino, 5- or 6-membered heterocycloalkyl containing one or more heteroatom(s) selected from N, O and S, or (C3-C60)cycloalkyl, or Ar₁₁ and Ar₁₂ may be linked via (C3-C60)alkylene or (C3-C60)alkenylene with or without a fused ring to form an alicyclic ring, or a monocyclic or polycyclic aromatic ring;
when d is 1, Ar₁₃ represents (C6-C60)aryl, (C4-C60)heteroaryl or aryl having one of the following structure: 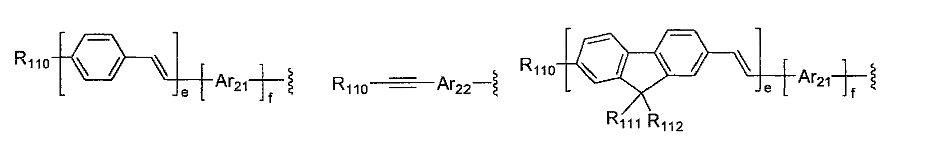 when d is 2, Ar₁₃ represents (C6-C60)arylene, (C4-C60)heteroarylene or arylene having one of the following structure:

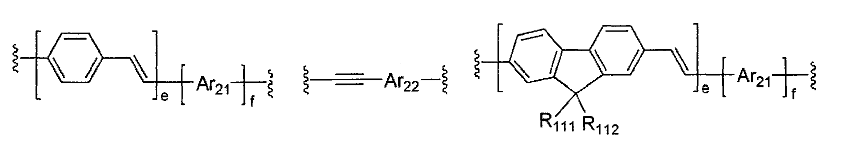

Ar₂₁ and Ar₂₂ independently represent (C6-C60)arylene or (C4-C60)heteroarylene;
R₁₁₀, R₁₁₁ and R₁₁₂ independently represent hydrogen, deuterium, (C1-C60)alkyl or (C6-C60)aryl;
e is an integer from 1 to 4, f is an integer of 0 or 1; and
the alkyl, aryl, heteroaryl, arylamino, alkylamino, cycloalkyl or heterocycloalkyl of Ar₁₁ and Ar₁₂; the aryl, heteroaryl, arylene or heteroarylene of Ar₁₃; arylene or heteroarylene of Ar₂₁ and Ar₂₂; or alkyl or aryl of R₁₁₀ through R₁₁₂ may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl;

Chemical Formula 6 M¹L¹⁰¹L¹⁰²L¹⁰³

wherein, M¹ is selected from a group consisting of metals from Group 7, 8, 9, 10, 11, 13, 14, 15 and 16 in the Periodic Table of Elements, and ligands L¹⁰¹, L¹⁰² and L¹⁰³ are independently selected from the following structures: 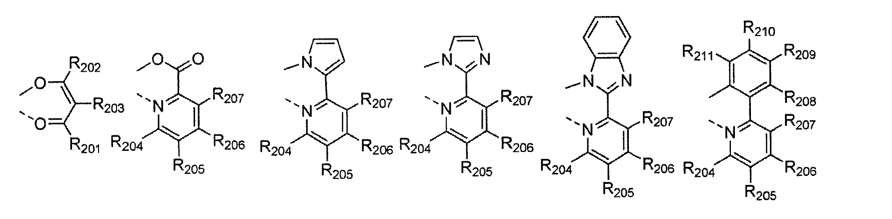 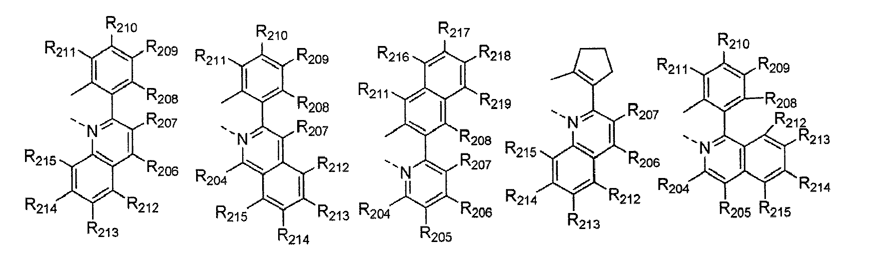 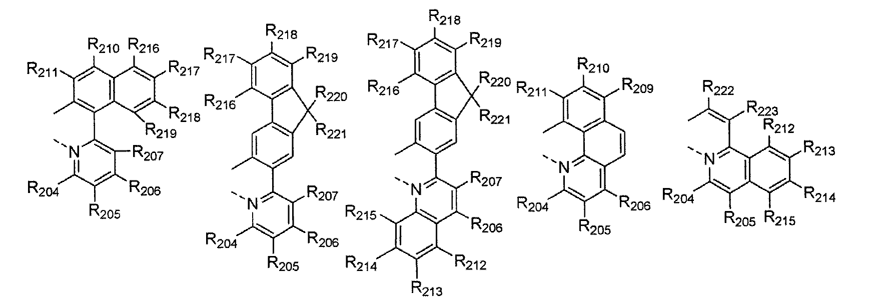 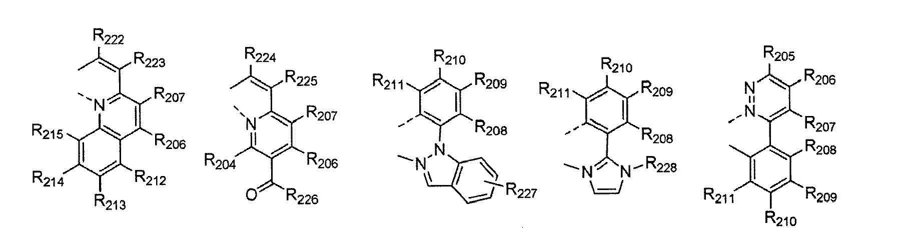 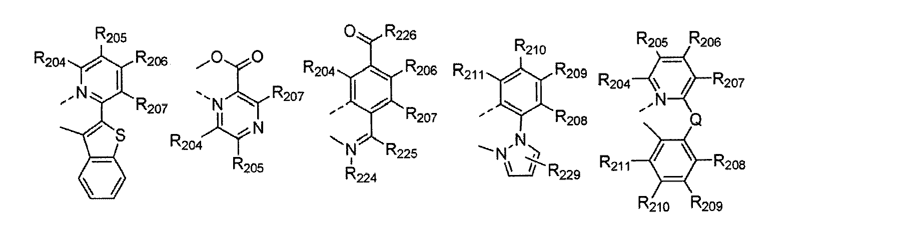 wherein, R₂₀₁ through R₂₀₃ independently represent hydrogen, deuterium, (C1-C60)alkyl with or without halogen substituent(s), (C6-C60)aryl with or without (C1-C60) alkyl substituent(s), or halogen;
R₂₀₄ through R₂₁₉ independently represent hydrogen, deuterium, (C1-C60)alkyl, (C1-C30)alkyloxy, (C3-C60)cycloalkyl, (C2-C30)alkenyl, (C6-C60)aryl, mono or di(C1-C30)alkylamino, mono or di(C6-C30)arylamino, SF₅, tri(C1-C30)alkylsilyl, di(C1-C30)alkyl(C6-C30)arylsilyl, tri(C6-C30)arylsilyl, cyano or halogen, and the alkyl, cycloalkyl, alkenyl or aryl of R₂₀₄ through R₂₁₉ may be further substituted by one or more substituent(s) selected from deuterium, (C1-C60)alkyl, (C6-C60)aryl and halogen;
R₂₂₀ through R₂₂₃ independently represent hydrogen, deuterium, (C1-C60)alkyl with or without halogen substituent(s), or (C6-C60)aryl with or without (C1-C60)alkyl substituent(s);
R₂₂₄ and R₂₂₅ independently represent hydrogen, deuterium, (C1-C60)alkyl, (C6-C60)aryl or halogen, or R₂₂₄ and R₂₂₅ are linked via (C3-C12)alkylene or (C3-C12)alkenylene with or without a fused ring to form an alicyclic ring, or a monocyclic or polycyclic aromatic ring, and the alkyl or aryl of R₂₂₄ and R₂₂₅, or the alicyclic ring, or the monocyclic or polycyclic aromatic ring formed therefrom by linkage via (C3-C12)alkylene or (C3-C12)alkenylene with or without a fused ring may be further substituted by one or more substituent(s) selected from (C1-C60)alkyl with or without halogen substituent(s), (C1-C30)alkyloxy, deuterium, halogen, tri(C1-C30)alkylsilyl, tri(C6-C30)arylsilyl and (C6-C60)aryl;
R₂₂₆ represents (C1-C60)alkyl, (C6-C60) aryl, (C5-C60)heteroaryl or halogen;
R₂₂₇ through R₂₂₉ independently represent hydrogen, deuterium, (C1-C60)alkyl, (C6-C60)aryl or halogen, and the alkyl or aryl of R₂₂₆ through R₂₂₉ may be further substituted by halogen or (C1-C60)alkyl substituent(s); and
Q represents 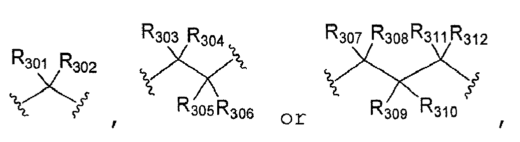 wherein R₃₀₁ through R₃₁₂ independently represent hydrogen, deuterium, (C1-C60)alkyl with or without halogen substituent(s), (C1-C30)alkyloxy, halogen, (C6-C60)aryl, cyano or (C5-C60)cycloalkyl, or each of R₃₀₁ through R₃₁₂ may be linked to an adjacent substituent via alkylene or alkenylene to form a (C5-C7)spiro ring or a (C5-C9) fused ring, or linked to R₂₀₇ or R₂₀₈ via alkylene or alkenylene to form a (C5-C7)fused ring.

The dopant compounds represented by one of Chemical Formulas (3) to (6) can be exemplified by the following compounds, without restriction.

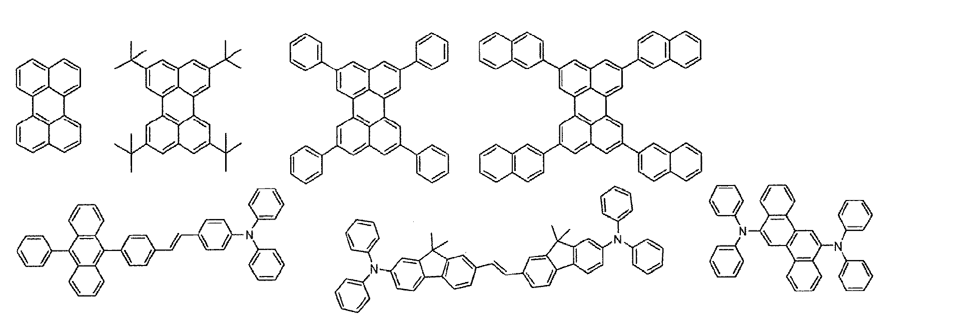

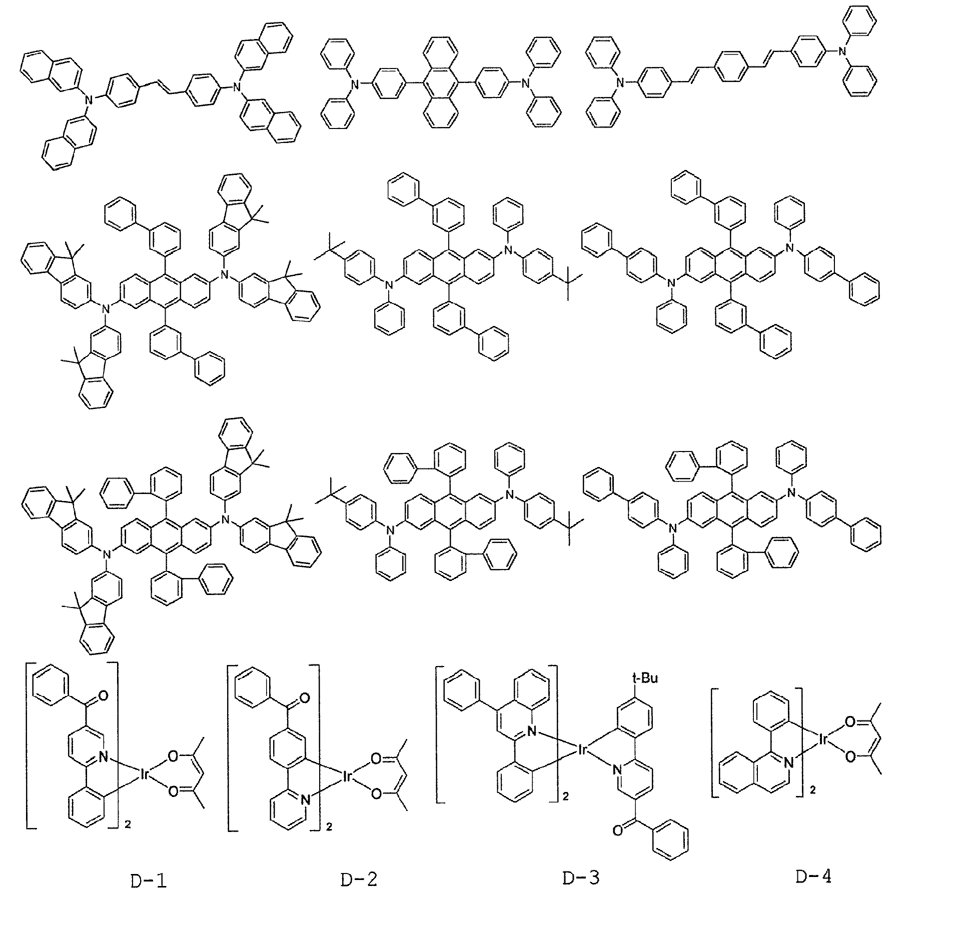

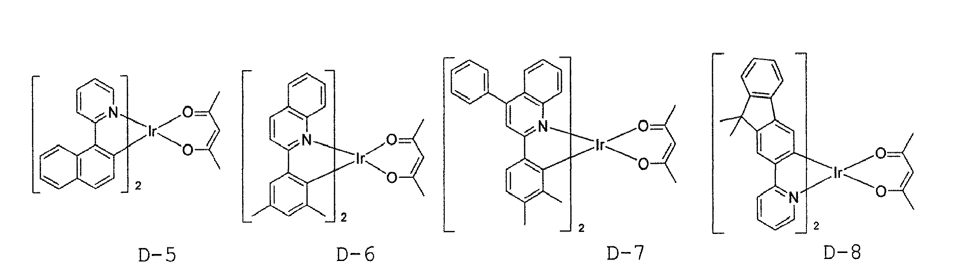

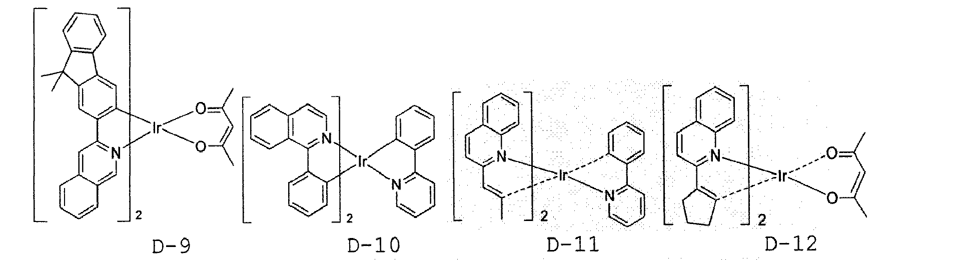

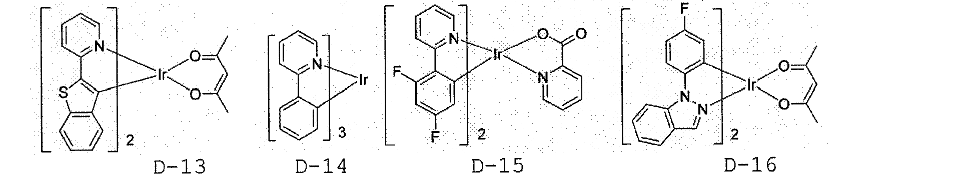

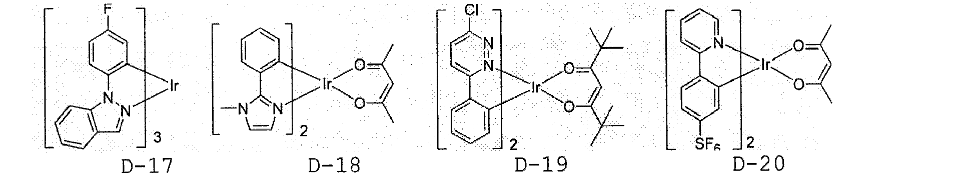

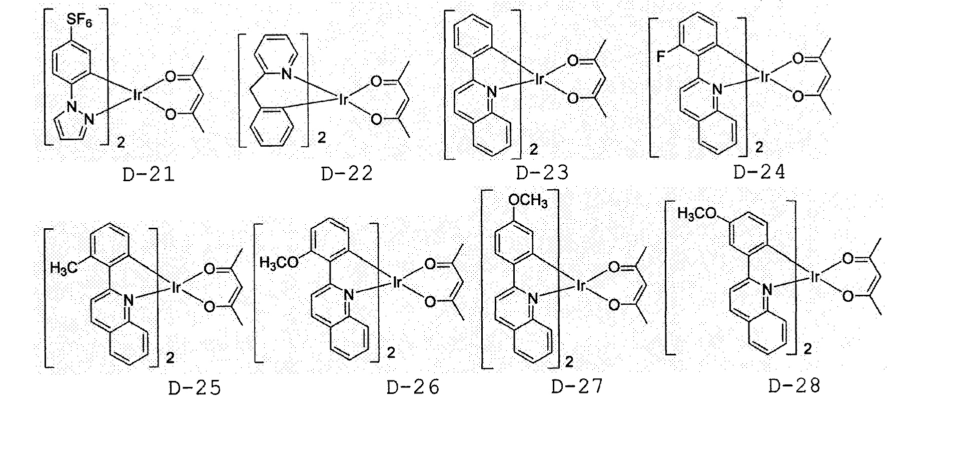

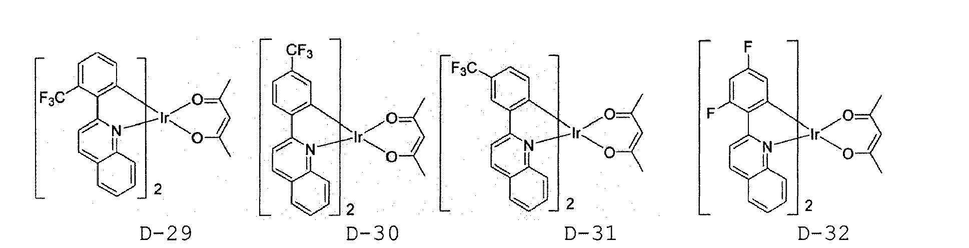

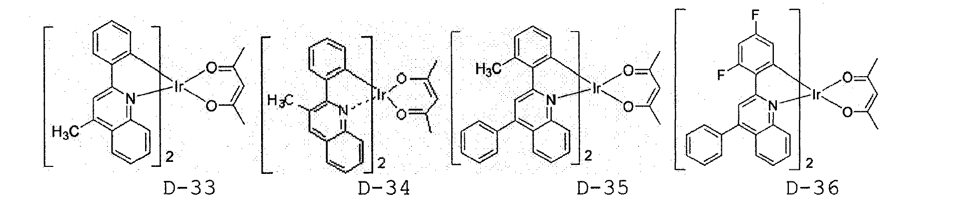

The host compound to be applied to the organic electroluminescent device according to the present invention can be selected from those represented by Chemical Formula (7) or (8):

Chemical Formula 7 (Ar₃₁)_{g}-L₂₁-(Ar₃₂)ₕ

Chemical Formula 8 (Ar₃₃)ᵢ-L₂₂-(Ar₃₄)ⱼ

wherein, L₂₁ represents (C6-C60)arylene or (C4-C60)heteroarylene;
L₂₂ represents anthracenylene;
Ar₃₁ through Ar₃₄ are independently selected from hydrogen, deuterium, (C1-C60)alkyl, (C1-C60)alkyloxy, halogen, (C4-C60)heteroaryl, (C5-C60)cycloalkyl and (C6-C60)aryl; the cycloalkyl, aryl or heteroaryl of Ar₃₁ through Ar₃₄ may be further substituted by one or more substituent(s) selected from a group consisting of (C6-C60)aryl or (C4-C60)heteroaryl having one or more substituent(s) selected from a group consisting of deuterium, (C1-C60)alkyl with or without halogen substituent(s), (C1-C60)alkyloxy, (C3-C60)cycloalkyl, halogen, cyano, tri(C1-C60)alkylsilyl, di(C1-C60)alkyl(C6-C60)arylsilyl and tri(C6-C60)arylsilyl; (C1-C60)alkyl with or without halogen substituent(s), (C1-C60)alkyloxy, (C3-C60)cycloalkyl, deuterium, halogen, cyano, tri(C1-C60)alkylsilyl, di(C1-C60)alkyl(C6-C60)arylsilyl and tri(C6-C60)arylsilyl; and
g, h, i and j independently represent an integer from 0 to 4.

The host of Chemical Formula (7) or (8) can be exemplified by anthracene derivatives and benz[a]anthracene derivatives represented by one of Chemical Formulas (9) to (11): 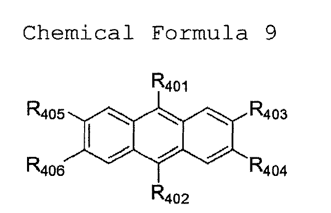 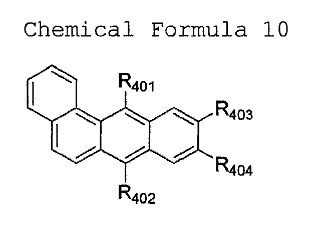 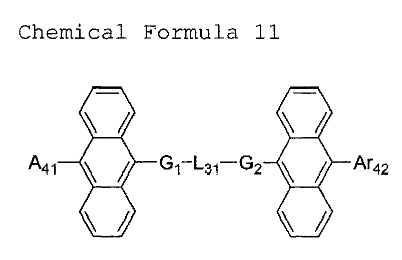 wherein, R₄₀₁ and R₄₀₂ independently represent (C6-C60) aryl, (C4-C60)heteroaryl, 5- or 6-membered heterocycloalkyl containing one or more heteroatom(s) selected from N, O and S, or (C3-C60)cycloalkyl; the aryl or heteroaryl of R₄₀₁ and R₄₀₂ may be further substituted by one or more substituent(s) selected from a group consisting of deuterium, (C1-C60)alkyl, halo(C1-C60)alkyl, (C1-C60)alkyloxy, (C3-C60)cycloalkyl, (C6-C60)aryl, (C4-C60)heteroaryl, halogen, cyano, tri(C1-C60)alkylsilyl, di(C1-C60)alkyl(C6-C60)arylsilyl and tri(C6-C60)arylsilyl;
R₄₀₃ through R₄₀₆ independently represent hydrogen, deuterium, (C1-C60)alkyl, (C1-C60)alkyloxy, halogen, (C4-C60)heteroaryl, (C5-C60)cycloalkyl or (C6-C60)aryl; the heteroaryl, cycloalkyl or aryl of R₄₀₃ through R₄₀₆ may be further substituted by one or more substituent(s) selected from a group consisting of (C1-C60)alkyl with or without halogen substituent(s), (C1-C60)alkyloxy, (C3-C60)cycloalkyl, deuterium, halogen, cyano, tri(C1-C60)alkylsilyl, di(C1-C60)alkyl(C6-C60)arylsilyl and tri(C6-C60)arylsilyl;
G₁ and G₂ independently represent a chemical bond, or (C6-C60)arylene with or without one or more substituent(s) selected from (C1-C60)alkyl, (C1-C60)alkyloxy, (C6-C60)aryl, (C4-C60)heteroaryl and halogen;
Ar₄₁ and Ar₄₂ independently represent aryl or (C4-C60)heteroaryl selected from the following structures; 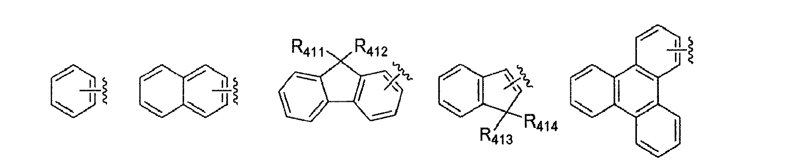 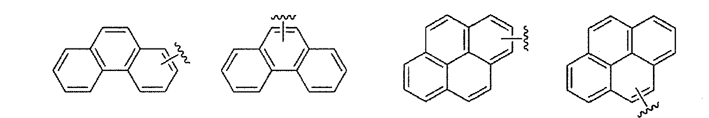 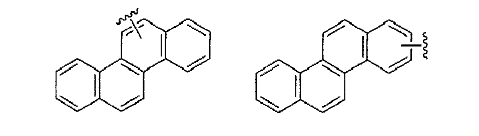 the aryl or heteroaryl of Ar₄₁ and Ar₄₂ may be substituted by one or more substituent(s) selected from (C1-C60)alkyl, (C1-C60)alkyloxy, (C6-C60)aryl and (C4-C60)heteroaryl;
L₃₁ represents (C6-C60)arylene, (C4-C60)heteroarylene or a group having the following structure; 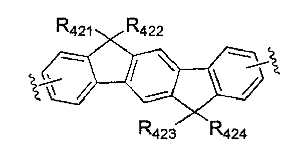 the arylene or heteroarylene of L₃₁ may be substituted by one or more substituent(s) selected from (C1-C60)alkyl, (C1-C60)alkyloxy, (C6-C60)aryl, (C4-C60)heteroaryl and halogen;
R₄₁₁, R₄₁₂, R₄₁₃ and R₄₁₄ independently represent hydrogen, deuterium, (C1-C60)alkyl or (C6-C60)aryl, or each of them may be linked to an adjacent substituent via (C3-C60)alkylene or (C3-C60)alkenylene with or without a fused ring to form an alicyclic ring, or a monocyclic or polycyclic aromatic ring; and
R₄₂₁, R₄₂₂, R₄₂₃ and R₄₂₄ independently represent hydrogen, deuterium, (C1-C60)alkyl, (C1-C60)alkyloxy, (C6-C60)aryl, (C4-C60)heteroaryl or halogen, or each of them may be linked to an adjacent substituent via (C3-C60)alkylene or (C3-C60)alkenylene with or without a fused ring to form an alicyclic ring, or a monocyclic or polycyclic aromatic ring.

The host compounds represented by one of Chemical Formulas (9) to (11) can be exemplified by the following compounds, but they are not restricted thereto.

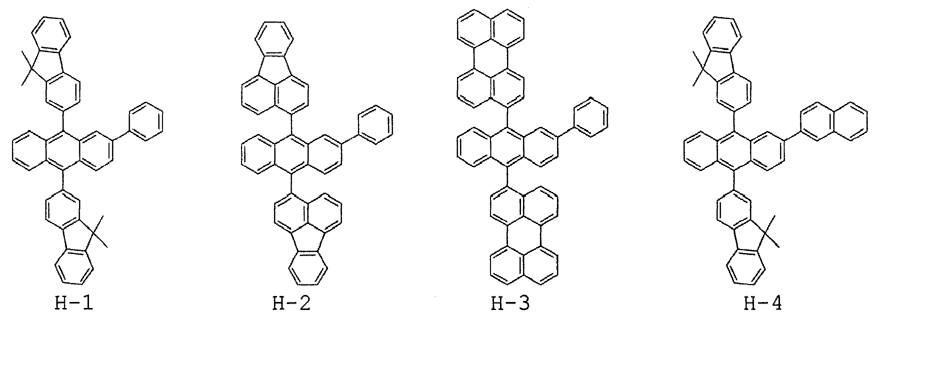

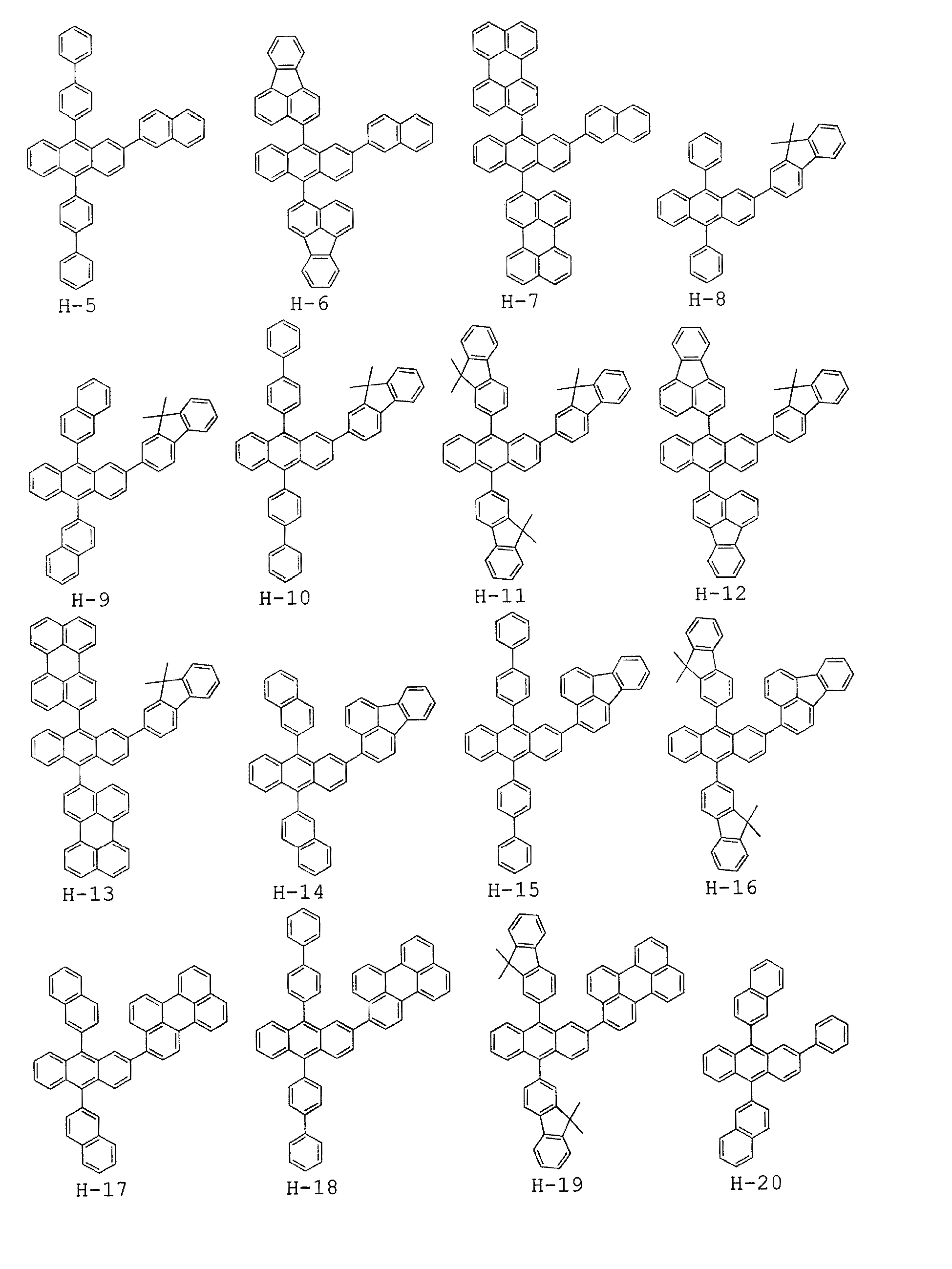

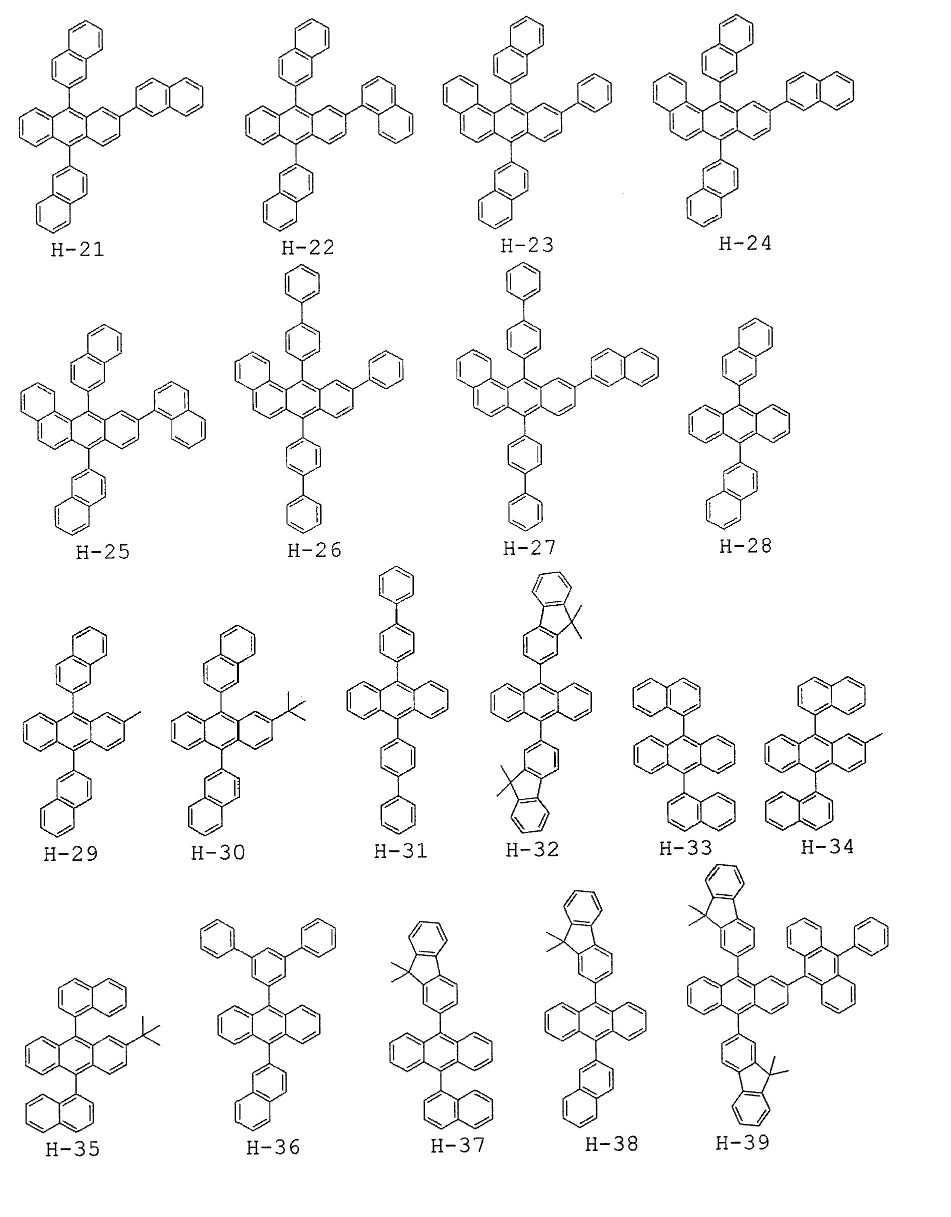

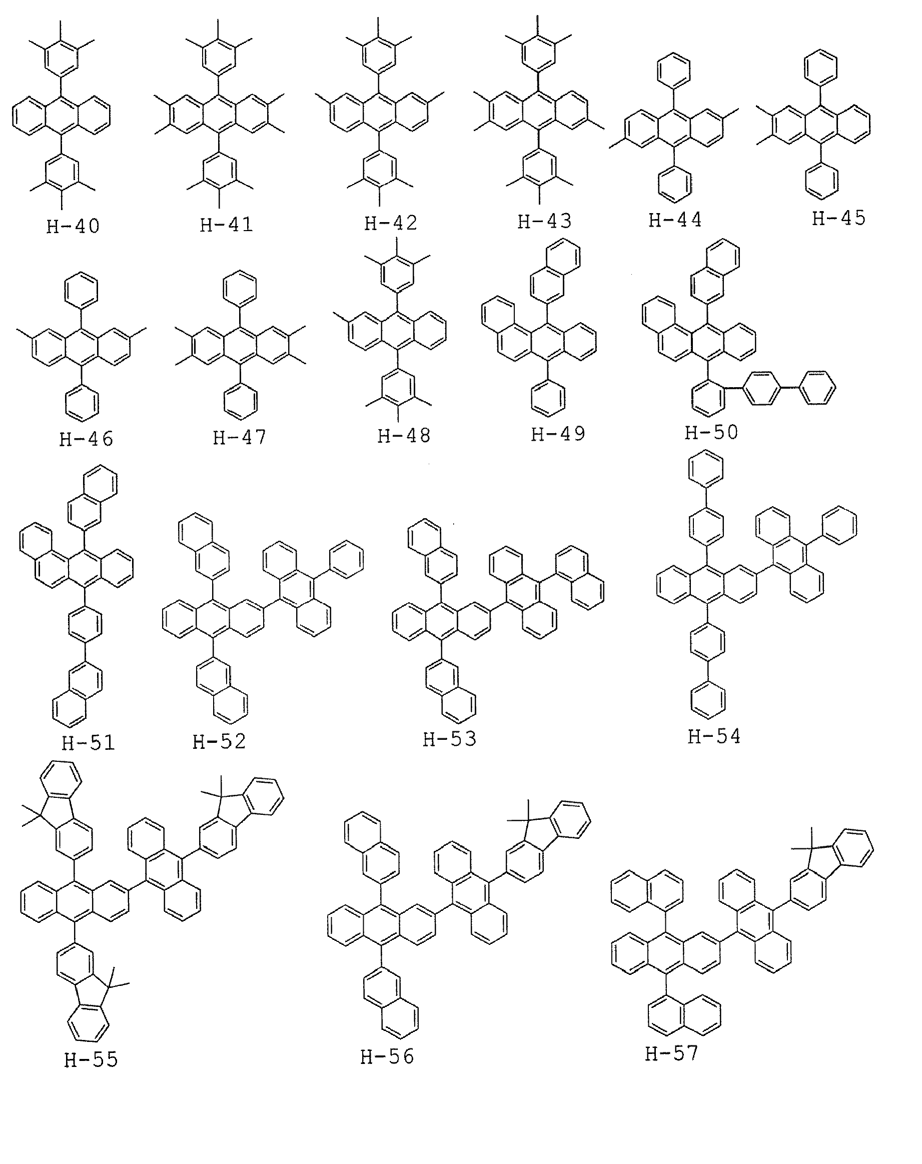

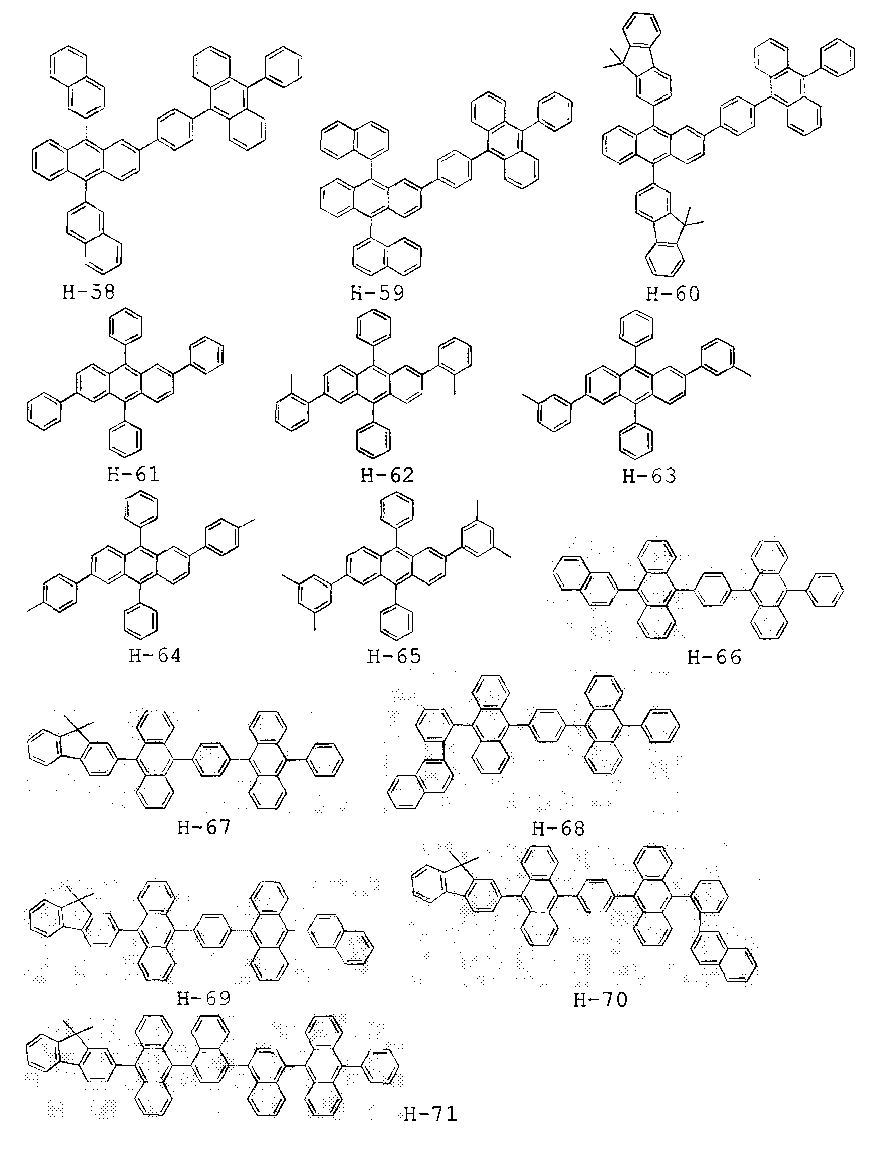

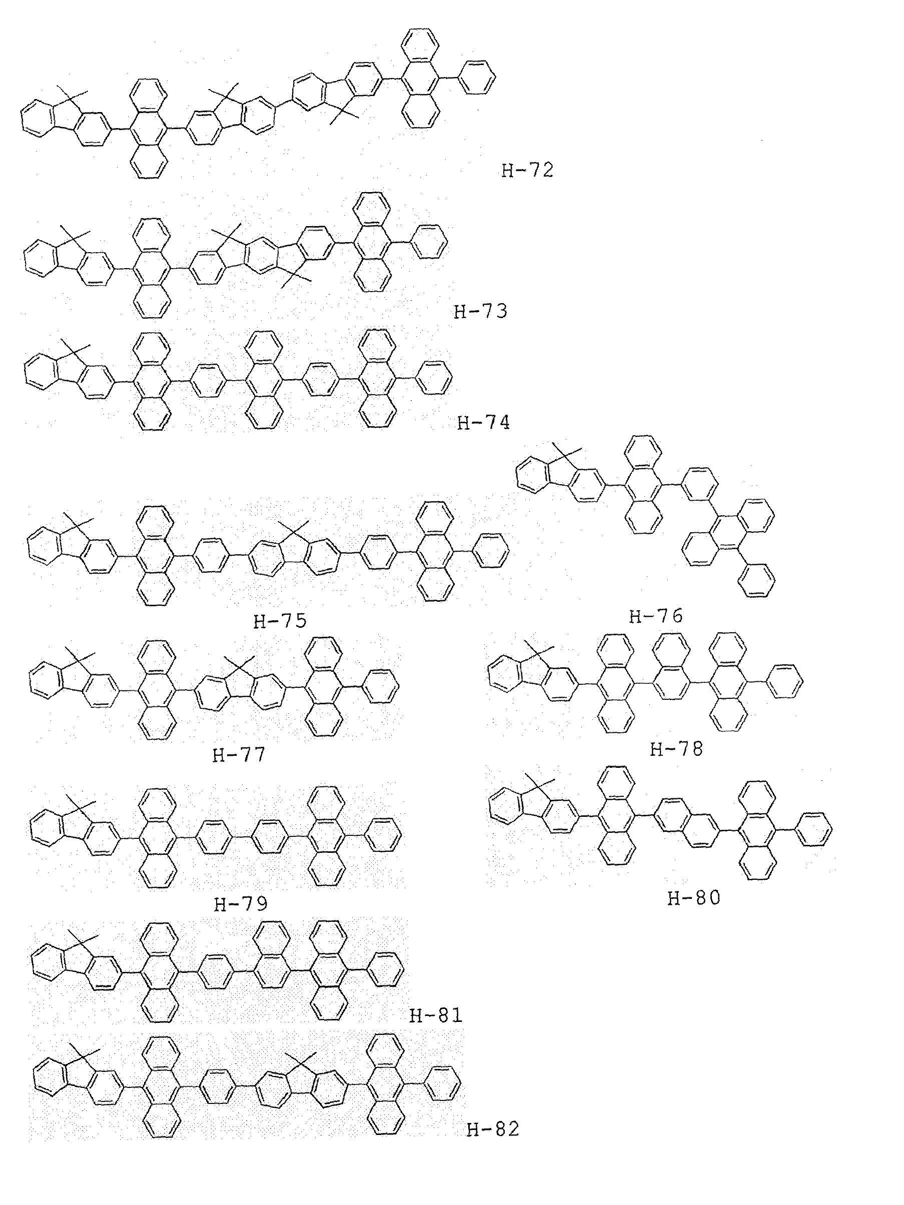

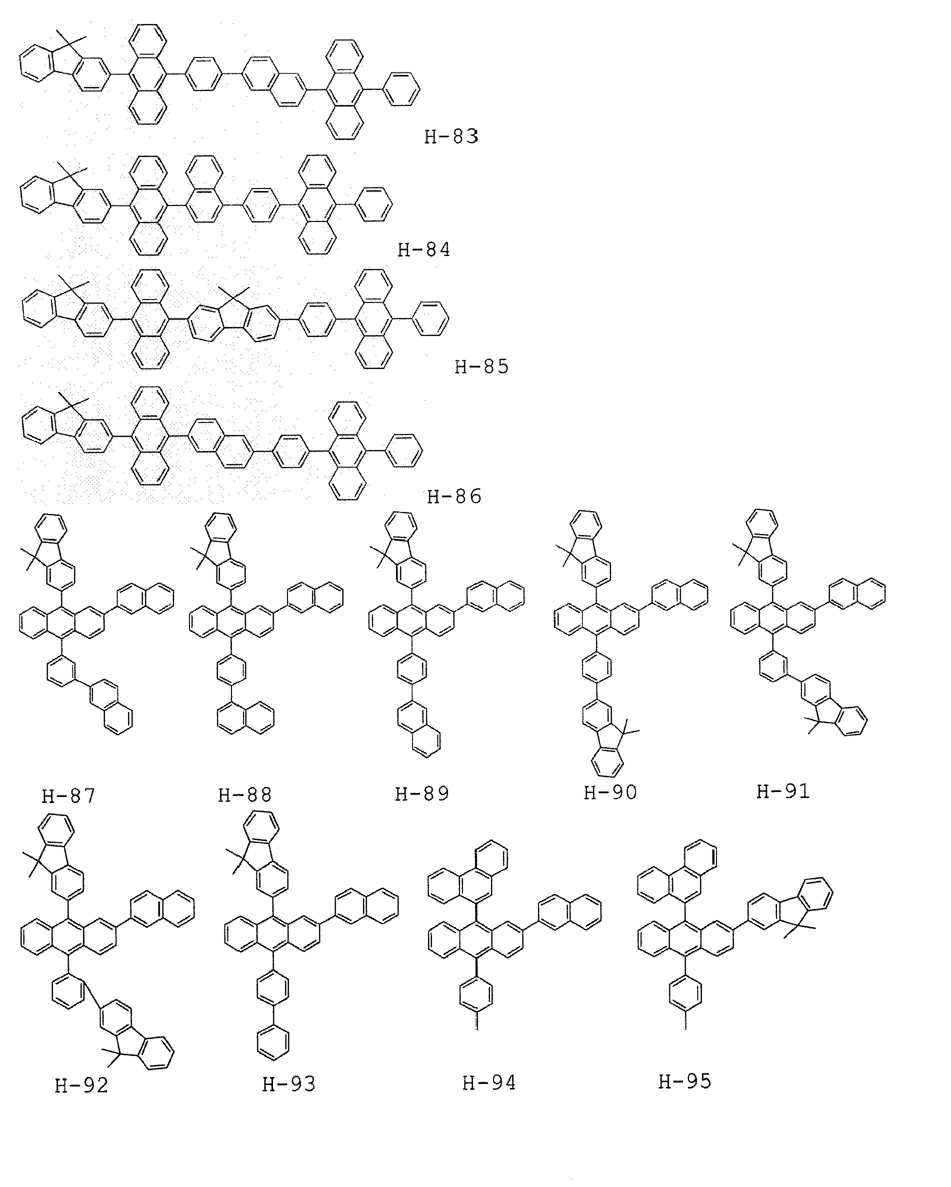

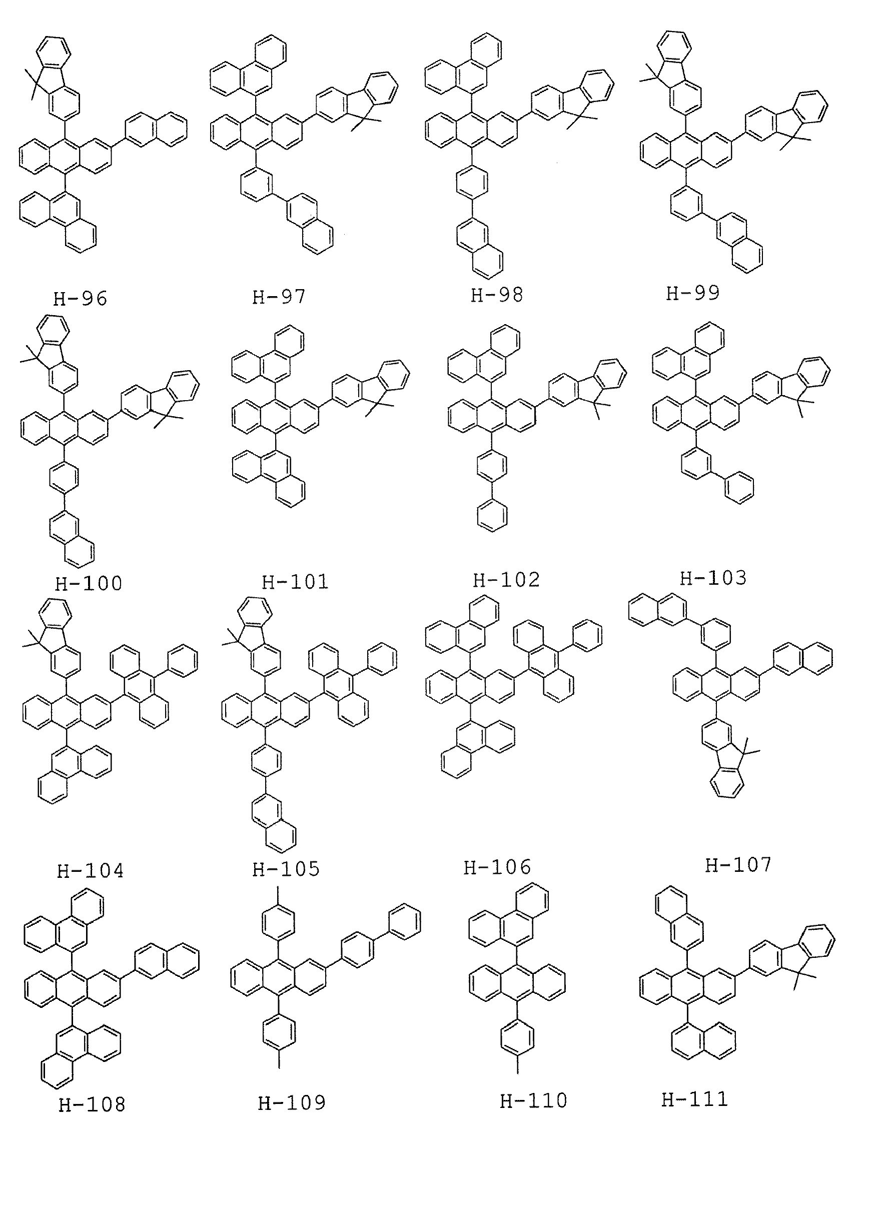

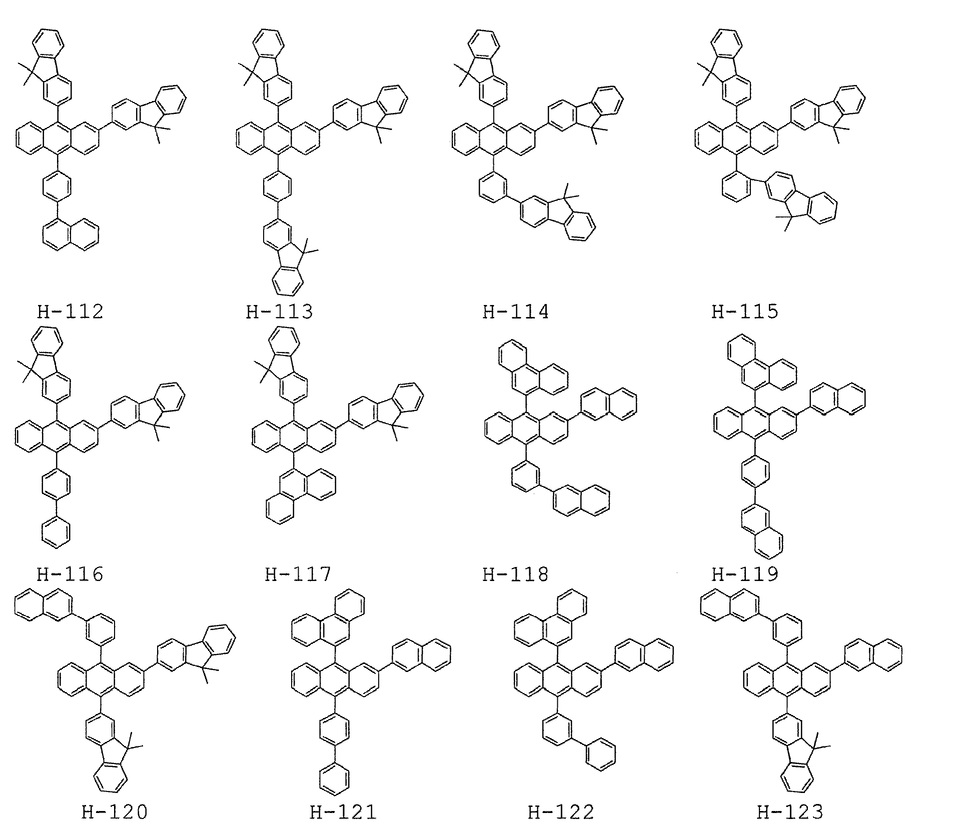

The organic electroluminescent device according to the invention may further comprise one or more compound(s) selected from a group consisting of arylamine compounds and styrylarylamine compounds, in addition to the organic electroluminescent compound represented by Chemical Formula (1). Examples of arylamine or styrylarylamine compounds include the compounds represented by Chemical Formula (12), but they are not restricted thereto: 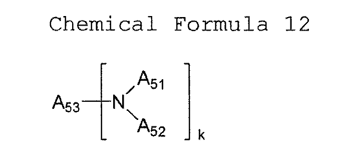 wherein, Ar₅₁ and Ar₅₂ independently represent (C1-C60)alkyl, (C6-C60)aryl, (C4-C60)heteroaryl, (C6-C60)arylamino, (C1-C60)alkylamino, morpholino, thiomorpholino, 5- or 6-membered heterocycloalkyl containing one or more heteroatom(s) selected from N, O and S, or (C3-C60)cycloalkyl, or Ar₅₁ and Ar₅₂ may be linked via (C3-C60)alkylene or (C3-C60)alkenylene with or without a fused ring to form an alicyclic ring, or a monocyclic or polycyclic aromatic ring;
the aryl, heteroaryl, arylamino or heterocycloalkyl of Ar₅₁ and Ar₅₂ may be further substituted by one or more substituent(s) selected from a group consisting of deuterium, halogen, (C1-C60)alkyl, (C2-C60)alkenyl, (C2-C60)alkynyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C1-C60)alkyloxy, (C1-C60)alkylthio, cyano, (C1-C60)alkylamino, (C6-C60)arylamino, (C6-C60)ar(C1-C60)alkyl, (C6-C60)aryloxy, (C6-C60)arylthio, (C6-C60)arylcarbonyl, (C1-C60)alkoxycarbonyl, (C1-C60)alkylcarbonyl, carboxyl, nitro and hydroxyl;

Ar₅₃ represents (C6-C60)aryl, (C5-C60)heteroaryl or (C6-C60)arylamino; the aryl, heteroaryl or arylamino of Ar₅₃ may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(Cl-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkyloxy, (C1-C60)alkylthio, cyano, (C1-C60)alkylamino, (C6-C60)arylamino, (C6-C60)ar(C1-C60)alkyl, (C6-C60)aryloxy, (C6-C60)arylthio, (C6-C60)arylcarbonyl, (C1-C60)alkoxycarbonyl, (C1-C60)alkylcarbonyl, carboxyl, nitro and hydroxyl; and
k is an integer from 1 to 4.

The arylamine compounds and styrylarylamine compounds may be more specifically exemplified by the following compounds, but are not restricted thereto.

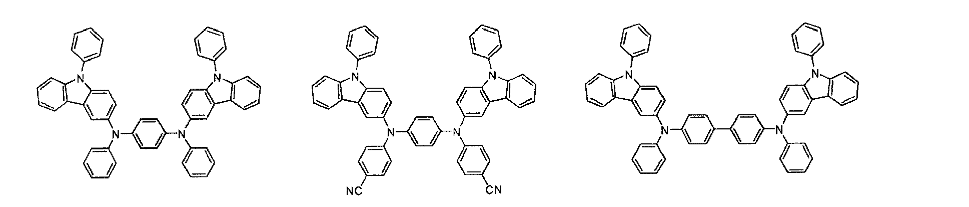

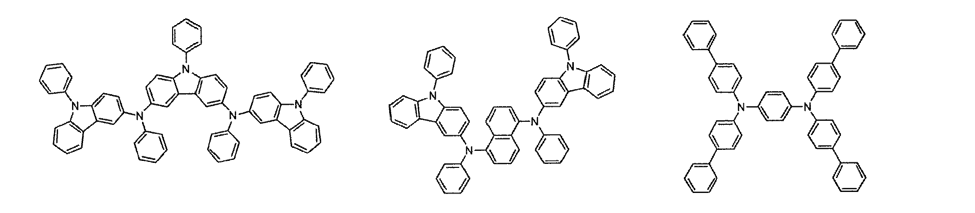

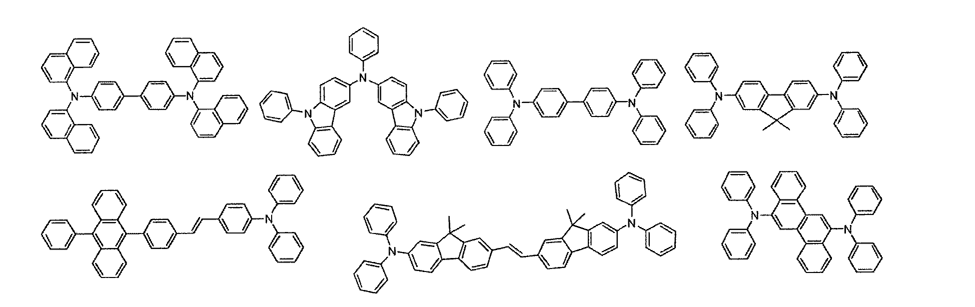

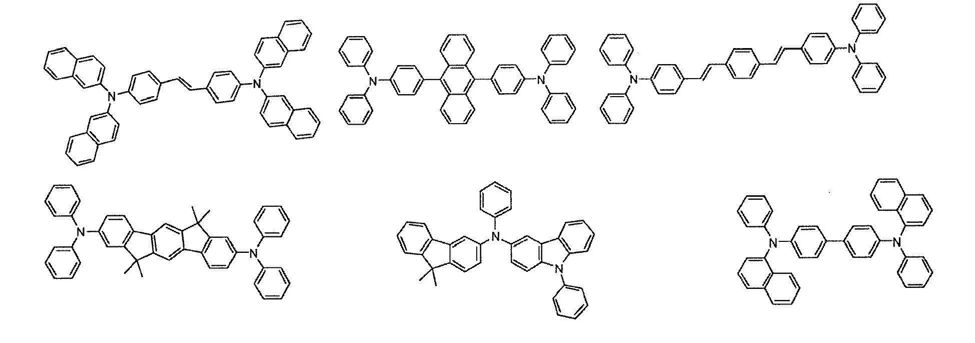

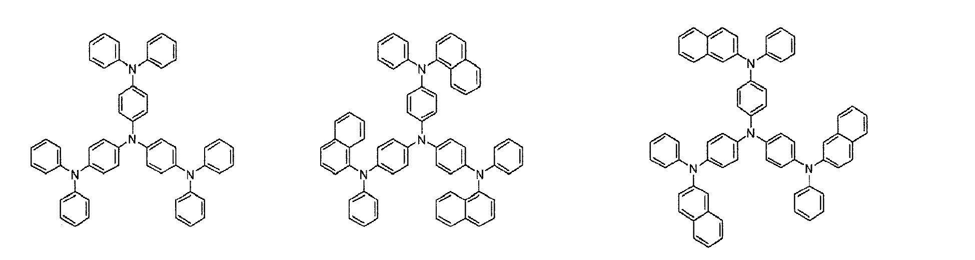

In an organic electroluminescent device according to the present invention, the organic layer may further comprise one or more metal(s) selected from a group consisting of organometals of Group 1, Group 2, 4^{th} period and 5^{th} period transition metals, lanthanide metals and d-transition elements in the Periodic Table of Elements, in addition to the organic electroluminescent compounds represented by Chemical Formula (1). The organic layer may comprise an electroluminescent layer and a charge generating layer.

The present invention can realize an organic electroluminescent device having a pixel structure of independent light-emitting mode, which comprises an organic electroluminescent device containing the organic electroluminescent compound of Chemical Formula (1) as a sub-pixel and one or more sub-pixel (s) comprising one or more metallic compound(s) selected from a group consisting of Ir, Pt, Pd, Rh, Re, Os, Tl, Pb, Bi, In, Sn, Sb, Te, Au and Ag, patterned in parallel at the same time.

In an organic electroluminescent device according to the present invention, it is preferable to place one or more layer(s) (here-in-below, referred to as the "surface layer") selected from chalcogenide layers, metal halide layers and metal oxide layers, on the inner surface of at least one side of the pair of electrodes. Specifically, it is preferable to arrange a chalcogenide layer of silicon and aluminum metal (including oxides) on the anode surface of the EL medium layer, and a metal halide layer or a metal oxide layer on the cathode surface of the EL medium layer. As the result, stability in operation can be obtained.

Examples of chalcogenides preferably include SiOₓ (1≤X≤2), AlOₓ (1≤X≤1.5), SiON, SiAlON, or the like. Examples of metal halides preferably include LiF, MgF₂, CaF₂, fluorides of rare earth metal, or the like. Examples of metal oxides preferably include Cs₂O, Li₂O, MgO, SrO, BaO, CaO, or the like.

In an organic electroluminescent device according to the present invention, it is also preferable to arrange, on at least one surface of the pair of electrodes thus manufactured, a mixed region of electron transport compound and a reductive dopant, or a mixed region of a hole transport compound with an oxidative dopant. Accordingly, the electron transport compound is reduced to an anion, so that injection and transportation of electrons from the mixed region to an EL medium are facilitated. In addition, since the hole transport compound is oxidized to form a cation, injection and transportation of holes from the mixed region to an EL medium are facilitated. Preferable oxidative dopants include various Lewis acids and acceptor compounds. Preferable reductive dopants include alkali metals, alkali metal compounds, alkaline earth metals, rare-earth metals, and mixtures thereof.

The organic electroluminescent compounds according to the invention exhibit high luminous efficiency and excellent color purity and life property of material, so that OLED's having very good operation life can be manufactured therefrom.

### Best Mode

The present invention is further described by referring to representative compounds with regard to the organic electroluminescent compounds according to the invention, preparation thereof and electroluminescent properties of the devices manufactured therefrom, but those examples are provided for illustration of the embodiments only, not being intended to limit the scope of the invention by any means.

### Preparation Examples

### [Preparation Example 1] Preparation of Compound (7)

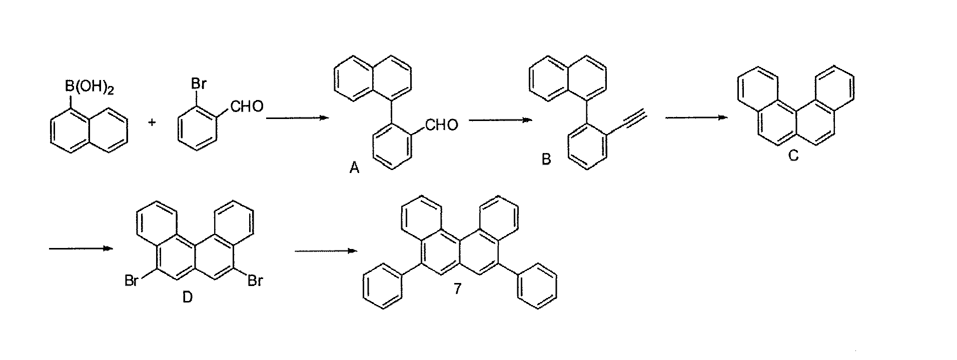

### Preparation of Compound (A)

A reaction vessel was charged with 2-bromobenzaldehyde (20.0 g, 108.09 mmol), 1-naphthaleneboronic acid (22.31 g, 129.72 mmol), tetrakis (triphenylphosphine) palladium (0) (6.24 g, 5.4 mmol) and calcium carbonate (60.27 g, 432.36 mmol). After adding toluene solvent (1000 mL), the mixture was stirred. Then, ethanol (300 mL) and water (200 mL) were sequentially added thereto, and the resultant mixture was stirred under reflux at 120°C for 15 hours. When the reaction was completed, the reaction mixture was cooled to room temperature, and extracted with ethyl acetate (500 mL). The organic extract was washed with brine, and dried over anhydrous magnesium sulfate. After filtering through silica, the filtrate was evaporated to remove the organic solvent. The residual liquid was recrystallized from dichloromethane (100 mL) and n-hexane (500 mL) to obtain Compound (A) (15.06 g, 60%).

### Preparation of Compound (B)

In a reaction vessel, n-butyllithium (31 mL, 77.49 mmol) was slowly added dropwise to diisopropylamine (11.83 mL, 83.95 mmol) at 0°C. Then, the reaction mixture was chilled to -78°C, and trimethylsilyldiazomethane (12.33 mL, 77.49 mmol) was added dropwise over 30 minutes. After stirring for 30 minutes, Compound (A) (15.0 g, 64.58 mmol) diluted with THF (50 mL) was slowly added dropwise thereto. After 3 hours, water was added to quench the reaction, and the mixture was extracted with ethyl acetate (200 mL). The organic extract thus obtained was purified via column chromatography by using ethyl acetate/n-hexane = 1/10 to obtain Compound (B) (10.5 g, 71%).

### Preparation of Compound (C)

A reaction vessel was charged with Compound (B) (10.0 g, 43.80 mmol), platinum dichloride (PtCl₂) (582 mg, 2.19 mmol) and toluene solvent (200 mL), and the mixture was stirred under reflux at 80°C for 24 hours. When the reaction was completed, water was added to quench the reaction. The mixture was then extracted with dichloromethane (300 mL) to separate the organic layer. The organic layer obtained was dried over anhydrous magnesium sulfate, and filtered through silica. After evaporation under reduced pressure, the residue was purified via column chromatography by using dichloromethane and n-hexane (1/10) to obtain Compound (C) (9.4 g, 94%).

### Preparation of Compound (D)

Compound (C) (9.0 g, 39.42 mmol) was dissolved in chloroform solvent (300 mL), and bromine (4.45 mL, 86.72 mmol) was slowly added dropwise to the solution. After 5 hours, the reaction was quenched by adding water, and the mixture was extracted with dichloromethane. The organic layer wad dried over anhydrous magnesium sulfate, and filtered through silica. The organic solvent was removed by distillation under reduced pressure, and the residue was recrystallized from dichloromethane (100 mL) and methanol (300 mL) to obtain Compound (D) (12.94 g, 85%).

### Preparation of Compound (7)

Compound (D) (2.0 g, 4.13 mmol), phenylboronic acid (1.3 g, 10.33 mmol) and Pd(PPh₃)₄ (0.6 g, 0.41 mmol) were dissolved in toluene (100 mL) and ethanol (50 mL). After adding aqueous 2 M sodium carbonate solution (50 mL) thereto, the mixture was stirred under reflux at 120°C for 4 hours. Then, the reaction mixture was cooled to 25°C, and the reaction was quenched by adding distilled water (200 mL). The mixture was extracted with ethyl acetate (150 mL), and evaporated under reduced pressure. Purification via column chromatography gave the target compound (Compound 7) (1.6 g, 3.33 mmol).

### [Preparation Example 2] Preparation of Compound (147)

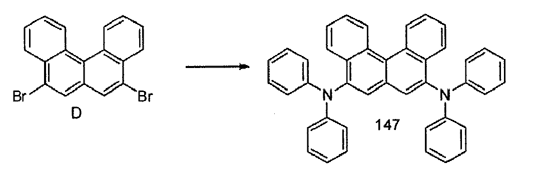

### Preparation of Compound (147)

Under nitrogen atmosphere, a reaction vessel was charged with Compound (D) (10.0 g, 25.9 mmol), diphenylamine (10.96 g, 64.75 mmol), palladium acetate (II) (290 mg, 1.29 mmol), tri-tert-butylphosphine (0.64 mL, 2.59 mmol) and sodium tert-butoxide (7.47 g, 77.7 mmol), and toluene solvent (200 mL) was added thereto. The mixture was stirred under reflux at 120°C for 3 hours. When the reaction was completed, the reaction was quenched by adding water, and the mixture was extracted with dichloromethane (300 mL). The organic layer obtained was dried over anhydrous magnesium sulfate, and filtered through silica. The organic layer was evaporated under reduced pressure, and the residue was recrystallized from dichloromethane (100 mL) and methanol (300 mL) to obtain Compound (147) (9.0 g, 62%).

Organic electroluminescent compounds (Compounds 1 to 532) were prepared according to the same procedure as in Preparation Examples 1 and 2, and the ¹H NMR and MS/FAB data of the compounds prepared are listed in Table 1.

**Table 1**

| compound | ¹H NMR(CDCl₃, 200 MHz) | MS/FAB | |
|---|---|---|---|
| | | found | calculated |
| **1** | δ = 2.89(6H, s), 7.71(2H, m), 7.82∼7.88(4H, m), 8.12(2H, m), 8.93(2H, m) | 256.34 | 256.13 |
| **2** | δ = 1.48(18H, s), 7.82∼7.88(4H, m), 7.94(2H, m), 8.12(2H, m), 8.93(2H, m) | 340.50 | 340.22 |
| **7** | δ = 7.41(2H, m), 7.51(4H, m), 7.79∼7.88(8H, m), 8.12∼8.13(4H, m), 8.93(2H, m) | 380.48 | 380.16 |
| **8** | δ = 7.58∼7.59(6H, m), 7.73(2H, m), 7.82∼7.92(6H, m), 8(4H, m), 8.12∼8.13(4H, m), 8.93(2H, m) | 480.60 | 480.19 |
| **9** | δ = 7.55(4H, m), 7.61(2H, m), 7.82∼7.88(4H, m), 8.04∼8.13(8H, m), 8.42(2H, m), 8.55(2H, m), 8.93(2H, m) | 480.60 | 480.19 |
| **10** | δ = 1.72(12H, s), 7.28(2H, m), 7.38(2H, m), 7.55(2H, m), 7.63(2H, m), 7.77∼7.93(10H, m), 8.12∼8.13(4H, m), 8.93(2H, m) | 612.80 | 612.28 |
| **17** | δ = 7.82∼7.93(14H, m), 8.12∼8.13(8H, m), 8.93(6H, m) | 580.71 | 580.22 |
| **27** | δ = 1.35(18H, s), 7.37∼7.38(8H, m), 7.82∼7.88(4H, m), 8.12∼8.13(4H, m), 8.93(2H, m) | 492.69 | 492.28 |
| **31** | δ = 7.5∼7.56(6H, m), 7.82∼7.88(6H, m), 7.94∼7.98(4H, m), 8.12∼8.13(4H, m), 8.45(2H, m), 8.93(2H, m) | 592.77 | 592.13 |
| **41** | δ = 7.25∼7.33(6H, m), 7.5(2H, m), 7.63(2H, m), 7.8∼7.94(8H, m), 8.1∼8.12(4H, m), 8.55(2H, m), 8.9∼8.93(2H, m) | 558.67 | 558.21 |
| **75** | δ = 7.57(2H, m), 7.82∼7.88(4H, m), 8.12∼8.13(4H, m), 8.42(2H, m), 8.7(2H, m), 8.93(2H, m), 9.24(2H, m) | 382.46 | 382.15 |
| **117** | δ = 2.88(8H, m), 6.58∼6.63(6H, m), 6.76∼6.84(8H, m), 7.02∼7.1(6H, m), 7.2(4H, m), 7.82∼7.88(4H, m), 8.12∼8.13(4H, m), 8.93(2H, m) | 766.97 | 766.33 |
| **121** | δ = 7.25(8H, m), 7.58∼7.59(6H, m), 7.73(2H, m), 7.82∼7.92(6H, m), 8(4H, m), 8.12∼8.13(4H, m), 8.93(2H, m) | 632.79 | 632.25 |
| **132** | δ = 1.72(12H, s), 7.25∼7.28(10H, m), 7.38(2H, m), 7.55(2H, m), 7.63(2H, m), 7.77∼7.93(10H, m), 8.12∼8.13(4H, m), 8.93(2H, m) | 764.99 | 764.34 |
| **147** | δ = 6.63(8H, m), 6.81(4H, m), 7.11(2H, m), 7.2(8H, m), 7.82∼7.88(4H, m), 8.12(2H, m), 8.93(2H, m) | 562.70 | 562.24 |
| **148** | δ = 7.11(2H, m), 7.36(4H, m), 7.49∼7.5(8H, m), 7.74∼7.88(20H, m), 8.12(2H, m), 8.93(2H, m) | 762.94 | 762.30 |
| **149** | δ = 6.98(4H, m), 7.11(2H, m), 7.38(4H, m), 7.53∼7.57(12H, m), 7.82∼7.88(4H, m), 8.02∼8.12(10H, m), 8.93(2H, m) | 762.94 | 762.30 |
| **152** | δ = 1.72(24H, s), 6.48(2H, m), 6.58(2H, m), 6.75(2H, m), 7.04(2H, m), 7.11(2H, m), 7.28∼7.3(6H, m), 7.38(4H, m), 7.55(4H, m), 7.62(2H, m), 7.82∼7.88(8H, m), 8.12(2H, m), 8.93(2H, m) | 1027.34 | 1026.49 |
| **155** | δ = 6.63(4H, m), 6.81(2H, m), 6.98(2H, m), 7.11(2H, m), 7.2(4H, m), 7.38(2H, m), 7.53∼7.57(6H, m), 7.82∼7.88(4H, m), 8.02∼8.12(6H, m), 8.93(2H, m) | 662.82 | 662.27 |
| **156** | δ = 6.63(4H, m), 6.81(2H, m), 7.11(2H, m), 7.2(4H, m), 7.36(2H, m), 7.49∼7.5(4H, m), 7.74∼7.88(12H, m), 8.12(2H, m), 8.93(2H, m) | 662.82 | 662.27 |
| **160** | δ = 1.35(18H, s), 6.55(4H, m), 6.63(4H, m), 6.81(2H, m), 7.01(4H, m), 7.11(2H, m), 7.2(4H, m), 7.82∼7.88(4H, m), 8.12(2H, m), 8.93(2H, m) | 674.91 | 674.37 |
| **162** | δ = 6.63(8H, m), 6.69(4H, m), 6.81(4H, m), 7.2(8H, m), 7.54(4H, m), 7.82∼7.88(4H, m), 8.12∼8.13(4H, m), 8.93(2H, m) | 714.89 | 714.30 |
| **164** | δ = 6.63(8H, m), 6.81(4H, m), 7.2(8H, m), 7.46∼7.49(4H, m), 7.64∼7.74(6H, m), 7.82∼7.88(6H, m), 8.12∼8.13(4H, m), 8.93(2H, m) | 815.01 | 814.33 |
| **165** | δ = 1.72(12H, s), 6.58∼6.63(10H, m), 6.75∼6.81(6H, m), 7.2(8H, m), 7.62∼7.63(4H, m), 7.77∼7.93(8H, m), 8.12∼8.13(4H, m), 8.93(2H, m) | 947.21 | 946.43 |
| **168** | δ = 6.69(4H, m), 7.36(4H, m), 7.49∼7.54(12H, m), 7.74∼7.88(20H, m), 8.12∼8.13(4H, m), 8.93(2H, m) | 915.13 | 914.37 |
| **173** | δ = 2.34(12H, s), 6.36(4H, m), 6.63(4H, m), 6.71(2H, m), 6.81(2H, m), 7.2(4H, m), 7.46∼7.49(4H, m), 7.64∼7.74(6H, m), 7.82∼7.88(6H, m), 8.12∼8.13(4H, m), 8.93(2H, m) | 871.12 | 870.40 |
| **177** | δ = 6.63(4H, m), 6.69(4H, m), 6.81(2H, m), 7.2(4H, m), 7.36(2H, m), 7.49∼7.54(8H, m), 7.74∼7.88(12H, m), 8.12∼8.13(4H, m), 8.93(2H, m) | 815.01 | 814.33 |
| **184** | δ = 1.72(12H, s), 6.48(2H, m), 6.63(4H, m), 6.69(4H, m), 6.81(2H, m), 7.04(2H, m), 7.2(4H, m), 7.28∼7.3(4H, m), 7.38(2H, m), 7.54∼7.55(6H, m), 7.82∼7.88(6H, m), 8.12∼8.13(4H, m), 8.93(2H, m) | 947.21 | 946.43 |
| **187** | δ = 1.72(12H, s), 6.58∼6.63(6H, m), 6.75∼6.81(4H, m), 7.2(4H, m), 7.36(2H, m), 7.49∼7.5(4H, m), 7.62∼7.63(4H, m), 7.74∼7.93(16H, m), 8.12∼8.13(4H, m), 8.93(2H, m) | 1047.33 | 1046.46 |
| **192** | δ = 7.25∼7.33(6H, m), 7.5(2H, m), 7.63∼7.68(6H, m), 7.79∼7.88(8H, m), 7.94(2H, m), 8.12∼8.13(6H, m), 8.55(2H, m), 8.93(2H, m) | 710.86 | 71.0.27 |
| **201** | δ = 7.25∼7.33(6H, m), 7.5∼7.55(6H, m), 7.63∼7.66(4H, m), 7.82∼7.88(4H, m), 7.94∼7.95(4H, m), 8.08∼8.13(8H, m), 8.55(4H, m), 8.93(2H, m) | 810.98 | 810.30 |
| **212** | δ = 7.39∼7.41(10H, m), 7.51∼7.52(8H, m), 7.82∼7.91(12H, m), 8.12∼8.13(4H, m), 8.93(2H, m) | 732.91 | 732.28 |
| **222** | δ = 7.39∼7.41(9H, m), 7.51∼7.52(4H, m), 7.58∼7.59(3H, m), 7.73(1H, m), 7.82∼7.93(14H, m), 8(2H, m), 8.12(2H, m), 8.34(1H, m), 8.93(2H, m) | 782.97 | 782.30 |
| **230** | δ = 7.41(1H, m), 7.51∼7.55(4H, m), 7.61(1H, m), 7.79∼7.93(7H, m), 8.04∼8.12(4H, m), 8.34(1H, m), 8.42(1H, m), 8.55(1H, m), 8.93(2H, m) | 430.54 | 430.17 |
| **243** | δ = 7.41(1H, m), 7.48∼7.61(8H, m), 7.7(1H, m), 7.79∼7.93(7H, m), 8.04∼8.12(4H, m), 8.34(1H, m), 8.42(1H, m), 8.55(1H, m), 8.93(2H, m) | 506.63 | 506.20 |
| **258** | δ = 7.36∼7.42(4H, m), 7.48∼7.51(3H, m), 7.74∼7.93(12H, m), 8.03∼8.12(5H, m), 8.34(1H, m), 8.93(2H, m) | 562.64 | 562.19 |
| **261** | δ = 7.35(1H, m), 7.41(1H, m), 7.51(2H, m), 7.6(1H, m), 7.78∼7.88(7H, m), 7.98(1H, m), 8.06∼8.12(4H, m), 8.34(1H, m), 8.44(1H, m), 8.93(2H, m) | 431.53 | 431.17 |
| **276** | δ = 6.63(2H, m), 6.81(2H, m), 6.99∼7.05(4H, m), 7.25(2H, m), 7.32(1H, m), 7.41(1H, m), 7.51(2H, m), 7.79∼7.93(7H, m), 8.12(2H, m), 8.93(2H, m) | 495.61 | 495.20 |
| **280** | δ = 1.72(6H, s), 7.28(1H, m), 7.38(1H, m), 7.55(3H, m), 7.61∼7.63(2H, m), 7.77∼7.93(8H, m), 8.04∼8.12(4H, m), 8.34(1H, m), 8.42(1H, m), 8.55(1H, m), 8.93(2H, m) | 546.70 | 546.23 |
| **288** | δ = 7.25(4H, m), 7.55∼7.61(6H, m), 7.73(1H, m), 7.82∼7.93(6H, m), 8∼8.12(6H, m), 8.34(1H, m), 8.42(1H, m), 8.55(1H, m), 8.93(2H, m) | 556.69 | 556.22 |
| **300** | δ = 7.5∼7.61(6H, m), 7.82∼7.94(12H, m), 8.34(1H, m), 8.42∼8.45(2H, m), 8.55(1H, m), 8.93(2H, m) | 536.68 | 536.16 |
| **310** | δ = 7.41(1H, m), 7.51∼7.61(7H, m), 7.79∼7.93(7H, m), 8∼8.12(6H, m), 8.34(1H, m), 8.4∼8.42(3H, m), 8.55(1H, m), 8.93(2H, m) | 556.69 | 556.22 |
| **318** | δ = 7.25∼7.33(3H, m), 7.5∼7.55(3H, m), 7.61∼7.63(2H, m), 7.8∼7.94(6H, m), 8.04∼8.12(6H, m), 8.42(1H, m), 8.55(2H, m), 8.9∼8.93(2H, m) | 519.63 | 519.20 |
| **328** | δ = 1.72(6H, s), 7.28(1H, m), 7.38(1H, m), 7.55∼7.63(5H, m), 7.73∼7.93(10H, m), 8(2H, m), 8.12(2H, m), 8.34(1H, m), 8.93(2H, m) | 546.70 | 546.23 |
| **335** | δ = 7.25(4H, m), 7.58∼7.59(6H, m), 7.73(2H, m), 7.82∼7.93(7H, m), 8(4H, m), 8.12(2H, m), 8.34(1H, m), 8.93(2H, m) | 556.69 | 556.22 |
| **351** | δ = 7.5∼7.52(2H, m), 7.58∼7.59(4H, m), 7.73(1H, m), 7.82∼8(9H, m), 8.12(2H, m), 8.2(1H, m), 8.34(1H, m), 8.41∼8.45(2H, m), 8.93(2H, m) | 536.68 | 536.16 |
| **358** | δ = 7.41(1H, m), 7.51∼7.59(7H, m), 7.73∼7.93(9H, m), 8∼8.01(3H, m), 8.08∼8.12(4H, m), 8.34(1H, m), 8.55(1H, m), 8.93(2H, m) | 556.69 | 556.22 |
| **371** | δ = 1.3(4H, m), 1.45(4H, m), 7.33∼7.35(2H, m), 7.52(1H, m), 7.58∼7.61(4H, m), 7.73(1H, m), 7.82∼8(11H, m), 8.12(2H, m), 8.34(1H, m), 8.93(2H, m) | 588.81 | 588.23 |
| **381** | δ = 6.63(4H, m), 6.81(2H, m), 7.2(4H, m), 7.32(1H, m), 7.55(2H, m), 7.61(1H, m), 7.82∼7.93(5H, m), 8.04∼8.12(4H, m), 8.42(1H, m), 8.55(1H, m), 8.93(2H, m) | 521.65 | 521.21 |
| **390** | δ = 6.63(2H, m), 6.81(1H, m), 6.98(1H, m), 7.2(2H, m), 7.32∼7.41(3H, m), 7.51∼7.57(5H, m), 7.79∼7.93(7H, m), 8.02∼8.12(4H, m), 8.93(2H, m) | 521.65 | 521.21 |
| **395** | δ = 6.63(4H, m), 6.69(2H, m), 6.81(2H, m), 7.2(4H, m), 7.41(1H, m), 7.51∼7.54(4H, m), 7.79∼7.93(7H, m), 8.12(2H, m), 8.34(1H, m), 8.93(2H, m) | 547.69 | 547.23 |
| **403** | δ = 6.63(2H, m), 6.81(1H, m), 7.2(2H, m), 7.32∼7.36(2H, m), 7.49∼7.5(2H, m), 7.58∼7.59(3H, m), 7.73∼7.82(11H, m), 8(2H, m), 8.12(2H, m), 8.93(2H, m) | 571.71 | 571.23 |
| **416** | δ = 1.72(6H, s), 6.48(1H, m), 6.63(2H, m), 6.81(1H, m), 7.04(1H, m), 7.2(2H, m), 7.28∼7.38(4H, m), 7.55(3H, m), 7.61(1H, m), 7.82∼7.93(6H, m), 8.04∼8.12(4H, m), 8.42(1H, m), 8.55(1H, m), 8.93(2H, m) | 637.81 | 637.28 |
| **423** | δ = 1.72(6H, s), 6.58∼6.63(5H, m), 6.75∼6.81(3H, m), 7.2(4H, m), 7.41(1H, m), 7.51(2H, m), 7.62∼7.63(2H, m), 7.77∼7.93(9H, m), 8.12(2H, m), 8.34(1H, m), 8.93(2H, m) | 663.85 | 663.29 |
| **427** | δ = 6.63(4H, m), 6.81(2H, m), 7.2(4H, m), 7.46∼7.55(4H, m), 7.61∼7.74(4H, m), 7.82∼7.93(6H, m), 8.04∼8.12(4H, m), 8.34(1H, m), 8.42(1H, m), 8.55(1H, m), 8.93(2H, m) | 647.80 | 647.26 |
| **444** | δ = 2.34(6H, s), 6.36(2H, m), 6.63(2H, m), 6.71(1H, m), 6.81(1H, m), 7.2(2H, m), 7.41∼7.51(5H, m), 7.64∼7.79(11H, m), 8.12(2H, m), 8.34(1H, m), 8.93(2H, m) | 625.80 | 625.28 |
| **455** | δ = 6.63(2H, m), 6.69(2H, m), 6.81(1H, m), 6.98(1H, m), 7.2(2H, m), 7.38(1H, m), 7.53∼7.61(8H, m), 7.82∼7.93(5H, m), 8.02∼8.12(6H, m), 8.34(1H, m), 8.42(1H, m), 8.55(1H, m), 8.93(2H, m) | 647.80 | 647.26 |
| **466** | δ = 1.35(9H, s), 6.55(2H, m), 6.63(2H, m), 6.69(2H, m), 6.81(1H, m), 7.01(2H, m), 7.2(2H, m), 7.41(1H, m), 7.51∼7.54 (4H, m), 7.79∼7.93(7H, m), 8.12(2H, m), 8.34(1H, m), 8.93(2H, m) | 603.79 | 603.29 |
| **480** | δ = 6.62(2H, m), 6.69∼6.7(4H, m), 7.54∼7.55(6H, m), 7.61(1H, m), 7.82∼7.93(5H, m), 8.04∼8.12(6H, m), 8.34(1H, m), 8.42(1H, m), 8.55(1H, m), 8.93(2H, m) | 599.72 | 599.24 |
| **493** | δ = 1.72(6H, s), 6.58∼6.63(3H, m), 6.69∼6.81(4H, m), 7.2(2H, m), 7.41(2H, m), 7.51∼7.54(8H, m), 7.62∼7.63(2H, m), 7.77∼7.93(9H, m), 8.12(2H, m), 8.34(1H, m), 8.93(2H, m) | 739.94 | 739.32 |
| **508** | δ = 6.59(2H, m), 6.69(2H, m), 6.77(2H, m), 6.89∼6.92(4H, m), 7.54∼7.55(4H, m), 7.61(1H, m), 7.82∼7.93(5H, m), 8.04∼8.12(4H, m), 8.34(1H, m), 8.42(1H, m), 8.55(1H, m), 8.93(2H, m) | 611.73 | 611.22 |
| **515** | δ = 3.81(2H, m), 6.51(2H, m), 6.69(4H, m), 6.98∼7.01(4H, m), 7.54∼7.59(5H, m), 7.73(1H, m), 7.82∼7.93(6H, m), 8(2H, m), 8.12(2H, m), 8.34(1H, m), 8.93(2H, m) | 609.76 | 609.25 |
| **523** | δ = 6.69(2H, m), 6.97(2H, m), 7.16∼7.21(6H, m), 7.41(1H, m), 7.51∼7.54(4H, m), 7.79∼7.93(7H, m), 8.12(2H, m), 8.34(1H, m), 8.93(2H, m) | 577.74 | 577.19 |
| **527** | δ = 6.63(8H, m), 6.69(2H, m), 6.81(4H, m), 7.2(8H, m), 7.32(1H, m), 7.54(2H, m), 7.82∼7.93(5H, m), 8.12(2H, m), 8.93(2H, m) | 638.80 | 638.27 |
| **530** | δ = 6.63(8H, m), 6.81(4H, m), 7.2(8H, m), 7.32(1H, m), 7.46∼7.49(2H, m), 7.64∼7.74(3H, m), 7.82∼7.93(6H, m), 8.12(2H, m), 8.93(2H, m) | 688.86 | 688.29 |
| **532** | δ = 1.72(6H, s), 6.58∼6.63(5H, m), 6.75∼6.81(3H, m), 6.98(2H, m), 7.2(4H, m), 7.32∼7.38(3H, m), 7.53∼7.63(8H, m), 7.77∼7.93(7H, m), 8.02∼8.12(6H, m), 8.93(2H, m) | 855.07 | 854.37 |

### [Example 1] Manufacture of OLED by using organic electroluminescent compound according to the invention

An OLED device was manufactured by using electroluminescent material according to the present invention.

First, a transparent electrode ITO thin film (15 Ω/□) (2) prepared from glass for OLED (1) (manufactured by Samsung-Corning) was subjected to ultrasonic washing with trichloroethylene, acetone, ethanol and distilled water, sequentially, and stored in isopropanol before use.

Then, an ITO substrate was equipped in a substrate folder of a vacuum vapor-deposit device, and 4,4',4"-tris(N,N-(2-naphthyl)-phenylamino)triphenylamine (2-TNATA) (of which the structure is shown below) was placed in a cell of the vacuum vapor-deposit device, which was then ventilated up to 10⁻⁶ torr of vacuum in the chamber. Electric current was applied to the cell to evaporate 2-TNATA, thereby providing vapor-deposit of a hole injecting layer (3) having 60 nm thickness on the ITO substrate.

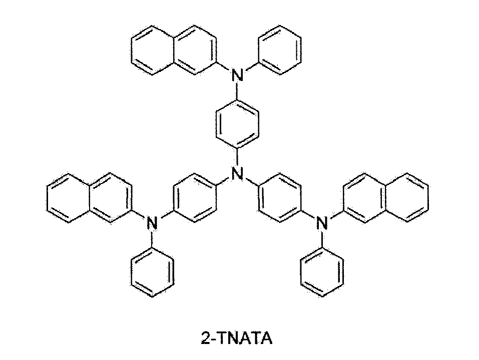

Then, to another cell of the vacuum vapor-deposit device, charged was N,N'-bis(α-naphthyl)-N,N'-diphenyl-4,4'-diamine (NPB) (of which the structure is shown below), and electric current was applied to the cell to evaporate NPB, thereby providing vapor-deposit of a hole transport layer (4) with 20 nm thickness on the hole injecting layer.

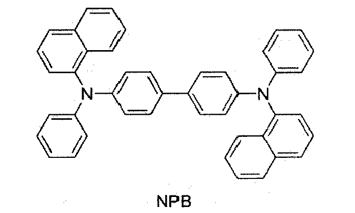

After forming the hole injecting layer and the hole transport layer, an electroluminescent layer was vapor-deposited as follows. To one cell of a vacuum vapor-deposit device, charged was a compound according to the invention (e.g., Compound 17) as electroluminescent material, and DSA-Ph (of which the structure is shown below) was charged to another cell. The two cells were simultaneously heated to carry out vapor-deposition at the vapor-deposition rate of DSA-Ph of 2 to 5% by weight, thereby providing vapor-deposit of an electroluminescent layer (5) with a thickness of 30 nm on the hole transport layer.

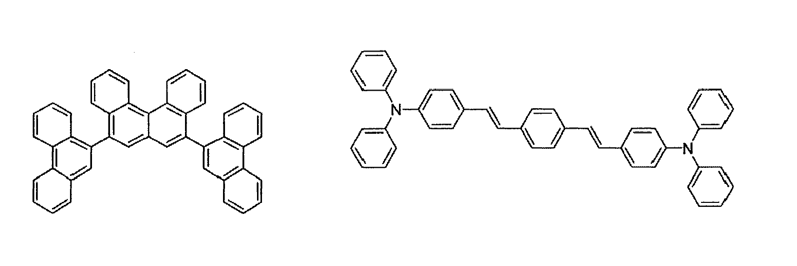

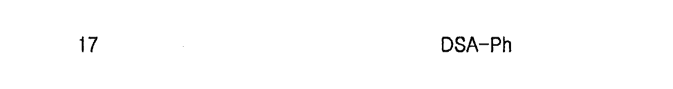

Then, tris(8-hydroxyquinoline)aluminum (III) (Alq) (of which the structure is shown below) was vapor-deposited as an electron transport layer (6) with a thickness of 20 nm, and lithium quinolate (Liq) (of which the structure shown below) was vapor-deposited as an electron injecting layer (7) with a thickness of 1 to 2 nm. Thereafter, an Al cathode (8) was vapor-deposited with a thickness of 150 nm by using another vacuum vapor-deposit device to manufacture an OLED.

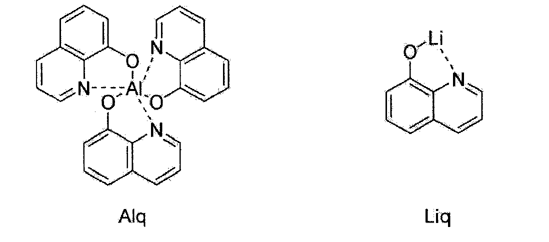

Each material employed for manufacturing an OLED was used as the electroluminescent material after purifying via vacuum sublimation at 10⁻⁶ torr.

### [Comparative Example 1] Manufacture of OLED by using conventional electroluminescent material

After forming a hole injecting layer (3) and a hole transport layer (4) according to the same procedure as described in Example 1, dinaphthylanthracene (DNA) was charged to another cell of said vacuum vapor-deposit device, while DSA-Ph was charged to another cell as was in Example 1. An electroluminescent layer (5) was vapor-deposited with a thickness of 30 nm on the hole transport layer, at the vapor-deposition rate of 100:3.

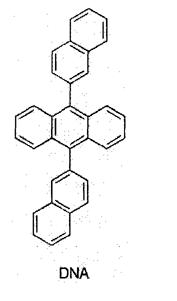

Then, an electron transport layer (6) and an electron injecting layer (7) were vapor-deposited according to the same procedures as in Example 1, and an Al cathode (8) was vapor-deposited with a thickness of 150 nm by using another vacuum vapor-deposit device to manufacture an OLED.

The luminous efficiencies of the OLED's comprising the organic electroluminescent compounds according to the present invention (Example 1) or conventional electroluminescent compound (Comparative Example 1) were measured at 5,000 cd/m², respectively, and the results are shown in Table 2.

**Table 2**

| No. | | Host | Dopant | Doping concentration (wt%) | Luminous efficiency (cd/A) | Color |
|---|---|---|---|---|---|---|
| | | | | | @5000cd/m² | |
| Ex.1 | 1 | **8** | DSA-Ph | 3 | 8.5 | Blue |
| | 2 | **17** | DSA-Ph | 3 | 8.2 | Blue |
| | 3 | **122** | DSA-Ph | 3 | 7.6 | Blue |
| | 4 | **223** | DSA-Ph | 3 | 7.4 | Blue |
| | 5 | **252** | DSA-Ph | 3 | 7.6 | Blue |
| Comp.1 | | DNA | DSA-Ph | 3 | 7.3 | Jade green |

As can be seen from Table 2, the blue electroluminescent devices to which the material of the present invention was applied, when DSA-Ph was commonly doped to the organic electroluminescent compound according to the invention, showed comparable luminous efficiency, but far better color purity than the device employing DNA as conventional electroluminescent material (Comparative Example 1).

### [Example 2] Manufacture of OLED by using organic electroluminescent compound according to the invention

After forming a hole injecting layer and a hole transport layer according to the same procedure as described in Example 1, a compound according to the present invention (e.g., Compound 17) was charged to one cell of said vacuum vapor-deposit device as electroluminescent material, and Compound E (of which the structure is shown below) was charged to another cell. Then the two substances were evaporated at different rates to carry out doping at a concentration of 2 to 5% by weight on the basis of the host, thus providing an electroluminescent layer having 30 nm thickness vapor-deposited on the hole transport layer.

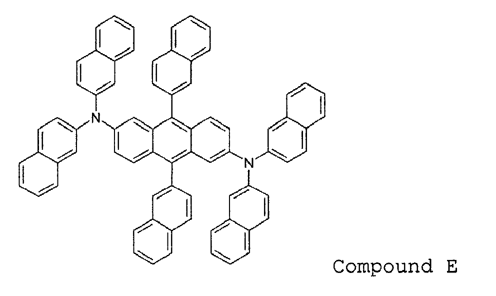

Then, an electron transport layer and an electron injecting layer were vapor-deposited according to the same procedure as in Example 1, and an Al cathode was vapor-deposited thereon with a thickness of 150 nm by using another vacuum vapor-deposit device to manufacture an OLED.

### [Comparative Example 2] Manufacture of OLED by using conventional electroluminescent material

After forming a hole injecting layer and a hole transport layer according to the same procedure as described in Example 1, tris (8-hydroxyquinoline) aluminum (III) (Alq) was charged as electroluminescent host material to another cell of said vacuum vapor-deposit device, while Coumarin 545T (C545T) (of which the structure is shown below) was charged to still another cell. The two substances were evaporated at different rates to carry out doping, thereby providing an electroluminescent layer with a thickness of 30 nm on the hole transport layer. The doping concentration is preferably 1 to 3% by weight on the basis of Alq.

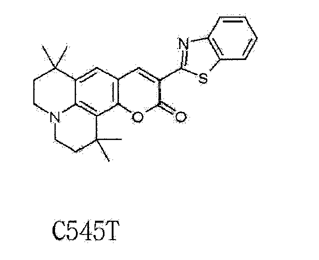

Then, an electron transport layer and an electron injecting layer were vapor-deposited according to the same procedure as in Example 1, and an Al cathode was vapor-deposited thereon with a thickness of 150 nm by using another vacuum vapor-deposit device to manufacture an OLED.

The luminous efficiencies of the OLED's comprising the organic electroluminescent compound according to the present invention (Example 2) or conventional electroluminescent compound (Comparative Example 2) were measured at 5,000 cd/m² respectively, and the results are shown in Table 3.

**Table 3**

| No. | | Host | Dopant | Doping Concentration (wt%) | Luminous efficiency (cd/A) | Color |
|---|---|---|---|---|---|---|
| | | | | | @5000cd/m² | |
| Ex.2 | 1 | **17** | Compound E | 3 | 18.2 | Green |
| | 2 | **29** | Compound E | 3 | 18.6 | Green |
| | 3 | **127** | Compound E | 3 | 18.2 | Green |
| | 4 | **214** | Compound E | 3 | 18.9 | Green |
| | 5 | **224** | Compound E | 3 | 18.7 | Green |
| Comp.2 | | Alq | Compound C545T | 1 | 10.3 | Green |

As can be seen from Table 3, the green electroluminescent device to which the inventive material was applied, particularly the device using the organic electroluminescent compound according to the invention (Compound 214) doped with Compound (E) at 3.0% doping concentration showed improved luminous efficiency by more than twice as compared to the conventional device employing Alq:C545T (Comparative Example 2).

### [Example 3] Manufacture of OLED by using organic electroluminescent compound according to the invention

After forming a hole injecting layer and a hole transport layer according to the same procedure as described in Example 1, a compound according to the present invention (e.g., Compound 41) was charged to one cell of said vacuum vapor-deposit device as electroluminescent material, and electroluminescent dopant (e.g., Compound D-4) was charged to another cell. Then the two substances were evaporated at different rates to carry out doping at a concentration of 8% by weight, thus providing an electroluminescent layer (5) having 30 nm thickness vapor-deposited on the hole transport layer.

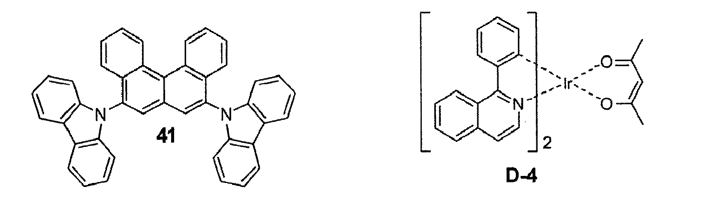

Then, tris(8-hydroxyquinoline)aluminum (III) (Alq) (of which the structure is shown below) was vapor-deposited as an electron transport layer (6) with a thickness of 20 nm, and lithium quinolate (Liq) (of which the structure shown below) was vapor-deposited as an electron injecting layer (7) with a thickness of 1 to 2 nm. Thereafter, an Al cathode (8) was vapor-deposited with a thickness of 150 nm by using another vacuum vapor-deposit device to manufacture an OLED.

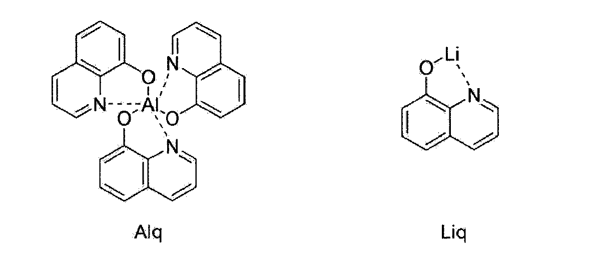

Each material employed for manufacturing an OLED was used as the electroluminescent material after purifying via vacuum sublimation at 10⁻⁶ torr.

### [Comparative Example 3] Manufacture of OLED by using conventional electroluminescent material

After forming a hole injecting layer and a hole transport layer according to the same procedure as described in Example 3, another cell of said vacuum vapor-deposit device was charged with 4,4'-N,N'-dicarbazole-biphenyl (CBP) as electroluminescent host material, while still another cell was charged with electroluminescent dopant (e.g., Compound D-4). Then the two substances were evaporated at different rates to carry out doping, thereby providing an electroluminescent layer (5) having 30 nm thickness on the hole transport layer. The doping concentration is preferably 8% by weight on the basis of CBP.

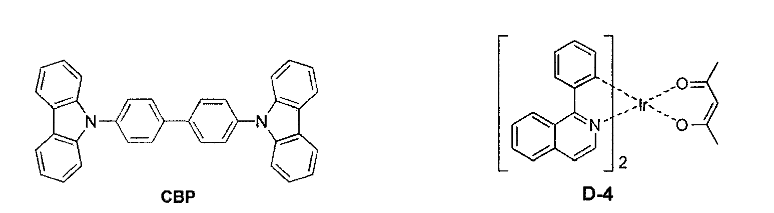

Then, on the electroluminescent layer, bis(2-methyl-8-quinolinato)(p-phenylphenolato)aluminum (III) (BAlq) was vapor-deposited as a hole blocking layer with a thickness of 10 nm, tris(8-hydroxyquinoline)aluminum (III) (Alq) was vapor-deposited as an electron transport layer (6) with a thickness of 20 nm, and then lithium quinolate (Liq) was vapor-deposited as an electron injecting layer (7) with a thickness of 1 to 2 nm. Thereafter, an Al cathode (8) was vapor-deposited with a thickness of 150 nm by using another vacuum vapor-deposit device to manufacture an OLED.

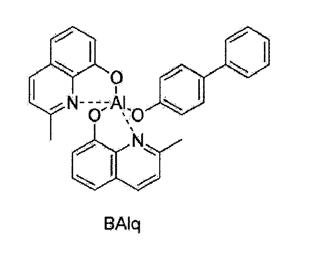

The luminous efficiencies of the OLED's comprising the organic electroluminescent compound according to the present invention (Example 3) or conventional electroluminescent compounds (Comparative Example 3) are shown in Table 4.

**Table 4**

| No. | | Material | Host | Hole blocking layer | EL color | Operation voltage | Max. Luminous efficiency (cd/A) |
|---|---|---|---|---|---|---|---|
| Ex.3 | 1 | D-6 | **36** | - | Red | 7.5 | 6.5 |
| | 2 | D-4 | **41** | - | Red | 7.3 | 6.7 |
| | 3 | D-10 | **66** | - | Red | 7.5 | 7.5 |
| | 4 | D-12 | **103** | - | Red | 7.3 | 7.2 |
| | 5 | D-25 | **192** | - | Red | 7.1 | 6.9 |
| Comp.3 | | (piq)₂Ir(acac) | CBP | BAlq | Red | 8.3 | 6.5 |

As can be seen from Table 4, the device employing the inventive host without using a hole blocking layer provided at least comparable luminous efficiency as compared to CBP as conventional phosphorescent host, with lowered operation voltage by 0.8-1.2 V. Thus, power consumption of OLED could be noticeably lowered.

### [Example 4] Manufacture of OLED by using organic electroluminescent compound of the invention

After forming a hole injecting layer and a hole transport layer according to the same procedure as described in Example 1, an anthracene-type host compound (Compound H-29) was charged to one cell of said vacuum vapor-deposit device as host, and Compound (147) according to the invention was charged to another cell as dopant. Then the two substances were evaporated at different rates to carry out doping at a concentration of 3% by weight on the basis of the host, thus providing an electroluminescent layer (5) having 30 nm thickness on the hole transport layer.

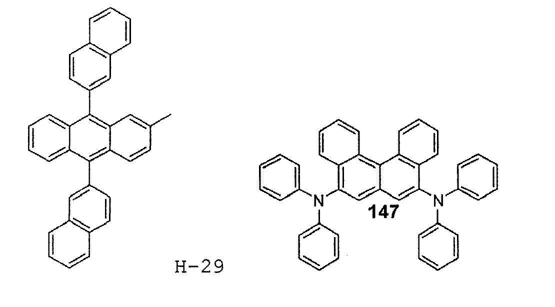

Then, an electron transport layer and electron injecting layer were vapor-deposited according to the same procedure as in Example 1, and an Al cathode was vapor-deposited thereon with a thickness of 150 nm by using another vacuum vapor-deposit device to manufacture an OLED.

### [Comparative Example 4] Manufacture of OLED by using conventional electroluminescent material

After forming a hole injecting layer and a hole transport layer according to the same procedure as described in Example 4, dinaphthylanthracene (DNA) was charged to another cell of said vacuum vapor-deposit device as electroluminescent host material, and perylene was charged to still another cell. Then the two substances were evaporated at different rates to carry out doping at a concentration of 3% by weight on the basis of the host, thus providing an electroluminescent layer (5) having 30 nm thickness vapor-deposited on the hole transport layer.

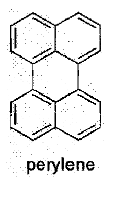

Then, an electron transport layer and an electron injecting layer were vapor-deposited according to the same procedure as in Example 1, and an Al cathode was vapor-deposited thereon with a thickness of 150 nm by using another vacuum vapor-deposit device to manufacture an OLED.

The luminous efficiencies of the OLED's comprising the organic electroluminescent compound according to the present invention (Example 4) or conventional electroluminescent compound (Comparative Example 4) are shown in Table 5.

**Table 5**

| No. | | Host | Dopant | Efficiency (cd/A) @5,000 cd/m² | Color |
|---|---|---|---|---|---|
| Ex.4 | 1 | H-29 | **147** | 5.8 | Blue |
| | 2 | H-31 | **149** | 5.6 | Blue |
| | 3 | H-33 | **158** | 6.5 | Blue |
| | 4 | H-37 | **160** | 6.1 | Blue |
| | 5 | H-73 | **183** | 6.8 | Blue |
| Comp.4 | | DNA | perylene | 4.5 | Blue |

As can be seen from Table 5, the device employing Compound (H-73) with 3.0% by weight doping of Compound (183) showed the highest luminous efficiency.

As is evident from the experimental results, the organic electroluminescent compounds according to the invention can be used as blue, green or red electroluminescent material with high efficiency. Since the compounds provide improvement in both color purity and luminous efficiency, OLED's having very excellent properties can be manufactured from the electroluminescent material according to the invention.

## Claims

1. An organic electroluminescent compound represented by Chemical Formula (1): 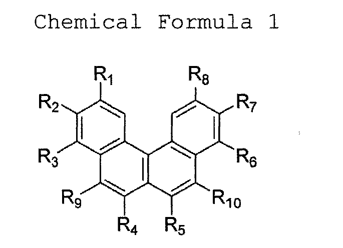 wherein, R₁ through R₁₀ independently represent hydrogen, deuterium, halogen, (C₁-C₆₀)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, NR₁₁R₁₂, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or a substituent selected from the following structures, provided that R₁ through R₁₀ cannot be hydrogen all at the same time: 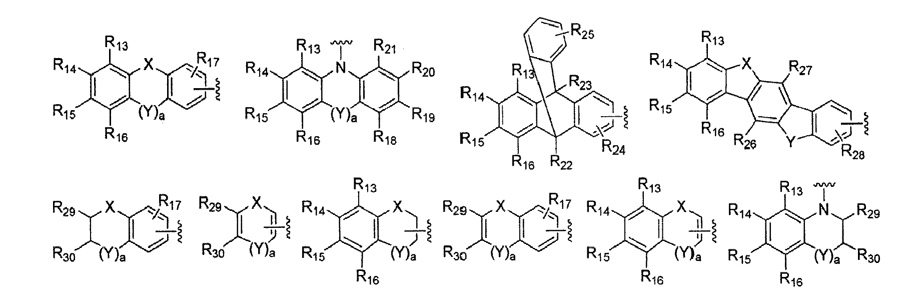 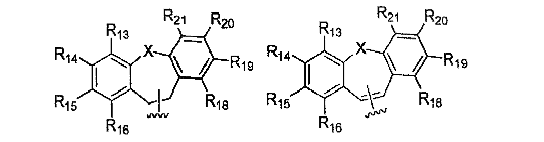 R₁₁ and R₁₂ independently represent hydrogen, deuterium, (C1-C60)alkyl, (C3-C60)cycloalkyl, (C6-C60)aryl or (C3-C60)heteroaryl;
R₁₃ through R₃₀ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₃ through R₂₅ may be linked to an adjacent substituent via (C3-C60)alkylene or (C3-C60)alkenylene with or without a fused ring to form an alicyclic ring, or a monocyclic or polycyclic aromatic ring;
X and Y independently represent a chemical bond, or - C(R₃₁)(R₃₂)-, -N(R₃₃)-, -S-, -O-, -Si(R₃₄)(R₃₅)-, -P(R₃₆)-, - C(=O)-, -B(R₃₇)-, -In(R₃₈)-, -Se-, -Ge(R₃₉)(R₄₀)-, -Sn(R₄₁)(R₄₂)-, -Ga(R₄₃)- or -(R₄₄)C=C(R₄₅)-;
R₃₁ through R₄₅ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₃₁ and R₃₂, R₃₄ and R₃₅, R₃₉ and R₄₀, R₄₁ and R₄₂, or R₄₄ and R₄₅ may be linked via (C3-C60)alkylene or (C3-C60)alkenylene with or without a fused ring to form an alicyclic ring, or a monocyclic or polycyclic aromatic ring;
the alkyl, aryl, heteroaryl, heterocycloalkyl, cycloalkyl, trialkylsilyl, dialkylarylsilyl, triarylsilyl, adamantyl, bicycloalkyl, alkenyl, alkynyl, aralkyl, alkyloxy, alkylthio, aryloxy, arylthio, alkylamino, arylamino, alkoxycarbonyl, alkylcarbonyl or arylcarbonyl of R₁ through R₄₅ may be further substituted by one or more substituent(s) selected from deuterium, halogen, (C1-C60)alkyl with or without halogen substituent(s), (C6-C60)aryl, (C3-C60)heteroaryl with or without (C6-C60)aryl substituent(s), morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; and
a is an integer from 0 to 4.

2. The organic electroluminescent compound according to claim 1, which is represented by Chemical Formula (2): 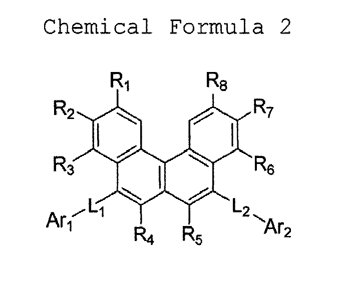 wherein, R₁ through R₈ are defined as in claim 1;
L₁ and L₂ independently represent a chemical bond, or (C1-C60)alkylenoxy, (C1-C60)alkylenethio, (C6-C60)arylenoxy, (C6-C60)arylenethio, (C6-C60)arylene or (C3-C60)heteroarylene;
Ar₁ and Ar₂ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, NR₁₁R₁₂, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or a substituent selected from the following structures: 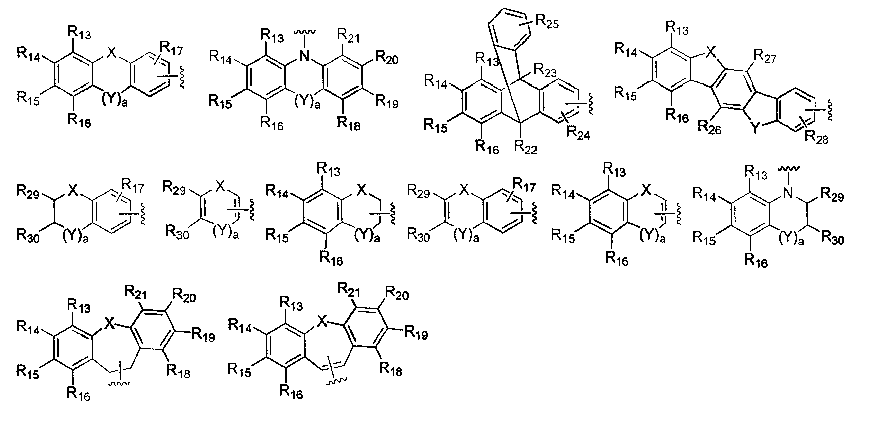 R₁₁ and R₁₂ independently represent hydrogen, deuterium, (C1-C60)alkyl, (C3-C60)cycloalkyl, (C6-C60)aryl or (C3-C60)heteroaryl;
R₁₃ through R₃₀ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₃ through R₂₅ may be linked to an adjacent substituent via (C3-C60)alkylene or (C3-C60)alkenylene with or without a fused ring to form an alicyclic ring, or a monocyclic or polycyclic aromatic ring;
X and Y independently represent a chemical bond, or - C(R₃₁)(R₃₂)-, -N(R₃₃)-, -S-, -O-, -Si(R₃₄)(R₃₅)-, -P(R₃₆)-, - C(=O)-, -B(R₃₇)-, -In(R₃₈)-, -Se-, -Ge(R₃₉)(R₄₀)-, -Sn(R₄₁)(R₄₂)-, -Ga(R₄₃)- or -(R₄₄)C=C(R₄₅)-;
R₃₁ through R₄₅ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₃₁ and R₃₂, R₃₄ and R₃₅, R₃₉ and R₄₀, R₄₁ and R₄₂, or R₄₄ and R₄₅ may be linked via (C3-C60)alkylene or (C3-C60)alkenylene with or without a fused ring to form an alicyclic ring, or a monocyclic or polycyclic aromatic ring;
the arylene or heteroarylene of L₁ and L₂; or the alkyl, aryl, heteroaryl, heterocycloalkyl, cycloalkyl, trialkylsilyl, dialkylarylsilyl, triarylsilyl, adamantyl, bicycloalkyl, alkenyl, alkynyl, aralkyl, alkyloxy, alkylthio, aryloxy, arylthio, alkylamino, arylamino, alkoxycarbonyl, alkylcarbonyl or arylcarbonyl of Ar₁, Ar₂ and R₁₁ through R₄₅ may be further substituted by one or more substituent(s) selected from deuterium, halogen, (C1-C60)alkyl with or without halogen substituent(s), (C6-C60)aryl, (C3-C60)heteroaryl with or without (C6-C60)aryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsily tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; and
a is an integer from 0 to 4.

3. An organic electroluminescent device which is comprised of a first electrode; a second electrode; and at least one organic layer(s) interposed between the first electrode and the second electrode; wherein the organic layer comprises an organic electroluminescent compound represented by Chemical Formula (1): 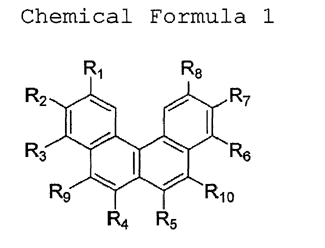 wherein, R₁ through R₁₀ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, NR₁₁R₁₂, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or a substituent selected from the following structures, provided that R₁ through R₁₀ cannot be hydrogen all at the same time: 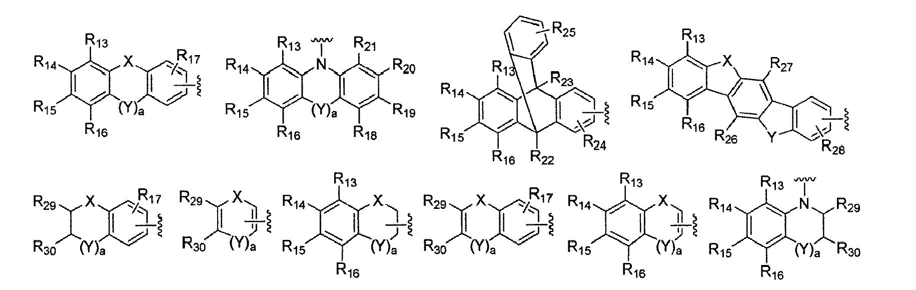 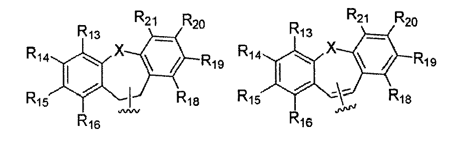 R₁₁ and R₁₂ independently represent hydrogen, deuterium, (C1-C60)alkyl, (C3-C60)cycloalkyl, (C6-C60)aryl or (C3-C60)heteroaryl;
R₁₃ through R₃₀ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₃ through R₂₅ may be linked to an adjacent substituent via (C3-C60)alkylene or (C3-C60)alkenylene with or without a fused ring to form an alicyclic ring, or a monocyclic or polycyclic aromatic ring;
X and Y independently represent a chemical bond, or - C(R₃₁)(R₃₂)-, -N(R₃₃)-, -S-, -O-, -Si(R₃₄)(R₃₅)-, -P(R₃₆)-, C(=O)-, -B(R₃₇)-, -In(R₃₈)-, -Se-, -Ge(R₃₉)(R₄₀)-, -Sn(R₄₁)(R₄₂)-, -Ga(R₄₃)- or -(R₄₄)C=C(R₄₅)-;
R₃₁ through R₄₅ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkylox (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₃₁ and R₃₂, R₃₄ and R₃₅, R₃₉ and R₄₀, R₄₁ and R₄₂, or R₄₄ and R₄₅ may be linked via (C3-C60)alkylene or (C3-C60)alkenylene with or without a fused ring to form an alicyclic ring, or a monocyclic or polycyclic aromatic ring;
the alkyl, aryl, heteroaryl, heterocycloalkyl, cycloalkyl, trialkylsilyl, dialkylarylsilyl, triarylsilyl, adamantyl, bicycloalkyl, alkenyl, alkynyl, aralkyl, alkyloxy, alkylthio, aryloxy, arylthio, alkylamino, arylamino, alkoxycarbonyl, alkylcarbonyl or arylcarbonyl of R₁ through R₄₅ may be further substituted by one or more substituent(s) selected from deuterium, halogen, (C1-C60)alkyl with or without halogen substituent(s), (C6-C60)aryl, (C3-C60)heteroaryl with or without (C6-C60)aryl substituent(s), morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; and
a is an integer from 0 to 4 and one or more dopant(s) selected from the compounds represented by one of Chemical Formulas (3) to (6): 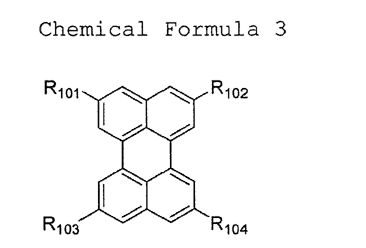 wherein, R₁₀₁ through R₁₀₄ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C1-C60)alkylthio, (C6-C60)arylthio, (C1-C60)alkoxycarbonyl, (C1-C60)alkylcarbonyl, (C6-C60)arylcarbonyl, carboxyl, nitro or hydroxyl, or R₁₀₁ through R₁₀₄ may be linked to an adjacent substituent via (C3-C60)alkylene or (C3-C60)alkenylene with or without a fused ring to form an alicyclic ring, or a monocyclic or polycyclic aromatic ring; and
the alkyl, alkenyl, alkynyl, cycloalkyl, heterocycloalkyl, aryl, heteroaryl, arylsilyl, alkylsilyl, alkyloxy, aryloxy, arylthio, alkylamino or arylamino of R₁₀₁ through R₁₀₄, or the alicyclic ring, or the monocyclic or polycyclic aromatic ring formed therefrom by linkage to an adjacent substitnet via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C1-C60)alkylthio, (C6-C60)arylthio, (C1-C60)alkoxycarbonyl, (C1-C60)alkylcarbonyl, (C6-C60)arylcarbonyl, carboxyl, nitro and hydroxyl; 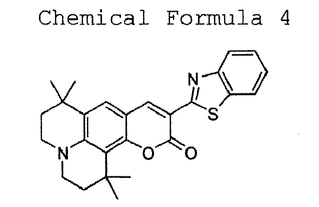 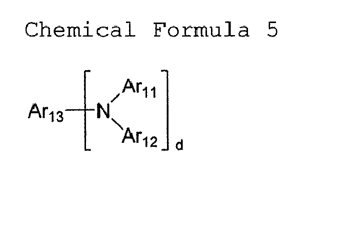 wherein, Ar₁₁ and Ar₁₂ independently represent (C1-C60)alkyl, (C6-C60)aryl, (C4-C60)heteroaryl, (C6-C60)arylamino, (C1-C60)alkylamino, 5- or 6-membered heterocycloalkyl containing one or more heteroatom(s) selected from N, O and S, or (C3-C60)cycloalkyl, or Ar₁₁ and Ar₁₂ may be linked via (C3-C60)alkylene or (C3-C60)alkenylene with or without a fused ring to form an alicyclic ring, or a monocyclic or polycyclic aromatic ring;
when d is 1, Ar₁₃ represents (C6-C60)aryl, (C4-C60)heteroaryl or aryl having one of the following structure: 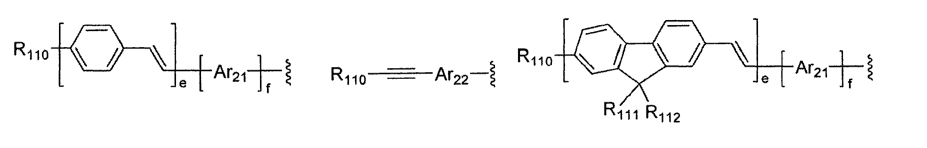 when d is 2, Ar₁₃ represents (C6-C60)arylene, (C4-C60)heteroarylene or arylene having one of the following structure: 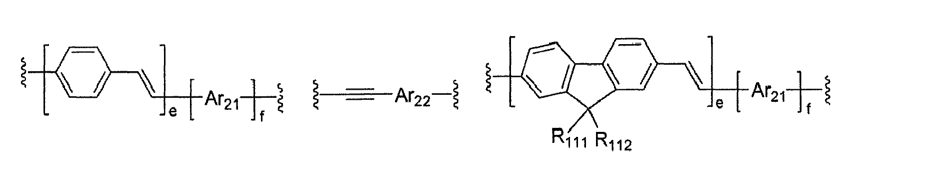 Ar₂₁ and Ar₂₂ independently represent (C6-C60)arylene or (C4-C60)heteroarylene;
R₁₁₀, R₁₁₁ and R₁₁₂ independently represent hydrogen, deuterium, (C1-C60)alkyl or (C6-C60)aryl;
e is an integer from 1 to 4, f is an integer of 0 or 1; and
the alkyl, aryl, heteroaryl, arylamino, alkylamino, cycloalkyl or heterocycloalkyl of Ar₁₁ and Ar₁₂; the aryl, heteroaryl, arylene or heteroarylene of Ar₁₃; arylene or heteroarylene of Ar₂₁ and Ar₂₂; or alkyl or aryl of R₁₁₀ through R₁₁₂ may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl;
Chemical Formula 6 M¹L¹⁰¹L¹⁰²L¹⁰³
wherein, M¹ is selected from a group consisting of metals from Group 7, 8, 9, 10, 11, 13, 14, 15 and 16 in the Periodic Table of Elements, and ligands L¹⁰¹, L¹⁰² and L¹⁰³ are independently selected from the following structures: 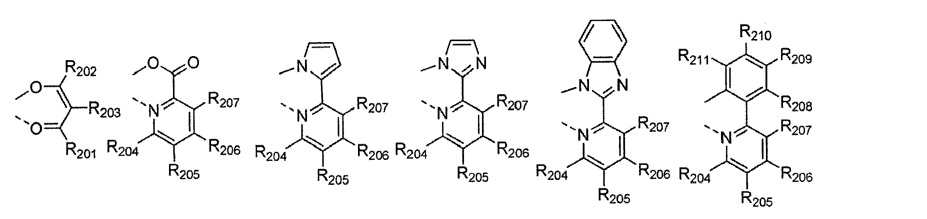 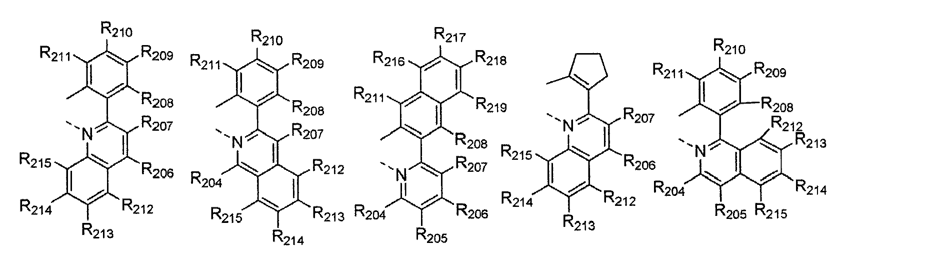 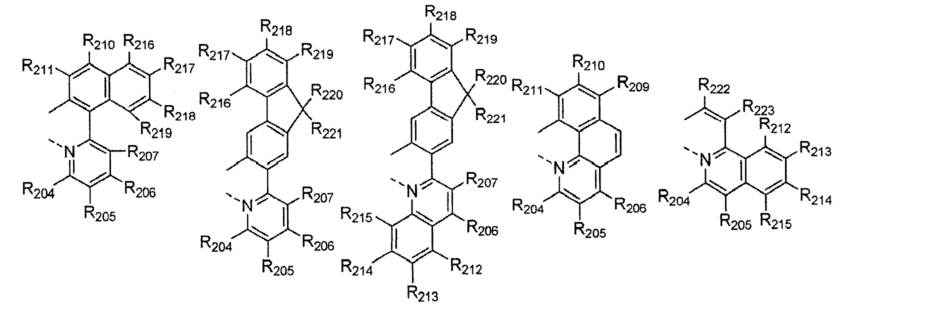 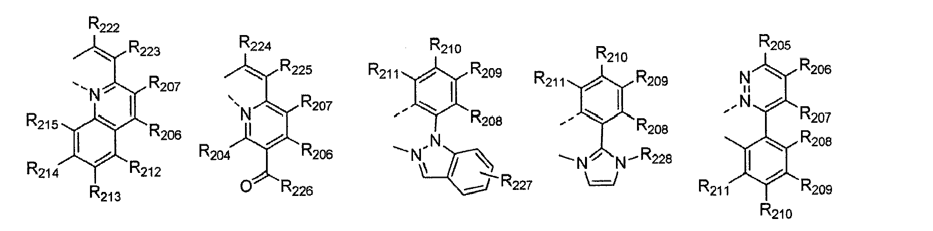 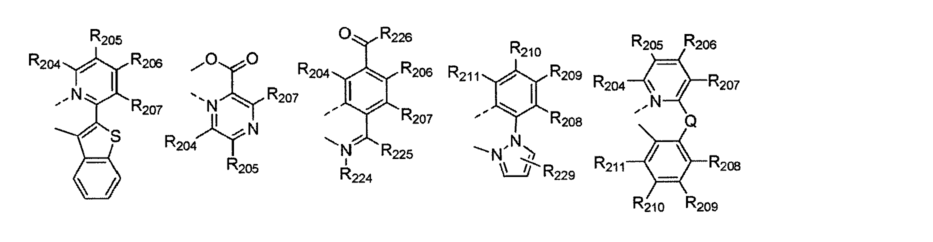 wherein, R₂₀₁ through R₂₀₃ independently represent hydrogen, deuterium, (C1-C60)alkyl with or without halogen substituent(s), (C6-C60)aryl with or without (C1-C60) alkyl substituent(s), or halogen;
R₂₀₄ through R₂₁₉ independently represent hydrogen, deuterium, (C1-C60)alkyl, (C1-C30)alkyloxy, (C3-C60)cycloalkyl, (C2-C30)alkenyl, (C6-C60)aryl, mono or di(C1-C30)alkylamin mono or di(C6-C30)arylamino, SF₅, tri(C1-C30)alkylsilyl, di(C1-C30)alkyl(C6-C30)arylsilyl, tri(C6-C30)arylsilyl, cyano or halogen, and the alkyl, cycloalkyl, alkenyl or aryl of R₂₀₄ through R₂₁₉ may be further substituted by one or more substituent(s) selected from deuterium, (C1-C60)alkyl, (C6-C60)aryl and halogen;
R₂₂₀ through R₂₂₃ independently represent hydrogen, deuterium, (C1-C60)alkyl with or without halogen substituent(s), or (C6-C60)aryl with or without (C1-C60)alkyl substituent(s);
R₂₂₄ and R₂₂₅ independently represent hydrogen, deuterium, (C1-C60)alkyl, (C6-C60) aryl or halogen, or R₂₂₄ and R₂₂₅ are linked via (C3-C12)alkylene or (C3-C12)alkenylene with or without a fused ring to form an alicyclic ring, or a monocyclic or polycyclic aromatic ring, and the alkyl or aryl of R₂₂₄ and R₂₂₅, or the alicyclic ring, or the monocyclic or polycyclic aromatic ring formed therefrom by linkage via (C3-C12)alkylene or (C3-C12)alkenylene with or without a fused ring may be further substituted by one or more substituent(s) selected from (C1-C60)alkyl with or without halogen substituent(s), (C1-C30)alkyloxy, deuterium, halogen, tri(C1-C30)alkylsilyl, tri(C6-C30)arylsilyl and (C6-C60)aryl;
R₂₂₆ represents (C1-C60)alkyl, (C6-C60)aryl, (C5-C60)heteroaryl or halogen;
R₂₂₇ through R₂₂₉ independently represent hydrogen, deuterium, (C1-C60)alkyl, (C6-C60)aryl or halogen, and the alkyl or aryl of R₂₂₆ through R₂₂₉ may be further substituted by halogen or (C1-C60)alkyl substituent(s); and
Q represents 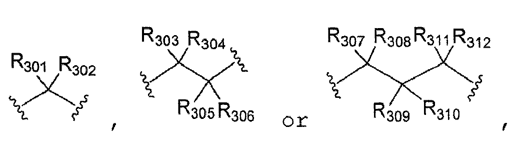 wherein R₃₀₁ through R₃₁₂ independently represent hydrogen, deuterium, (C1-C60)alkyl with or without halogen substituent(s), (C1-C30)alkyloxy, halogen, (C6-C60)aryl, cyano or (C5-C60) cycloalkyl, or each of R₃₀₁ through R₃₁₂ may be linked to an adjacent substituent via alkylene or alkenylene to form a (C5-C7) spiro ring or a (C5-C9)fused ring, or linked to R₂₀₇ or R₂₀₈ via alkylene or alkenylene to form a (C5-C7)fused ring.

4. The organic electroluminescent device according to claim 3, which is comprised of a first electrode, a second electrode, and at least one organic layer(s) interposed between the first electrode and the second electrode;
wherein the organic layer comprises one or more organic electroluminescent compound(s) according to claim 1 or 2, and one or more host(s) selected from the compounds represented by Chemical Formula (7) or (8):
Chemical Formula 7 (Ar₃₁)_{g}-L₂₁-(Ar₃₂)ₕ
Chemical Formula 8 (Ar₃₃)ᵢ-L₂₂-(Ar₃₄)ⱼ
wherein, L₂₁ represents (C6-C60)arylene or (C4-C60)heteroarylene;
L₂₂ represents anthracenylene;
Ar₃₁ through Ar₃₄ are independently selected from hydrogen, deuterium, (C1-C60)alkyl, (C1-C60)alkyloxy, halogen, (C4-C60)heteroaryl, (C5-C60)cycloalkyl and (C6-C60)aryl; the cycloalkyl, aryl or heteroaryl of Ar₃₁ through Ar₃₄ may be further substituted by one or more substituent(s) selected from a group consisting of (C6-C60)aryl or (C4-C60)heteroaryl having one or more substituent(s) selected from a group consisting of deuterium, (C1-C60)alkyl with or without halogen substituent(s), (C1-C60)alkyloxy, (C3-C60)cycloalkyl, halogen, cyano, tri(C1-C60)alkylsilyl, di(C1-C60)alkyl(C6-C60)arylsilyl and tri(C6-C60)arylsilyl; (C1-C60)alkyl with or without halogen substituent(s), (C1-C60)alkyloxy, (C3-C60)cycloalkyl, deuterium, halogen, cyano, tri(C1-C60)alkylsilyl, di(C1-C60)alkyl(C6-C60)arylsilyl and tri(C6-C60)arylsilyl; and g, h, i and j independently represent an integer from 0 to 4.

5. The organic electroluminescent device according to claim 3, wherein the organic layer comprises one or more compound(s) selected from a group consisting of arylamine compounds and styrylarylamine compounds.

6. The organic electroluminescent device according to claim 3, wherein the organic layer comprises one or more metal(s) selected from a group consisting of organic metals of Group 1, Group 2, 4^{th} period and 5^{th} period transition metals, lanthanide metals and d-transition elements in the Periodic Table of Elements.

7. The organic electroluminescent device according to claim 3, wherein the organic layer comprises an electroluminescent layer and a charge generating layer.

8. The organic electroluminescent device according to claim 3, wherein a mixed region of reductive dopant and organic substance, or a mixed region of oxidative dopant and organic substance is placed on the inner surface of one or both electrode(s) among the pair of electrodes.

9. An organic solar cell which comprises an organic electroluminescent compound represented by Chemical Formula (1) : 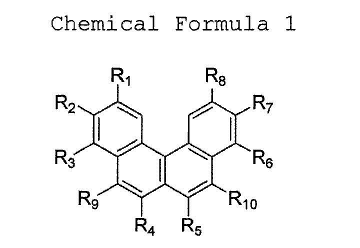 wherein, R₁ through R₁₀ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, NR₁₁R₁₂, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or a substituent selected from the following structures, provided that R₁ through R₁₀ cannot be hydrogen all at the same time: 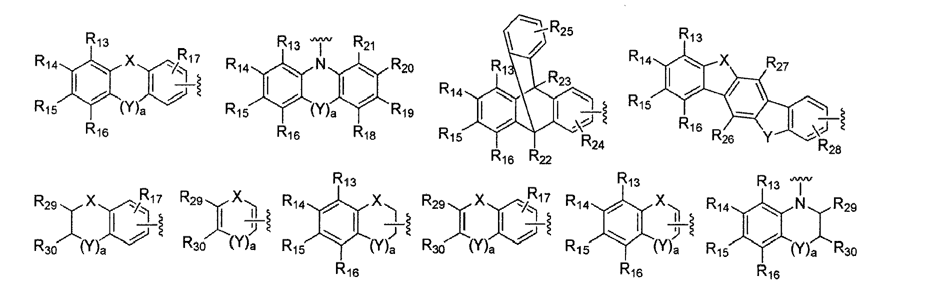 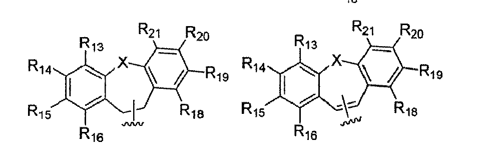 R₁₁ and R₁₂ independently represent hydrogen, deuterium, (C1-C60)alkyl, (C3-C60)cycloalkyl, (C6-C60)aryl or (C3-C60)heteroaryl;
R₁₃ through R₃₀ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₃ through R₂₅ may be linked to an adjacent substituent via (C3-C60)alkylene or (C3-C60)alkenylene with or without a fused ring to form an alicyclic ring, or a monocyclic or polycyclic aromatic ring;
X and Y independently represent a chemical bond, or - C(R₃₁)(R₃₂)-, -N(R₃₃)-, -S-, -O-, -Si(R₃₄)(R₃₅)-, -P(R₃₆)-, - C(=O)-, -B(R₃₇)-, -In(R₃₈)-, -Se-, -Ge(R₃₉)(R₄₀)-, -Sn(R₄₁)(R₄₂)-, -Ga(R₄₃)- or -(R₄₄)C=C(R₄₅)-;
R₃₁ through R₄₅ independently represent hydrogen, deuterium, halogen, (C1-C60)alkyl, (C6-C60) aryl, (C3-C60)heteroaryl, morpholino, thiomorpholino, 5- or 6-membered heterocycloalkyl containing one or more heteroatom(s) selected from N, O, S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₃₁ and R₃₂, R₃₄ and R₃₅, R₃₉ and R₄₀, R₄₁ and R₄₂, or R₄₄ and R₄₅ may be linked via (C3-C60)alkylene or (C3-C60)alkenylene with or without a fused ring to form an alicyclic ring, or a monocyclic or polycyclic aromatic ring;
the alkyl, aryl, heteroaryl, heterocycloalkyl, cycloalkyl, trialkylsilyl, dialkylarylsilyl, triarylsilyl, adamantyl, bicycloalkyl, alkenyl, alkynyl, aralkyl, alkyloxy, alkylthio, aryloxy, arylthio, alkylamino, arylamino, alkoxycarbonyl, alkylcarbonyl or arylcarbonyl of R₁ through R₄₅ may be further substituted by one or more substituent(s) selected from deuterium, halogen, (C1-C60)alkyl with or without halogen substituent(s), (C6-C60)aryl, (C3-C60)heteroaryl with or without (C6-C60)aryl substituent(s), morpholino, thiomorpholino, 5- or 6-membered heterocycloalkyl containing one or more heteroatom(s) selected from N, O S and Si, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; and
a is an integer from 0 to 4.
